# EUROPEAN PATENT APPLICATION

(11) **EP 4 340 581 A1**
(43) Date of publication of application: **20.03.2024**
(21) Application number: 22212321.8
(22) Date of filing: 08.12.2022
(51) Int. Cl.: H10K 85/30, H10K 85/60, C07F 1/08, C09K 11/00

(54) **AN ELECTROLUMINESCENT DEVICE COMPRISING AN ANODE LAYER, A CATHODE LAYER, A FIRST EMISSION LAYER, A HOLE INJECTION LAYER AND A FIRST HOLE TRANSPORT LAYER THAT COMPRISES A COMPOUND CONTAINING A METAL**

(30) Priority: 19.09.2022 WO PCT/EP2022/075945
(71) Applicant: Novaled GmbH, 01099 Dresden (DE)
(72) Inventor: STEUDEL, Annette, 01099 Dresden (DE); UVAROV, Vladimir, 01099 Dresden (DE); PINTER, Piermaria, 01099 Dresden (DE); HUANG, Qiang, 01099 Dresden (DE); ROSENOW, Thomas, 01099 Dresden (DE); LUSCHTINETZ, Regina, 01099 Dresden (DE)
(74) Representative: Michalski Hüttermann & Partner Patentanwälte mbB

(57) **Abstract**

The present invention is directed to an electroluminescent device comprising an anode layer, a cathode layer, a first emission layer, a hole injection layer and a first hole transport layer that comprises a compound containing a metal.

## Description

### Technical Field

The present invention relates to an electroluminescent device comprising an anode layer, a cathode layer, a first emission layer, a hole injection layer and a first hole transport layer that comprises a compound containing a metal.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the hole injection layer, and among them, may be affected by characteristics of the hole transport compound and the compound which are contained in the hole injection layer.

There remains a need to improve performance of organic electroluminescent devices and organic electronic devices by providing hole injection layers with improved performance, in particular to achieve improved operating voltage, voltage stability over time and/or lifetime through improving the characteristics of the hole injection layer, the organic electroluminescent device and the organic electronic device.

Further there remains a need to improve the hole injection layer which enable injection into adjacent layers comprising compounds with a HOMO level further away from vacuum level.

It is a further objective to provide an organic electroluminescent device with a hole injection layer comprising compounds which can be deposited through vacuum thermal evaporation under conditions suitable for mass production.

It is a further objective to provide an organic electroluminescent device wherein the hole injection layer comprises a metal containing compound with improved thermal properties, in particular improved thermal stability and/or rate onset temperature.

It is a further objective to provide an organic an organic electroluminescent device wherein the hole injection layer comprises a metal containing compound which may have reduced health and safety risks compared to the art.

### DISCLOSURE

An aspect of the present invention provides an organic electroluminescent device comprising an anode layer, a cathode layer, a first emission layer (EML), a hole injection layer (HIL) and a first hole transport layer (HTL), wherein
- the hole injection layer comprises a compound of formula (I):

   M^{n⊕}(L^{⊖})ₙ (AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II):

   [A¹-Y¹-X-Y²-A²]^{⊖} (II),

   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein at least two of the substituents in L of formula (II) are independently selected from C₃ to C₉heteroaryl, C₁ to C₆ alkoxy, C₃ to C₆ branched alkoxy, C₃ to C₆ cyclic alkoxy, partially orperfluorinated C₁ to C₁₆ alkyl, partially or perfluorinated C₁ to C₁₆ alkoxy, partially orperdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 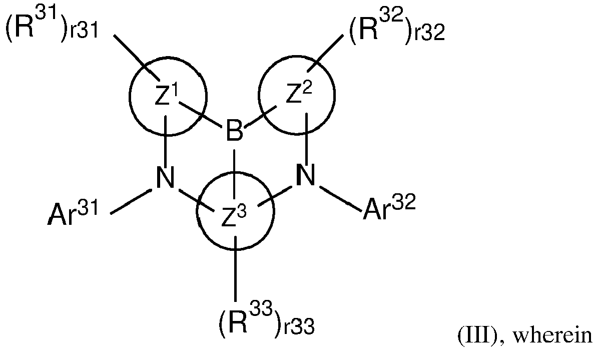
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
   - r31, r32 and r33: wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent; are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
      wherein the molecular weight Mw of the organic hole transport compound is in the range of ≥ 400 g/mol and ≤ 2000 g/mol; and
   wherein the hole injection layer is arranged between the anode layer and the first hole transport layer; the first emission layer is arranged between the first hole transport layer and the cathode layer; and the first hole transport layer is arranged between the hole injection layer and the first emission layer.

According to an embodiment of the organic electroluminescent device comprises an anode layer, a cathode layer, a first emission layer (EML), a hole injection layer (HIL) and a first hole transport layer (HTL), wherein the following compound BH9 is excluded:

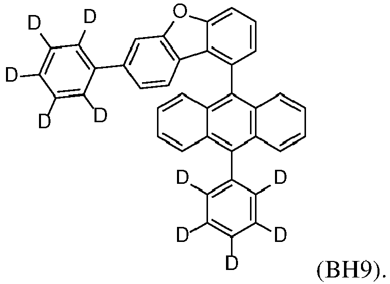

According to an embodiment of the organic electroluminescent device comprises an anode layer, a cathode layer, a first emission layer (EML), a hole injection layer (HIL) and a first hole transport layer (HTL), wherein the following compound BD8 is excluded:

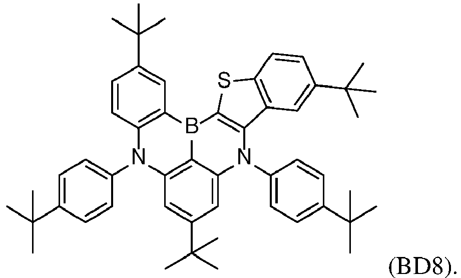

According to an embodiment of the organic electroluminescent device comprises an anode layer, a cathode layer, a first emission layer (EML), a hole injection layer (HIL) and a first hole transport layer (HTL), wherein the following compounds BH9 and BD8 are excluded:

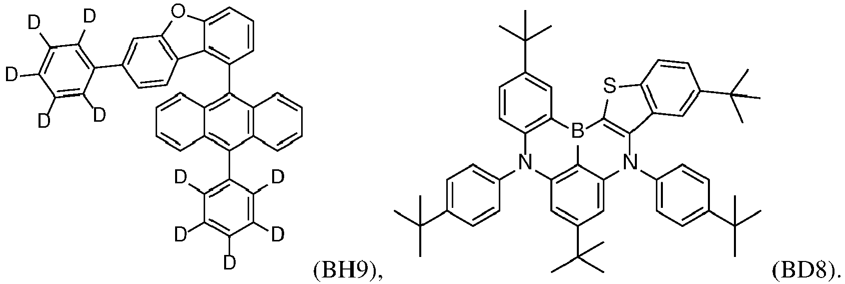

According to an embodiment of the organic electroluminescent device comprises an anode layer, a cathode layer, a first emission layer (EML), a hole injection layer (HIL) and a first hole transport layer (HTL), wherein the following compound is excluded:

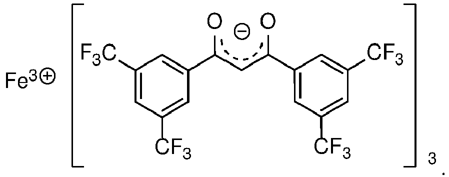

According to an embodiment of the organic electroluminescent device comprises an anode layer, a cathode layer, a first emission layer (EML), a hole injection layer (HIL) and a first hole transport layer (HTL), wherein the following compound G70 is excluded:

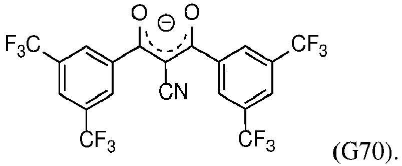

According to an embodiment of the organic electroluminescent device comprises an anode layer, a cathode layer, a first emission layer (EML), a hole injection layer (HIL) and a first hole transport layer (HTL), wherein the following compounds are excluded:

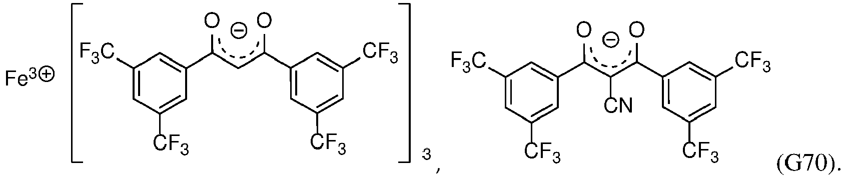

According to an embodiment of the organic electroluminescent device comprises an anode layer, a cathode layer, a first emission layer (EML), a hole injection layer (HIL) and a first hole transport layer (HTL), wherein the following compounds are excluded:

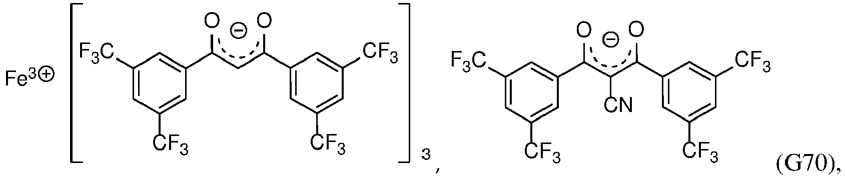

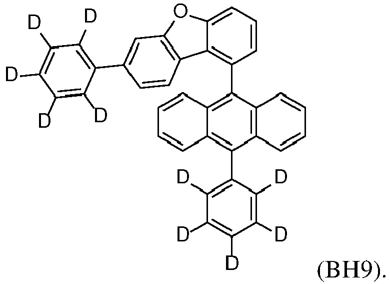

According to an embodiment of the organic electroluminescent device comprises an anode layer, a cathode layer, a first emission layer (EML), a hole injection layer (HIL) and a first hole transport layer (HTL), wherein the following compounds are excluded:

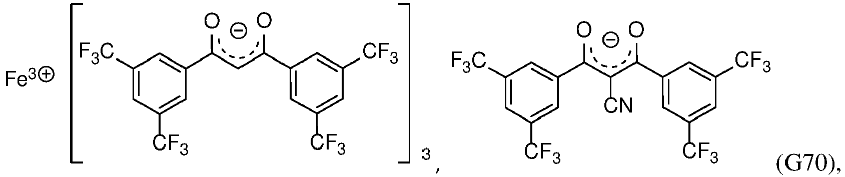

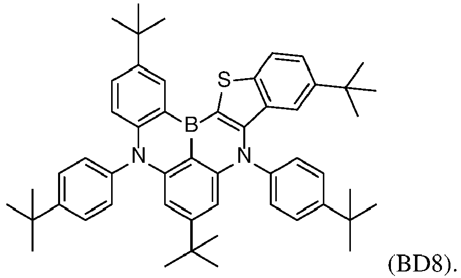

According to an embodiment of the organic electroluminescent device comprises an anode layer, a cathode layer, a first emission layer (EML), a hole injection layer (HIL) and a first hole transport layer (HTL), wherein the following compounds are excluded:

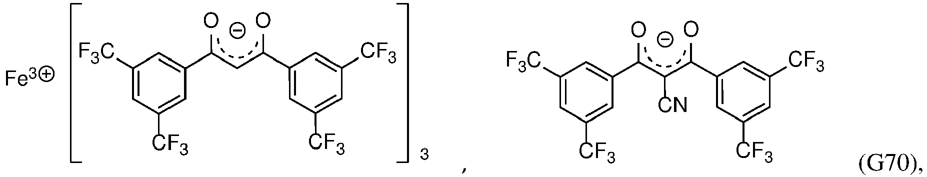

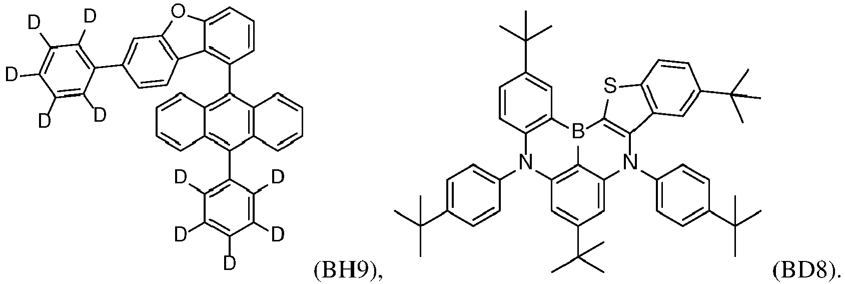

According to an embodiment, wherein an organic electroluminescent device is excluded comprising:
- a hole injection layer comprising a compound of formula (I): 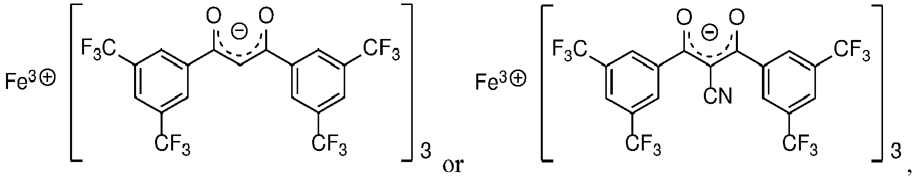 and a compound of formula (IVa) or (IVb): 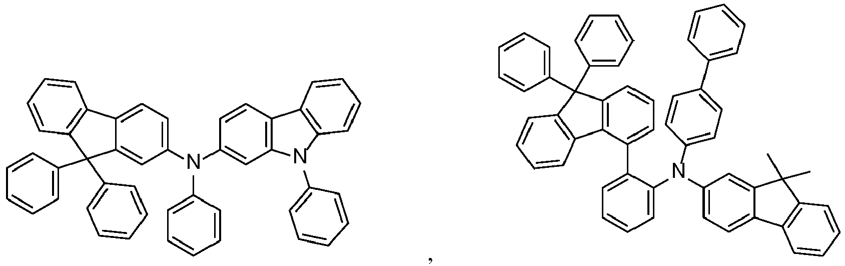 or 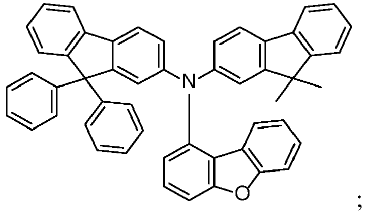
- a first hole transport layer comprising a compound of formula (IVa) or (IVb) 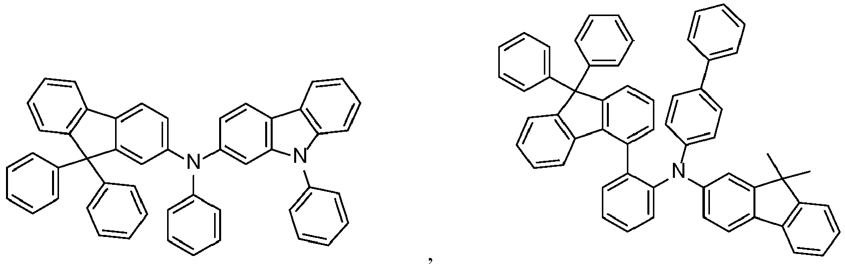 or 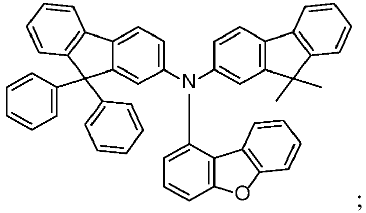
   - an electron blocking layer comprising N,N-di([1,1'-biphenyl]-4-yl)-3'-(9H-carbazol-9-yl)-[1,1'-biphenyl]-4-amine (CAS 1464822-27-2);
   - a first emission layer comprising 99 vol.-% compound with CAS 2457172-82-4 and 1 vol.-% compound with CAS 2482607-57-6;
   - a hole blocking layer comprising 2-(3'-(9,9-dimethyl-9H-fluoren-2-yl)-[1,1'-biphenyl]-3-yl)-4,6-diphenyl-1,3,5-triazine;
   - an electron transport layer comprising 50 wt.-% 2-(2',6'-diphenyl-[1,1':4',1"-terphenyl]-4-yl)-4-phenyl-6-(3-(pyridin-4-yl)phenyl)-1,3,5-triazine and 50 wt.-% of LiQ;
   - an electron injection layer comprising Yb;
   - a cathode layer comprising Ag:Mg (90:10 vol.-%).

According to an embodiment, wherein an organic electroluminescent device is excluded, wherein 99 vol.-% 9-(4-(naphthalen-1-yl)phenyl)-10-(phenyl-d5)anthracene (CAS 1185865-32-0) as EML host and 1 vol.-% 2,12-di-tert-butyl-5,9-bis(4-(tert-butyl)phenyl)-7-methyl-5,9-dihydro-5,9-diaza-13b-boranaphtho[3,2,1-de]anthracene (CAS 1805802-42-9) as blue EML dopant were deposited on the EBL, to form a first emission layer with a thickness of 20 nm.

According to another embodiment the organic electroluminescent device comprises an anode layer, a cathode layer, a first emission layer (EML), a hole injection layer (HIL) and a first hole transport layer (HTL), wherein
- the hole injection layer comprises a compound of formula (I):

   M^{n⊕}(L^{⊖})ₙ(AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II):

   [A¹-Y¹-X-Y²-A²]^{⊖} (II),

   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein
   at least two of the substituents in L of formula (II) are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 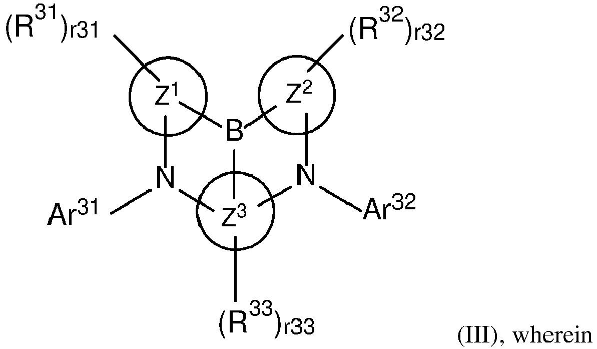
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted
   or unsubstituted alkyl group, a substituted or unsubstituted silyl group, a substituted or unsubstituted amine group, a substituted or unsubstituted aryl group, or a substituted
   or unsubstituted heteroaryl group, or adjacent substituents are bonded to each other to form a substituted or unsubstituted aromatic ring or a substituted or unsubstituted aliphatic ring,
   wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
   - r31, r32 and r33: are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
      wherein the molecular weight Mw of the organic hole transport compound is in the range of ≥ 400 g/mol and ≤ 2000 g/mol;
   wherein the hole injection layer is arranged between the anode layer and the first hole transport layer; the first emission layer is arranged between the first hole transport layer and the cathode layer; and the first hole transport layer is arranged between the hole injection layer and the first emission layer; and wherein the following equation is fulfilled:
   - 0.8 eV ≥ [ HOMO of organic emitter host compound [eV] - HOMO of organic hole transport compound [eV] ] ≤ 0 eV.

According to another embodiment the organic electroluminescent device comprises an anode layer, a cathode layer, a first emission layer (EML), a hole injection layer (HIL) and a first hole transport layer (HTL), wherein
- the hole injection layer comprises a compound of formula (I):

   Mⁿ⊕ (L^{⊖})ₙ (AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II):

   [A¹-Y¹-X-Y²-A²]^{⊖} (II),

   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein
   at least two of the substituents in L of formula (II) are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 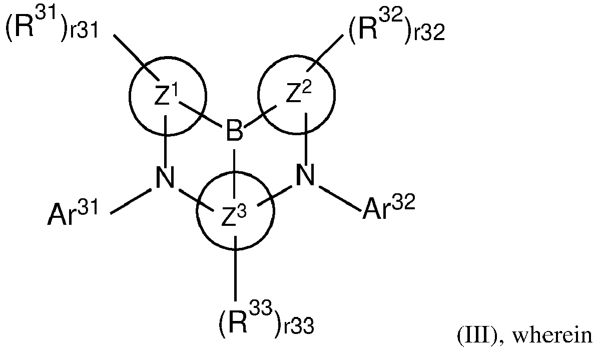
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
   wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
   - r31, r32 and r33: are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
   wherein the molecular weight Mw of the organic hole transport compound is in the range of ≥ 400 g/mol and ≤ 2000 g/mol;
   wherein the hole injection layer is arranged between the anode layer and the first hole transport layer; the first emission layer is arranged between the first hole transport layer and the cathode layer; and the first hole transport layer is arranged between the hole injection layer and the first emission layer; and wherein a metal compound of formula (Ia) is excluded:

   Fe^{3⊕}(L^{⊖})₃(AL)ₙ (Ia),

   wherein
   L has the formula (IIa) 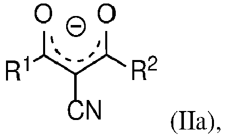 wherein
   - R1: of formula (IIa) is selected from substituted C2 to C12 alkyl, substituted C6 to C19 aryl, substituted or unsubstituted C2 to C20 heteroaryl, or substituted or unsubstituted 6-membered heteroaryl;
   - R2: of formula (IIa) is selected from substituted C6 to C19 aryl, substituted or unsubstituted C2 to C20 heteroaryl, substituted or unsubstituted 6-membered heteroaryl; wherein at least one of the substituents of the substituted C1 to C12 alkyl, substituted C6 to C19 aryl, substituted C2 to C20 heteroaryl, or substituted 6-membered heteroaryl are independently selected from halogen, Cl, F, CN, partially or perfluorinated C1 to C8 alkyl, partially or perfluorinated C1 to C8 alkoxy;
   wherein
   - L: of formula (Ia) comprises at least two CF3 groups and/or at least one N atom;
   - AL: of formula (Ia) is an ancillary ligand which coordinates to the metal M;
   - n: of formula (Ia) is an integer selected from 0 to 2.

According to another embodiment the organic electroluminescent device comprises an anode layer, a cathode layer, a first emission layer (EML), a hole injection layer (HIL) and a first hole transport layer (HTL), wherein
- the hole injection layer comprises a compound of formula (I):

   M^{n⊕}(L^{⊖})ₙ(AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II):

   [A¹-Y¹-X-Y²-A²]^{⊖} (II),

   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein
   at least two of the substituents in L of formula (II) are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 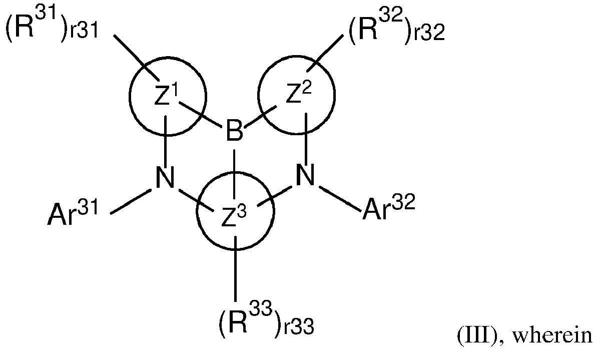
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
   wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
   - r31, r32 and r33: are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
   wherein the molecular weight Mw of the organic hole transport compound is in the range of ≥ 400 g/mol and ≤ 2000 g/mol;
   wherein the hole injection layer is arranged between the anode layer and the first hole transport layer; the first emission layer is arranged between the first hole transport layer and the cathode layer; and the first hole transport layer is arranged between the hole injection layer and the first emission layer;
   wherein the following equation is fulfilled:
      -0.8 eV ≥ [ HOMO of organic emitter host compound [eV] - HOMO of organic hole transport compound [eV] ] ≤ 0 eV; and
   wherein a metal compound of formula (Ia) is excluded:

      Fe^{3⊕}(L^{⊖}))₃(AL)ₙ (Ia),

      wherein
      L has the formula (IIa) 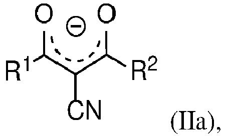 wherein
      - R1: of formula (IIa) is selected from substituted C2 to C12 alkyl, substituted C6 to C19 aryl, substituted or unsubstituted C2 to C20 heteroaryl, or substituted or unsubstituted 6-membered heteroaryl;
      - R2: of formula (IIa) is selected from substituted C6 to C19 aryl, substituted or unsubstituted C2 to C20 heteroaryl, substituted or unsubstituted 6-membered heteroaryl; wherein at least one of the substituents of the substituted C1 to C12 alkyl, substituted C6 to C19 aryl, substituted C2 to C20 heteroaryl, or substituted 6-membered heteroaryl are independently selected from halogen, Cl, F, CN, partially or perfluorinated C1 to C8 alkyl, partially or perfluorinated C1 to C8 alkoxy;
      wherein
      - L: of formula (Ia) comprises at least two CF3 groups and/or at least one N atom;
      - AL: of formula (Ia) is an ancillary ligand which coordinates to the metal M;
      - n: of formula (Ia) is an integer selected from 0 to 2.

According to one embodiment, wherein the following equation is fulfilled:
-0.8 eV ≥ [ HOMO of organic emitter host compound [eV] - HOMO of organic hole transport compound [eV]] ≤ 0 eV; preferably -0.6 eV ≥ [ HOMO of organic emitter host compound [eV] - HOMO of organic hole transport compound [eV]] ≤ -0.1 eV, more preferred -0.5 eV ≥ [ HOMO of organic emitter host compound [eV] - HOMO of organic hole transport compound [eV]] ≤ -0.2 eV. The HOMO of the organic emitter host and the HOMO of the organic hole transport compound may be calculated with the program package TURBOMOLE V6.5 (TURBOMOLE GmbH, Litzenhardtstrasse 19, 76135 Karlsruhe, Germany) or ORCA Version 5.0.3-f.1 (Department of theory and spectroscopy, Max Planck Institute für Kohlenforschung Kaiser Wilhelm Platz 1, 45470 Muelheim/Ruhr, Germany); wherein the optimized geometries and the HOMO and LUMO energy levels of the molecular structures are determined by applying the hybrid functional B3LYP with a 6-31G^{∗} basis set in the gas phase; whereby if more than one conformation is viable, the conformation with the lowest total energy is selected.

According to one embodiment, wherein a metal compound of formula (Ia) is excluded:

Fe^{3⊕}(L^{⊖})₃(AL)ₙ (Ia),

wherein
L has the formula (IIa) 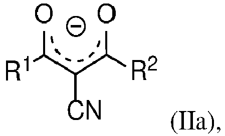 wherein
- R1: of formula (IIa) is selected from substituted C2 to C12 alkyl, substituted C6 to C19 aryl, substituted or unsubstituted C2 to C20 heteroaryl, or substituted or unsubstituted 6-membered heteroaryl;
- R2: of formula (IIa) is selected from substituted C6 to C19 aryl, substituted or unsubstituted C2 to C20 heteroaryl, substituted or unsubstituted 6-membered heteroaryl; wherein at least one of the substituents of the substituted C1 to C12 alkyl, substituted C6 to C19 aryl, substituted C2 to C20 heteroaryl, or substituted 6-membered heteroaryl are independently selected from halogen, Cl, F, CN, partially or perfluorinated C1 to C8 alkyl, partially or perfluorinated C1 to C8 alkoxy;
wherein
- L: of formula (Ia) comprises at least two CF3 groups and/or at least one N atom;
- AL: of formula (Ia) is an ancillary ligand which coordinates to the metal M;
- n: of formula (Ia) is an integer selected from 0 to 2.

According to another embodiment the organic electroluminescent device comprises an anode layer, a cathode layer, a first emission layer (EML), a hole injection layer (HIL) and a first hole transport layer (HTL), wherein
- the hole injection layer comprises a compound of formula (I):

   M^{n⊕}(L^{⊖})ₙ(AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II):

   [A¹-Y¹-X-Y²-A²]^{⊖} (II),

   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein
   at least two of the substituents in L of formula (II) are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 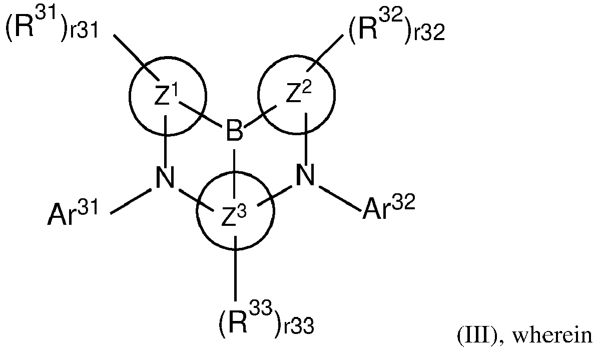
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
   wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
   - r31, r32 and r33: are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
   wherein the molecular weight Mw of the organic hole transport compound is in the range of ≥ 400 g/mol and ≤ 2000 g/mol;
   wherein the hole injection layer is arranged between the anode layer and the first hole transport layer; the first emission layer is arranged between the first hole transport layer and the cathode layer; and the first hole transport layer is arranged between the hole injection layer and the first emission layer; and
   wherein the ligand L of formula (II) is selected from the group of anionic ligands L of formula (IIb), (IIc) or (IId): 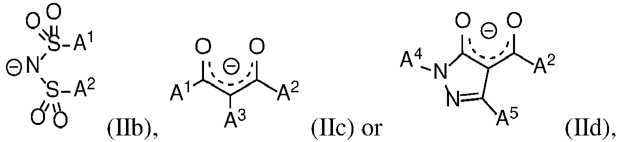 wherein
      - A¹ and A²: are independently selected from substituted or unsubstituted C₁ to C₁₂ alkyl, substituted or unsubstituted C₆ to C₁₂ aryl, substituted or unsubstituted C₃ to C₁₂ heteroaryl; wherein the substituents of A¹ and A² are independently selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN,
      wherein R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C3 to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
      - A³: is selected from H, D, CN, C₁ to C₄ alkyl, partially or perfluorinated C₁ to C₄ alkyl, F, or A¹ and A³ are bridged to form a cyclic ring, preferably A³ is selected as to form a cyclic structure with either A¹ or A², whereby 5- or 6- membered aliphatic or aromatic rings are preferred and whereby the ring may comprise one or more heteroatoms, preferably selected from N, O and S;
      - A⁴: is selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
      - A⁵: is selected from C₁ to C₆ alkyl, substituted or unsubstituted C₆ to C₁₂ aryl, substituted or unsubstituted C₃ to C₉ heteroaryl or CN, preferably CH₃ or CN,
   wherein the substituents on A⁴ and A⁵ are independently selected from D, CN, C₁ to C₄ alkyl, partially or perfluorinated C₁ to C₄ alkyl, halogen or F;
   wherein at least two of the substituents in L are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN; and
   wherein R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

According to another embodiment the organic electroluminescent device comprises an anode layer, a cathode layer, a first emission layer (EML), a hole injection layer (HIL) and a first hole transport layer (HTL), wherein
- the hole injection layer comprises a compound of formula (I):

   Mⁿ⊕(L^{⊖})ₙ(AL)ₘ (I),

   wherein
   - M: is a metal ion,
   - n: is an integer selected from 1 to 4, which corresponds to the oxidation number of M;
   - AL: is an ancillary ligand;
   - m: is an integer selected from 0, 1 or 2;
   - L: is a ligand of formula (II): 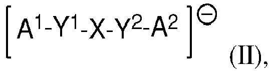
   - X is N or C-A³;
   - Y¹ and Y² are independently selected from CO or SO₂;
   - A¹ and A² are independently selected from substituted or unsubstituted C₁ to C₁₂ alkyl, substituted or unsubstituted C₆ to C₁₉ aryl, substituted or unsubstituted C₃ to C₁₂ heteroaryl,
      wherein the substituents on A¹ and A² are independently selected from D, C₆ aryl, C₃ to C₉ heteroaryl, C₁ to C₆ alkyl, C₁ to C₆ alkoxy, C₃ to C₆ branched alkyl, C3 to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN;
   - A³ is selected from H, D, C₁ to C₄ alkyl, partially or perfluorinated C₁ to C₄ alkyl, CN, F, or A¹ and A³ are bridged to form a cyclic ring;
   wherein
   at least two of the substituents in L of formula (II) are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
   wherein
   R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- the first emission layer comprises a compound of formula (III) and an organic emitter host compound: 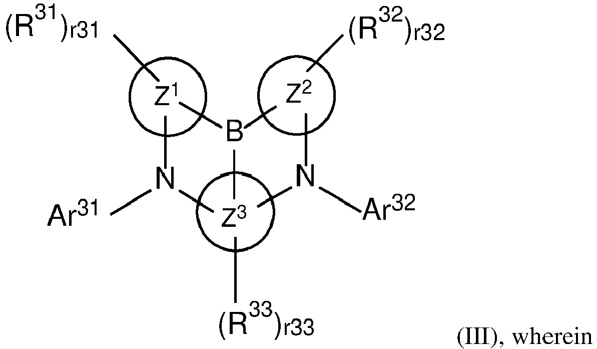
   - Z¹, Z² and Z³: are the same as or selected different from each other, and are each independently selected from the group comprising a monocyclic to polycyclic aromatic hydrocarbon ring or monocyclic to polycyclic aromatic hetero ring;
   - Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
   - R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
   wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
   - r31, r32 and r33: are each an integer from 0, 1, 2, 3 or 4, and when r31 to r33 are 2 or higher, substituents in the parenthesis are the same as or selected different from each other;
   wherein the organic emitter host compound comprises:
   - at least one condensed aromatic ring system consisting of at least ≥ 3 to ≤ 5 condensed aromatic rings, and
   - at least ≥ 3 to ≤ 7 aromatic rings and/or at least ≥ 3 to ≤ 7 heteroaromatic rings,
      wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
   wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
   - at least ≥ 1 to ≤ 3 amine moieties, preferably heteroaryl or aryl groups bonded to the amine unit, and
   - at least ≥ 8 to ≤ 12 aromatic rings or heteroaromatic rings, and
   wherein the molecular weight Mw of the organic hole transport compound is in the range of ≥ 400 g/mol and ≤ 2000 g/mol;
   wherein the hole injection layer is arranged between the anode layer and the first hole transport layer; the first emission layer is arranged between the first hole transport layer and the cathode layer; and the first hole transport layer is arranged between the hole injection layer and the first emission layer; and
   wherein the organic emitter host compound is selected from a compound of formula (V): 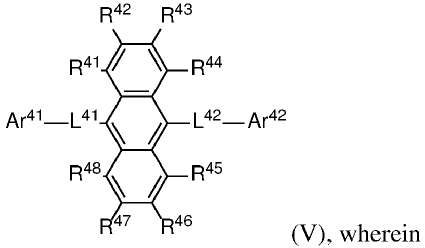
      - Ar⁴¹ and Ar⁴²: are independently selected from substituted or unsubstituted C₆ to C₂₄ aryl, substituted or unsubstituted C₃ to C₂₄ heteroaryl;
      - L⁴¹ and L⁴²: are independently selected from a direct bond or substituted or unsubstituted C₆ to C₂₄ arylene, substituted or unsubstituted C₃ to C₂₄ heteroarylene;
      - R⁴¹ to R⁴⁸: are independently selected from H, D, substituted or unsubstituted C₁ to C₁₂ alkyl, substituted or unsubstituted C₆ to C₁₉ aryl, substituted or unsubstituted C₃ to C₁₂ heteroaryl;
   wherein the substituents on Ar⁴¹, Ar⁴², L⁴¹, L⁴², R⁴¹ to R⁴⁸ are independently selected from D, C₆ to C₁₀ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, halogen, F or CN.

### Definitions

It should be noted that throughout the application and the claims any Aⁿ , Arⁿ, Rⁿ, Tⁿ etc. always refer to the same moieties, unless otherwise noted.

Ancillary ligands are defined as those ligands that provide the appropriate steric and
electronic environment around the central element but remain innocent in any transformation that the compound undergoes. In contrast, reactive ligands are those groups that undergo changes.

In the present specification, when a definition is not otherwise provided, "substituted" refers to at least one substituted with D, C₆ aryl, C₃ to C₉ heteroaryl, C₁ to C₆ alkyl, C₁ to C₆ alkoxy, C₃ to C6 branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR³, COOR³, halogen, F or CN.

In the present specification, when a definition is not otherwise provided, a substituted aryl group with at least 6 C-ring atoms can be substituted with 1, 2, 3, 4 or 5 substituents. For example a substituted C₆ aryl group may have 1, 2, 3, 4 or 5 phenyl substituents.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, a substituted heteroaryl group with at least 2 C-ring atoms can be substituted with one or more substituents. For example a substituted C₂ heteroaryl group may have 1 or 2 substituents.

In the present specification, when a definition is not otherwise provided, an "alkyl group" refers to a saturated aliphatic hydrocarbyl group. The alkyl group may be a C₁ to C₆ alkyl group. More specifically, the alkyl group may be a C₁ to C₄ alkyl group or a C₁ to C₃ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a sec-butyl group, a tert-butyl group, a pentyl group, a branched pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methyl cyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

Preferred examples of the hole transport compounds, which can be covalent hole transport compounds, are organic compounds, consisting substantially from covalently bound C, H, O, N, S, which may optionally comprise also covalently bound B, P or Si. In one embodiment, the hole transport compounds, which can be a covalent compound, is free of metal atoms and majority of its skeletal atoms may be selected from C, O, S, N. Alternatively, the covalent compound is free of metal atoms and majority of its skeletal atoms may be selected from C and N.

In the present specification, "aryl group" and "aromatic rings" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under "heteroaryl" and "heteroaromatic", it is especially where suitable understood a group derived by formal abstraction of one ring hydrogen from a heterocyclic aromatic ring in a compound comprising at least one such ring.

The term "non-heterocycle" is understood to mean a ring or ring-system comprising no hetero-atom as a ring member.

The term "heterocycle" is understood to mean that the heterocycle comprises at least one ring comprising one or more hetero-atoms. A heterocycle comprising more than one ring means that all rings comprising a hetero-atom or at least one ring comprising a hetero atom and at least one ring comprising C-atoms only and no hetero atom.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "fused ring system" is understood to mean a ring system wherein two or more rings share at least two atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₃ to C₁₈ heteroaryl.

In the present specification, when a substituent is not named, the substituent can be a H.

In the context of the present invention, "different" means that the compounds do not have an identical chemical structure.

The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-emitting layer", "light emission layer" and "emission layer" are used synonymously.

The terms "OLED", "organic light-emitting diode", organic electroluminescent device" and "organic light-emitting device" are used synonymously.

The terms anode, anode layer and anode electrode are used synonymously.

The term "at least two anode sub-layers" is understood to mean two or more anode sub-layers, for example two or three anode sub-layers.

The terms cathode, cathode layer and cathode electrode are used synonymously.

The term "hole injection layer" is understood to mean a layer which improves charge injection from the anode layer into further layers in the organic electroluminescent device or from further layers of the organic electroluminescent device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of compound of formula (I) and the matrix compound of formula (IV), wherein formula (IV) is selected formula (IVa) or formula (IVb), and/or layer, such as hole injection layer, to the visible emission spectrum from an organic electroluminescent device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "LUMO level" is understood to mean the lowest unoccupied molecular orbital and is determined in eV (electron volt).

The term "LUMO level further away from vacuum level" is understood to mean that the absolute value of the LUMO level is higher than the absolute value of the LUMO level of the reference compound.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi[fluorene]-2,2',7,7'-tetraamine is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "-" symbol. According to one embodiment of the present invention, the HOMO level of the matrix compound of the hole injection layer may be calculated by quantum mechanical methods.

### Advantageous Effects

Surprisingly, it was found that the organic electroluminescent device according to the invention solves the problem underlying the present invention by enabling organic electroluminescent device or organic electroluminescent devices, such as organic light-emitting diodes, in various aspects superior over the organic electroluminescent devices known in the art, in particular with respect to operating voltage, voltage stability over time and/or lifetime.

In particular the organic electroluminescent device possess an improved performance in operating voltage, EQE, cd/A efficiency, lifetime and/or voltage stability over time U(100h)-(1h).

Additionally, it was found that the problem underlying the present invention can be solved by using compounds which may be suitable for deposition through vacuum thermal evaporation under conditions suitable for mass production. In particular, the thermal stability and/or rate onset temperature of the compounds of formula (I) and the organic hole transport compound used may be in a range suitable for mass production.

Furthermore, it was found that the problem underlying the present invention can be solved by using compounds which may have reduced health and safety risk compared to the art. Thereby, the compounds may be suitable for mass production.

### Metal ion

The compounds according to formula (I) are non-emissive. In the context of the present specification the term "essentially non-emissive" or "non-emissive" means that the contribution of the compound according to formula (I) to the visible emission spectrum from an organic electroluminescent device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment, wherein the compound of formula (I) may have a molecular weight Mw of ≥ 287 g/mol and ≤ 2000 g/mol, preferably a molecular weight Mw of ≥ 400 g/mol and ≤ 1500 g/mol, further preferred a molecular weight Mw of ≥ 580 g/mol and ≤ 1500 g/mol, in addition preferred a molecular weight Mw of ≥ 580 g/mol and ≤ 1400 g/mol.

According to one embodiment of the present invention, the valency of M of the compound according to formula (I) may be 1 to 4, preferably 1, 2, 3 or 4.

According to one embodiment, M may be selected from an alkali metal, alkaline earth metal, transition metal, or group III or V metal.

The alkali metals may be selected from the group comprising Li, Na, K, Rb or Cs. The alkaline earth metals may be selected from the group comprising Mg, Ca, Sr or Ba. The transition metals may be selected from Sc, Y, La, Ti, Zr, V, Nb, Ta, Cr, Mo, W, Mn, Re, Fe, Co, Ni, Cu, Ag, Au or Zn. The rare earth metal may be selected from Ce. The group III and V metal may be selected from the group comprising Bi and Al.

According to one embodiment of the present invention, M is selected from Li, Na, K, Rb, Cs, Mg, Mn, Cu, Zn, Ag, Bi and Ce; preferably M is selected from Na, K, Rb, Cs, Mg, Mn, Cu, Zn, Ag and Bi; also preferred M is selected from Na, K, Rb, Cs, Mg, Mn, Cu, Zn, Ag and Bi, wherein if M is Cu, n is 2, and if M is Ce, n is 4.

According to one embodiment of the present invention M is selected from Na, Ag, Zn, Cu, Bi or Ce, wherein if M is Cu, n is 2 and if M is Ce, n is 4.

According to one embodiment of the present invention, M is not Li.

### Ancillary ligand AL

According to one embodiment, wherein AL can be selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (AL-I); 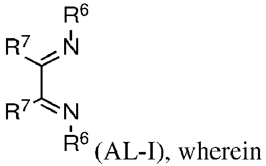
- R⁶ and R⁷: are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

### Ligand L of formula (I)

According to one embodiment, wherein the ligand L of formula (II) may comprises at least 3 fluorine atoms, more preferred at least 4 fluorine atoms, also preferred at least 6 fluorine atoms and more preferred ≥ 3 to ≤ 60 fluorine atoms.

According to one embodiment, wherein the ligand L of formula (II) may be selected from the group of anionic ligands L of formula (IIb), (IIc) or (IId): 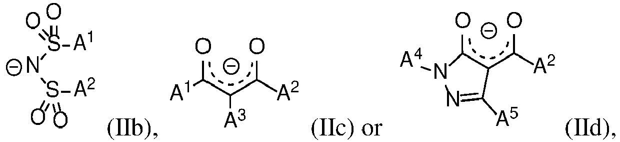 wherein
- A¹ and A²: are independently selected from substituted or unsubstituted C₁ to C₁₂ alkyl, substituted or unsubstituted C₆ to C₁₂ aryl, substituted or unsubstituted C₃ to C₁₂ heteroaryl;
wherein the substituents of A¹ and A² are independently selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN,
wherein R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C3 to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy;
- A³: is selected from H, D, CN, C₁ to C₄ alkyl, partially or perfluorinated C₁ to C₄ alkyl, F, or A¹ and A³ are bridged to form a cyclic ring, whereby preferably A³ is selected as to form a cyclic structure with either A¹ or A², whereby 5- or 6- membered aliphatic or aromatic rings are preferred and whereby the ring may comprise one or more heteroatoms, preferably selected from N, O and S;
- A⁴: is selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
- A⁵: is selected from C₁ to C₆ alkyl, substituted or unsubstituted C₆ to C₁₂ aryl, substituted or unsubstituted C₃ to C₉ heteroaryl or CN, preferably CH₃ or CN,
wherein
the substituents on A⁴ and A⁵ are independently selected from D, CN, C₁ to C₄ alkyl, partially or perfluorinated C₁ to C₄ alkyl, halogen or F;
wherein
at least two of the substituents in L are independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
wherein R¹ is selected from C₆ aryl, C₃ to C₉ heteroaryl, C₁ to C₆ alkyl, C₁ to C6 alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C₆ alkoxy.

According to one embodiment, wherein the ligand L in compound of formula (I) comprises per ligand L at least 15 covalently bound atoms and may be selected from a group comprising:
- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted C₁ to C₆ alkyl, substituted or unsubstituted C₁ to C₆ alkoxy, alternatively two or more groups selected from halogen, F, CN, substituted or unsubstituted C₁ to C₆ alkyl, substituted or unsubstituted C₁ to C₆ alkoxy, at least one or more groups selected from halogen, F, CN, substituted C₁ to C₆ alkyl, substituted C₁ to C₆ alkoxy, alternatively two or more groups selected from halogen, F, CN, perfluorinated C₁ to C₆ alkyl, perfluorinated C₁ to C₆ alkoxy, one or more groups selected from substituted or unsubstituted C₁ to C₆ alkyl, substituted or unsubstituted C₆ to C₁₂ aryl, and/or substituted or unsubstituted C₃ to C₁₂ heteroaryl,
   wherein the substituents are selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR³, COOR³, halogen, F or CN;
   wherein R³ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C6 cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

According to one embodiment, wherein the ligand L of formula (IIb), (IIc) or (IId) may be selected from a compound of G1 to G113:

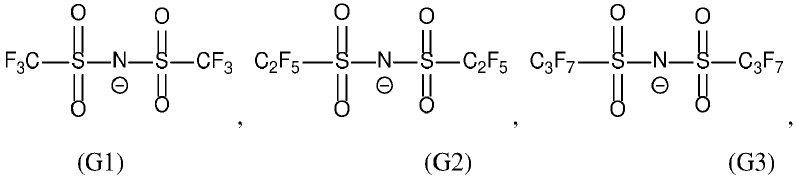

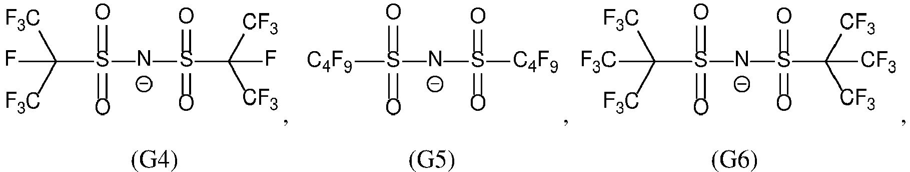

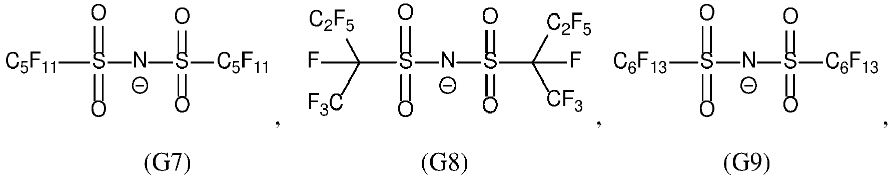

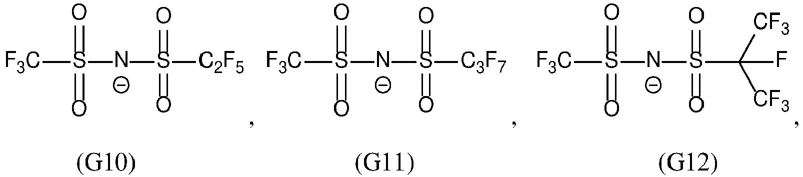

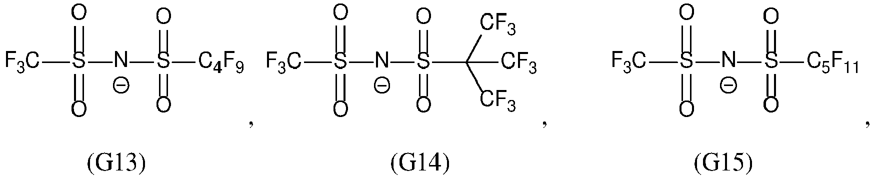

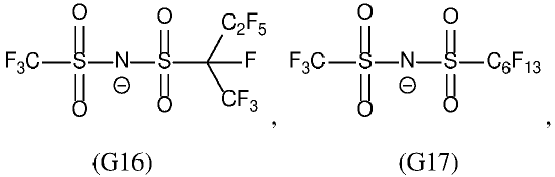

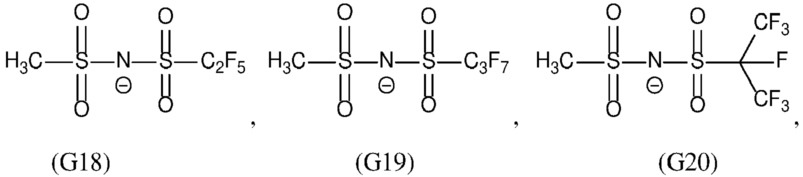

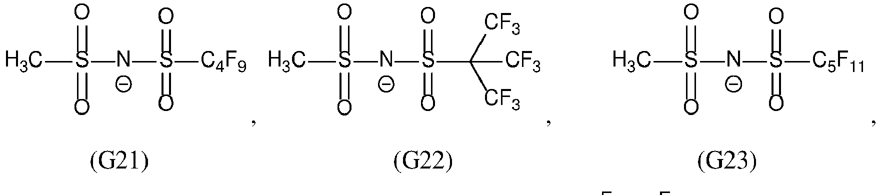

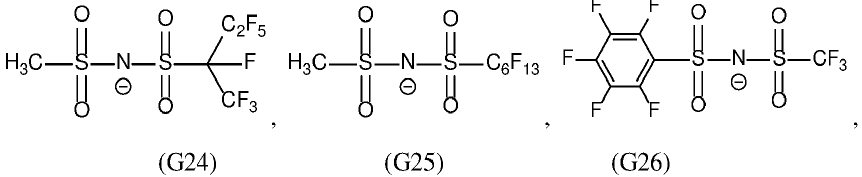

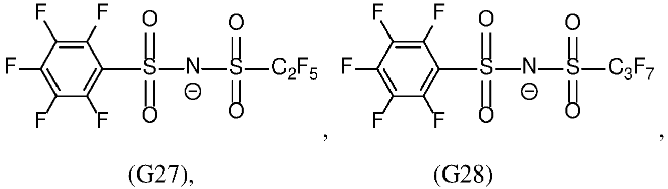

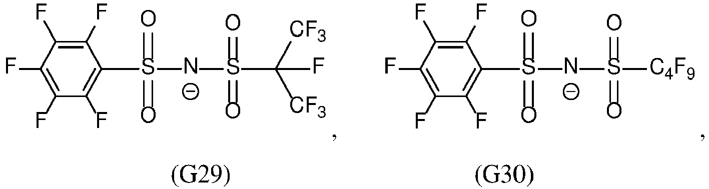

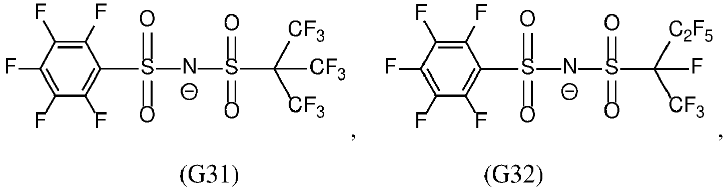

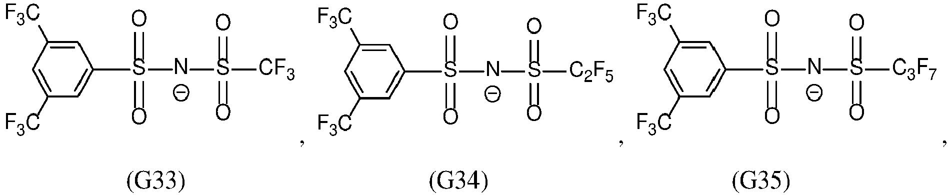

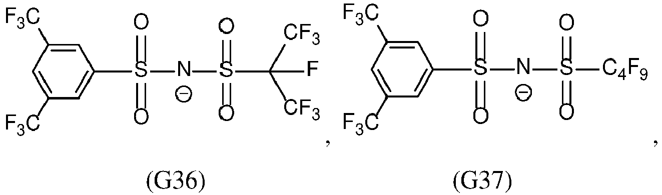

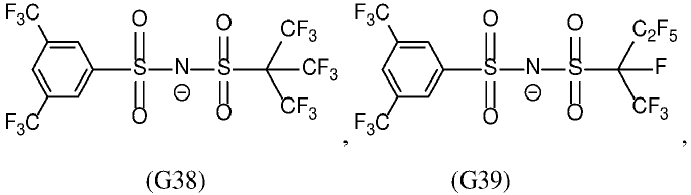

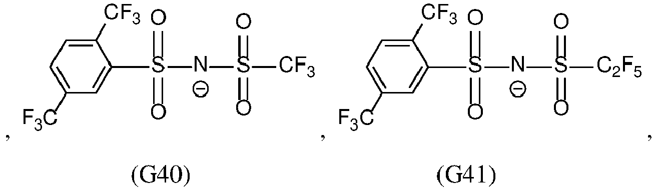

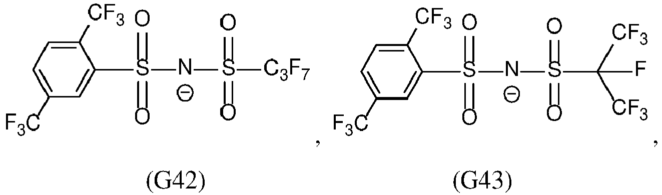

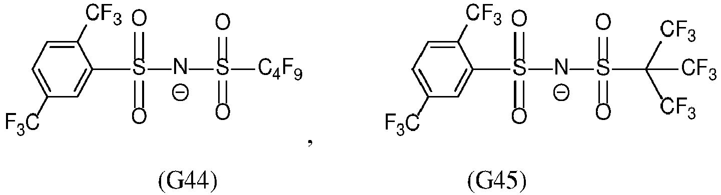

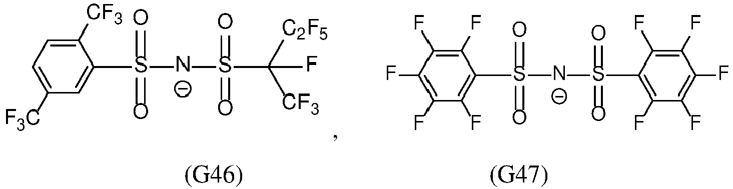

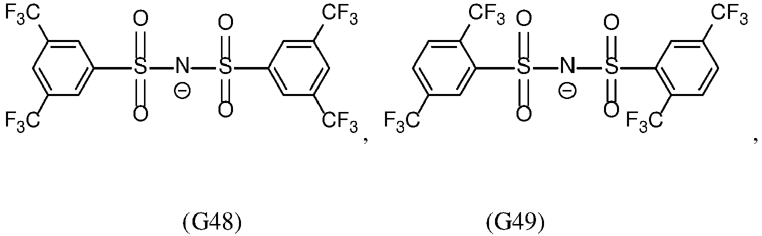

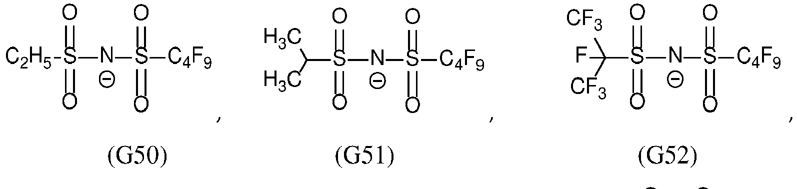

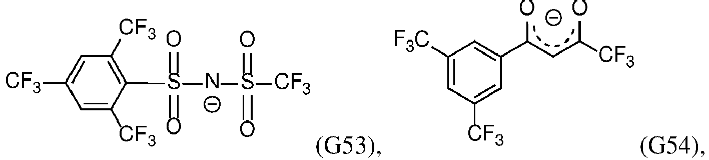

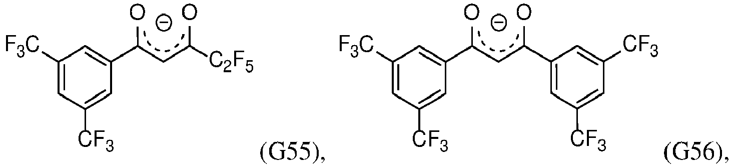

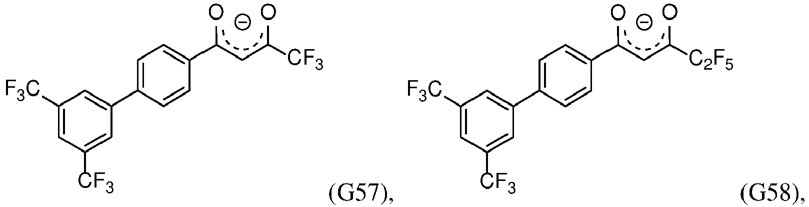

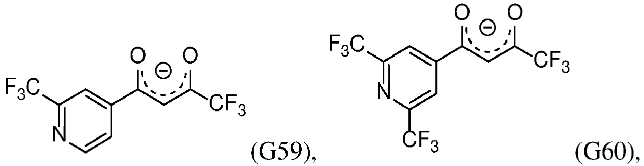

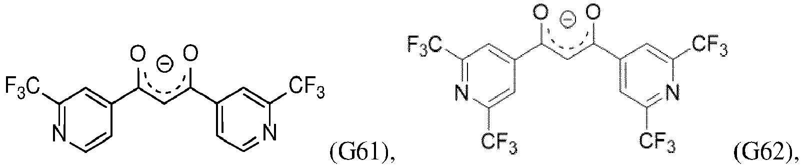

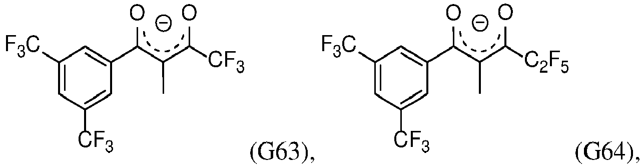

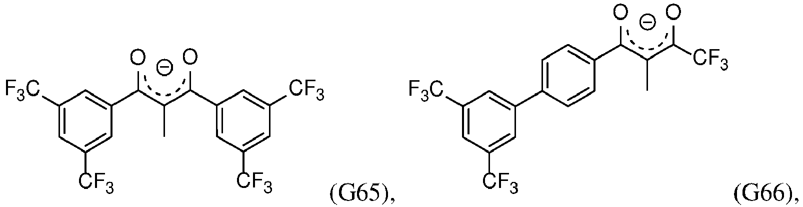

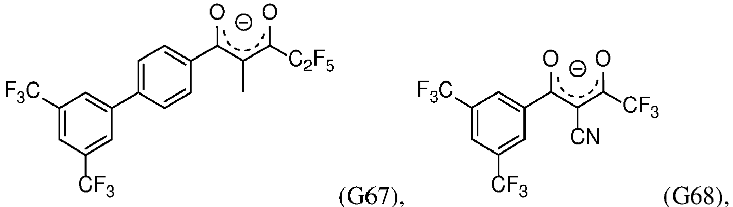

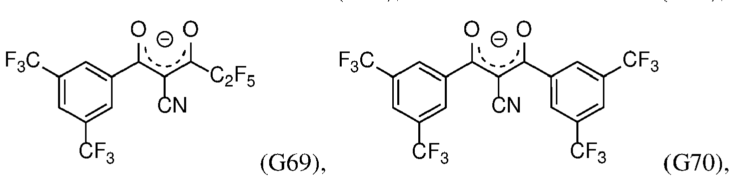

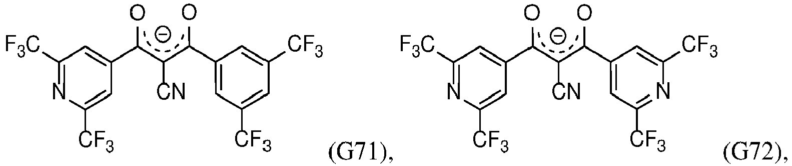

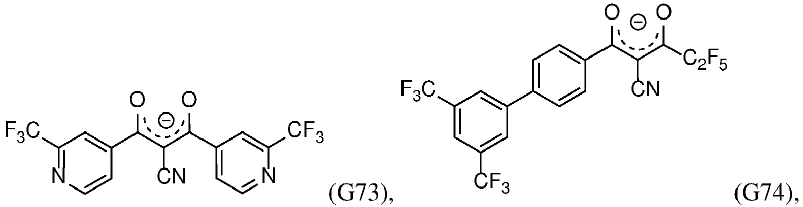

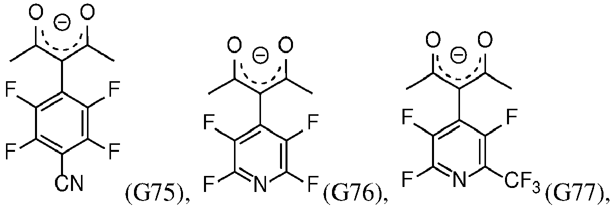

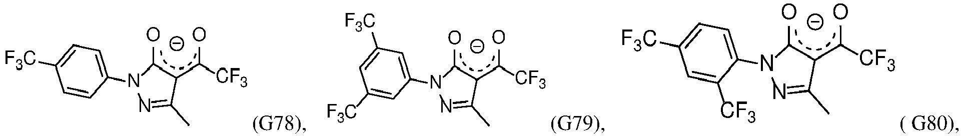

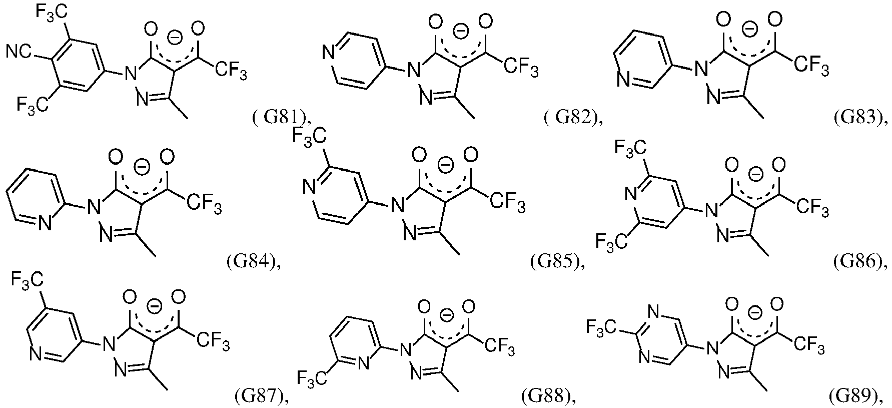

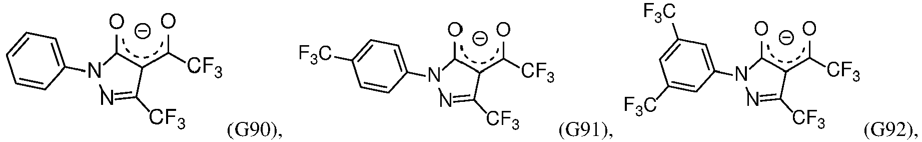

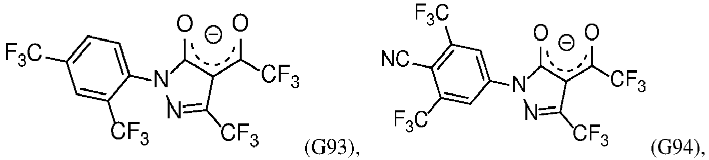

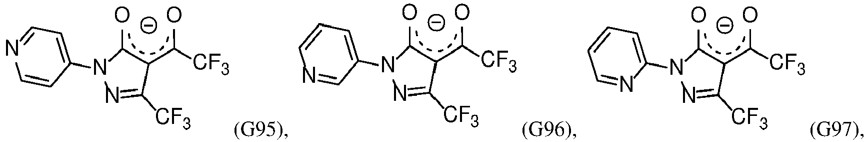

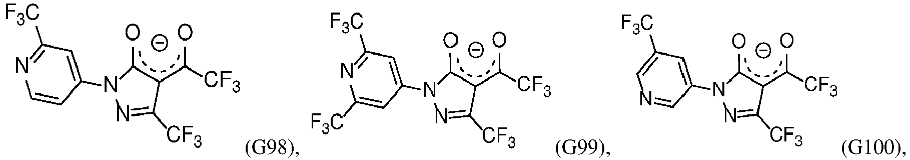

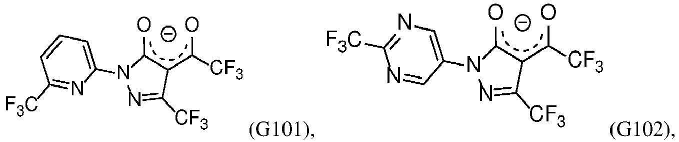

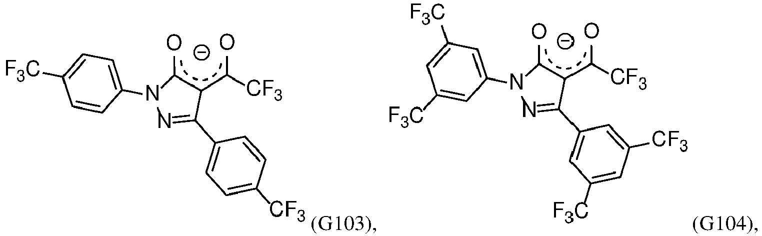

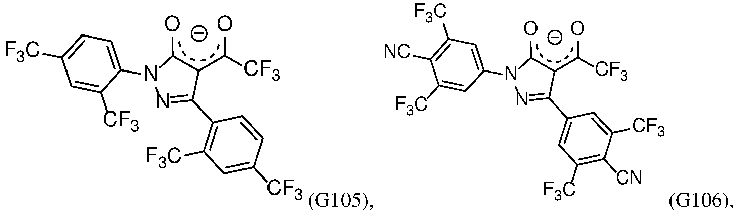

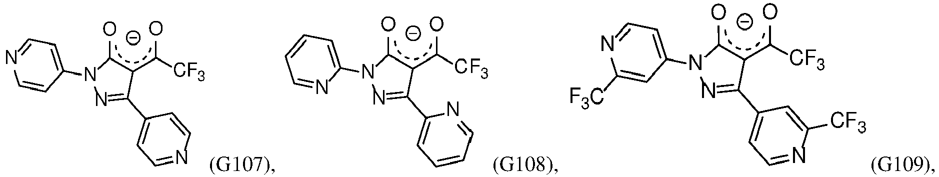

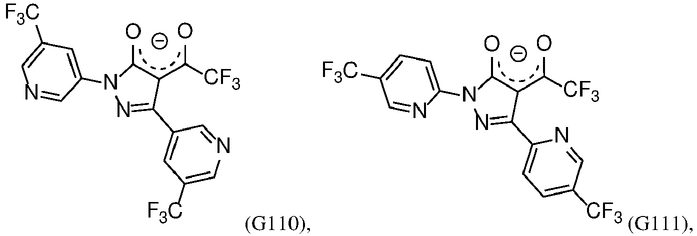

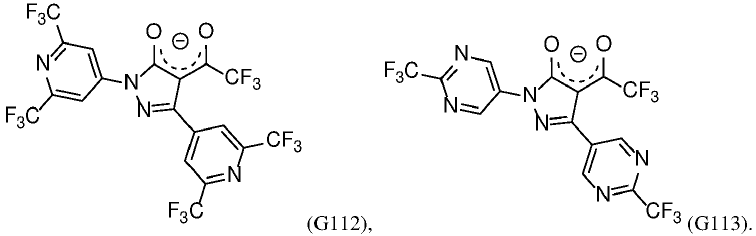

According to one embodiment, L of formula (I) is selected from (G2) to (G113), preferably from (G2) to (G77).

According to one embodiment, L of formula (I) is selected from (G1) to (G77), preferably from (G1) to (G74).

### Compound of formula (I)

According to one embodiment, wherein the compound of formula (I) is selected from: Li TFSI, K TFSI, Cs TFSI, Ag TFSI, Mg(TFSI)₂, Mn(TFSI)₂, Sc(TFSI)₃, Na[N(SO₂C₄F₉)₂], K[N(SO₂C₄F₉)₂], Mg[N(SO₂ⁱC₃F₇)₂]₂, Zn[N(SO₂ⁱC₃F₇)₂]₂, Ag[N(SO₂ⁱC₃F₇)₂], Ag[N(SO₂C₃F₇)₂], Ag[N(SO₂C₄F₉)₂], Ag[N(SO₂CF₃)(SO₂C₄F₉)], Cs[N(SO₂C₄F₉)₂], Mg[N(SO₂C₄F₉)₂]₂, Ca[N(SO₂C₄F₉)₂]₂, Ag[N(SO₂C₄F₉)₂], Cu[N(SO₂ⁱC₃F₇)₂]₂, Cu[N(SO₂C₃F₇)₂]₂, Cu[N(SO₂CF₃) (SO₂C₄F₉)]₂, Cu [N(SO₂C₂H₅) (SO₂C₄F₉)]₂, Cu [N(SO₂ ⁱC₃H₇) (SO₂C₄F₉)]₂, Cu [N(SO₂ ⁱC₃F₇) (SO₂C₄F₉)]₂, Cu[N(SO₂CH₃) (SO₂C₄F₉)]₂, Mg[N(SO₂CF₃) (SO₂C₄F₉)]₂, Mn[N(SO₂CF₃) (SO₂C₄F₉)]₂, Ag[N(SO₂CH₃) (SO₂C₄F₉)], 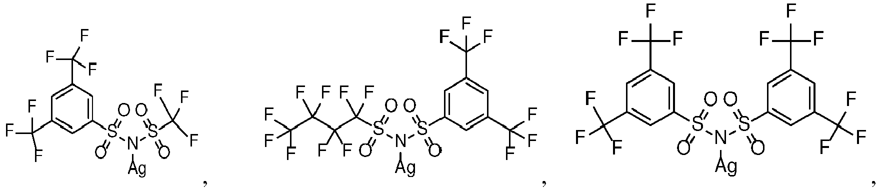 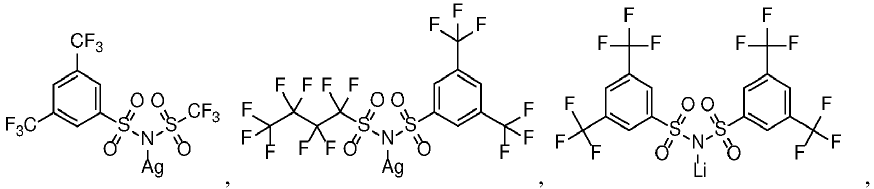 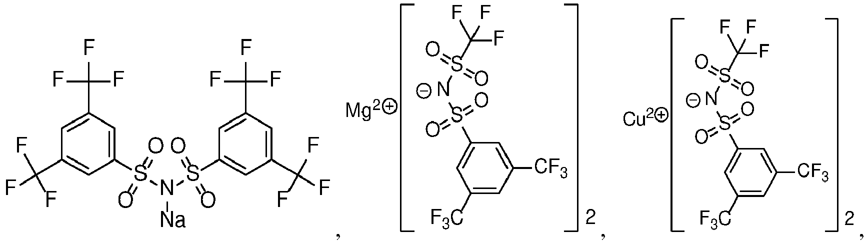 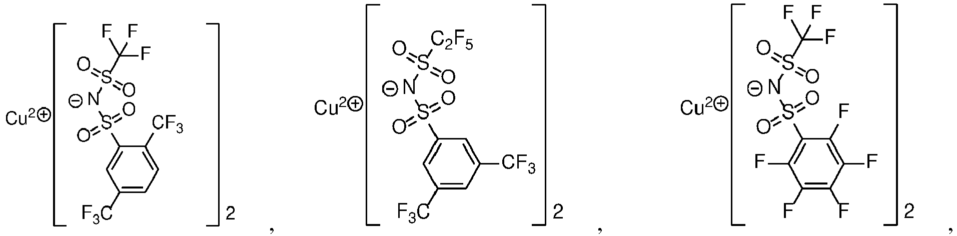 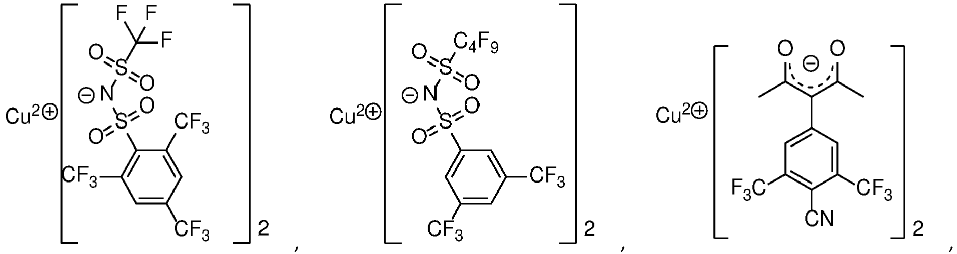 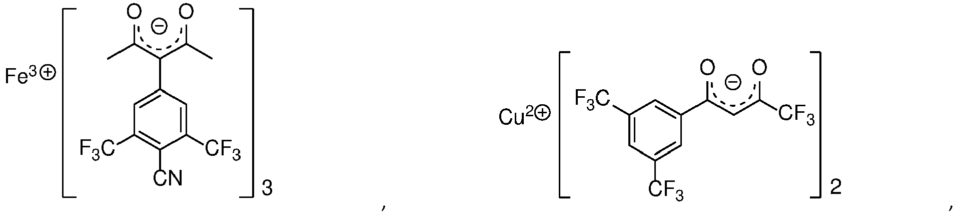 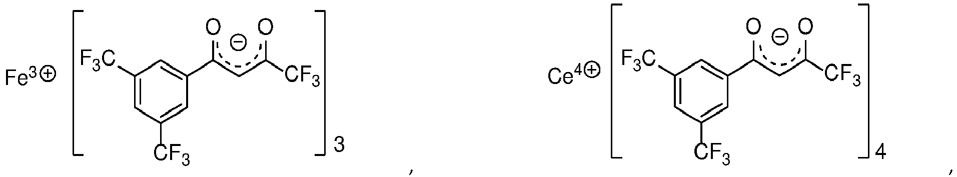 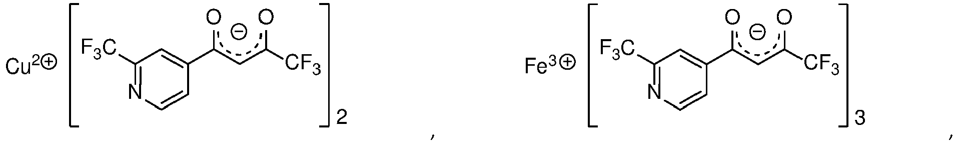 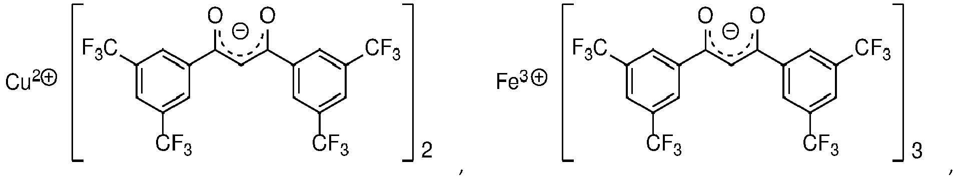 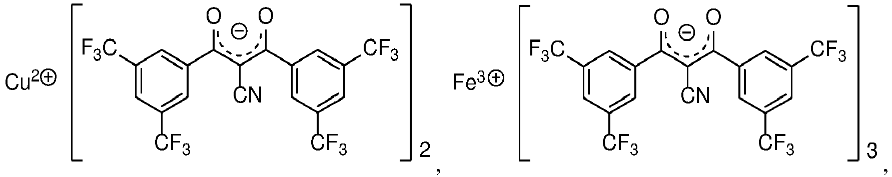 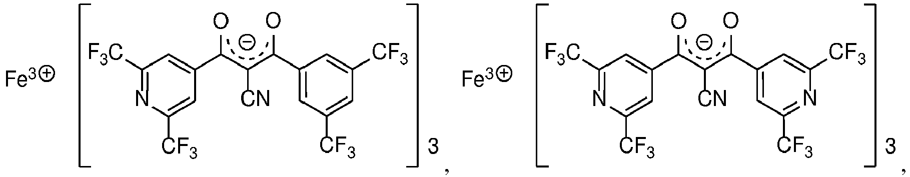 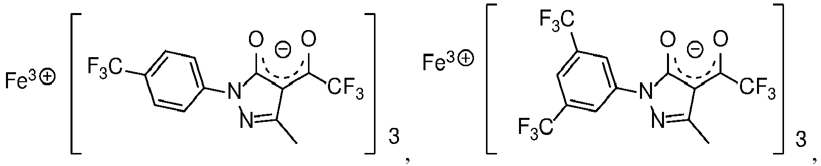 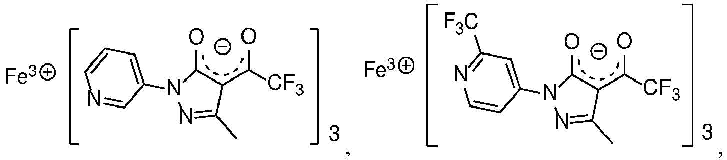 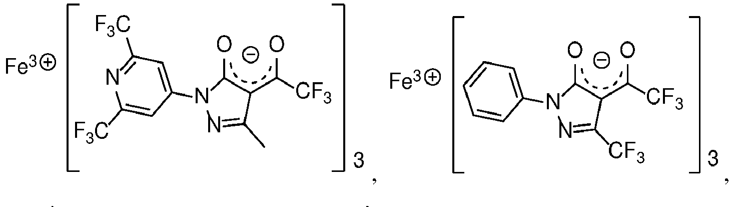 wherein ^{"1"} denotes "iso". For example "¹C₃F₇" denotes iso-heptafluoropropyl.

### Compound of formula (III)

According to one embodiment the emission layer, preferably the first emission layer, comprises a compound of formula (III): 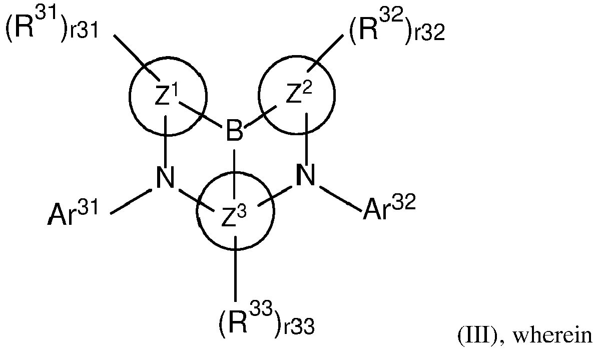
- Z¹, Z² and Z³: are the same as or selected different from each other, and are each independently selected from the group comprising a monocyclic to polycyclic aromatic hydrocarbon ring or monocyclic to polycyclic aromatic hetero ring;
- Ar³¹ and Ar³²: are the same as or selected different from each other, and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a
substituted or unsubstituted aliphatic ring;
- R³¹, R³² and R³³: are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents of Ar³¹,Ar³², R³¹, R³² and R³³ are independently selected from each other from the group comprising of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
- r31, r32 and r33: are each an integer from 0, 1, 2, 3 or 4, and when r31 to r33 are 2 or higher, substituents in the parenthesis are the same as or selected different from each other.

According to one embodiment, wherein for formula (III):
- Z¹, Z² and Z³: are the same as or selected different from each other, and are each independently selected from the group comprising a monocyclic to bicyclic aromatic hydrocarbon ring, or a monocyclic to bicyclic aromatic hetero ring containing O, N or S;
- Ar³¹ and Ar³²: are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;
- R³¹, R³² and R³³: are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (III):
- Z¹, Z² and Z³: are the same as or selected different from each other, and are each independently selected from the group comprising a benzene ring or a thiophene ring;
- Ar³¹ and Ar³²: are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;
- R³¹, R³² and R³³: are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to one embodiment the emission layer, preferably the first emission layer, comprises a compound of formula (III), wherein the compound of formula (III) is selected from the group of BD1 to BD9:

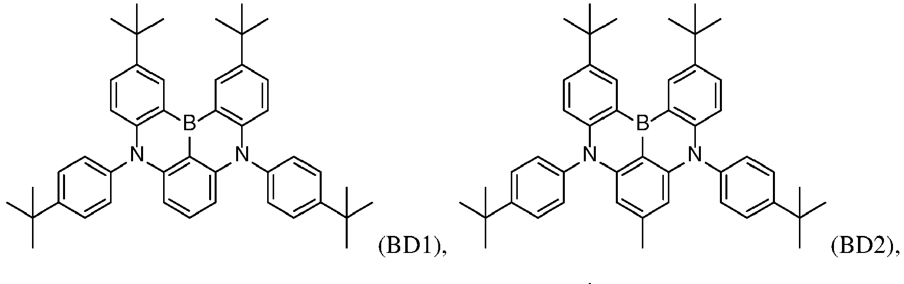

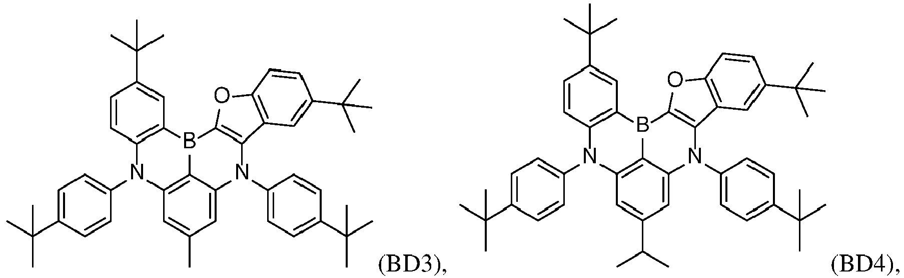

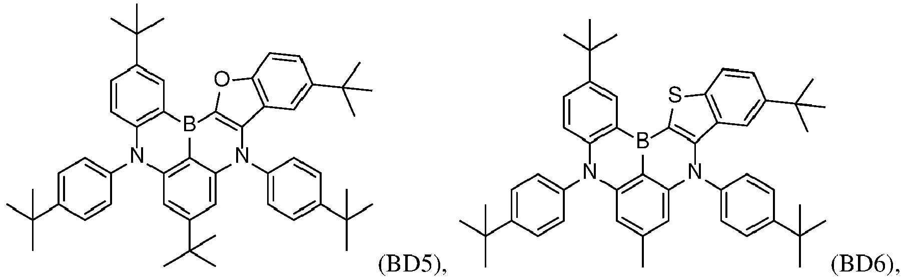

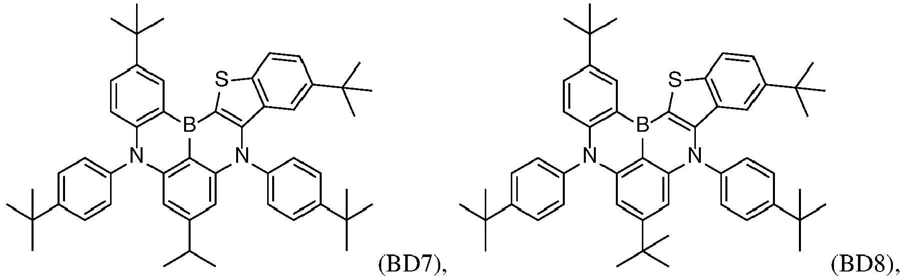

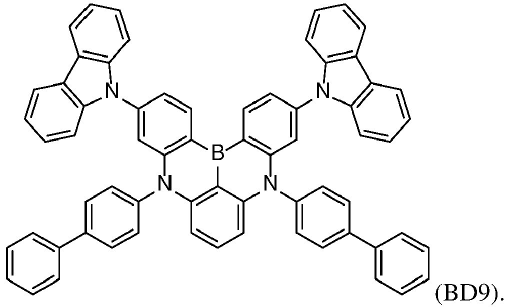

### Organic emitter host compound

According to one embodiment the emission layer, preferably the first emission layer, comprises an organic emitter host compound.

According to one embodiment the emission layer, preferably the first emission layer, comprises an organic emitter host compound, wherein the organic emitter host compound is selected from a compound of formula (V): 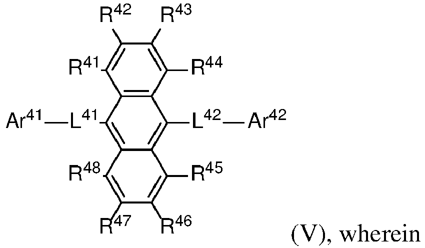
- Ar⁴¹ and Ar⁴²: are independently selected from substituted or unsubstituted C6 to C24 aryl, substituted or unsubstituted C3 to C24 heteroaryl;
- L⁴¹ and L⁴²: are independently selected from a direct bond or substituted or unsubstituted C6 to C24 arylene, substituted or unsubstituted C3 to C24 heteroarylene;
- R⁴¹ to R⁴⁸: are independently selected from H, D, substituted or unsubstituted C₁ to C₁₂ alkyl, substituted or unsubstituted C6 to C₁₉ aryl, substituted or unsubstituted C3 to C12 heteroaryl;
wherein the substituents on Ar⁴¹, Ar⁴², L⁴¹, L⁴², R⁴¹ to R⁴⁸ are independently selected from D, C₆ to C₁₀ aryl, C3 to C9 heteroaryl, C₁ to C6 alkyl, C₁ to C6 alkoxy, C3 to C6 branched alkyl, C3 to C6 cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C6 alkoxy, halogen, F or CN.

According to one embodiment, wherein the organic emitter host compound of formula (V) is selected from a compound of BH1 to BH13:

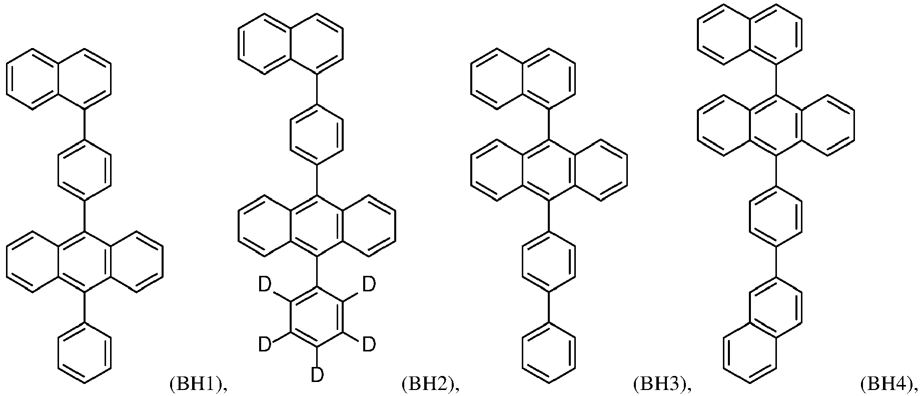

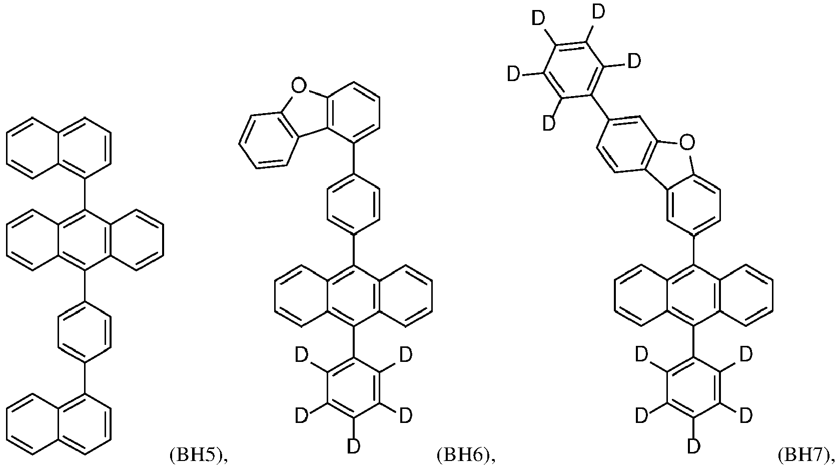

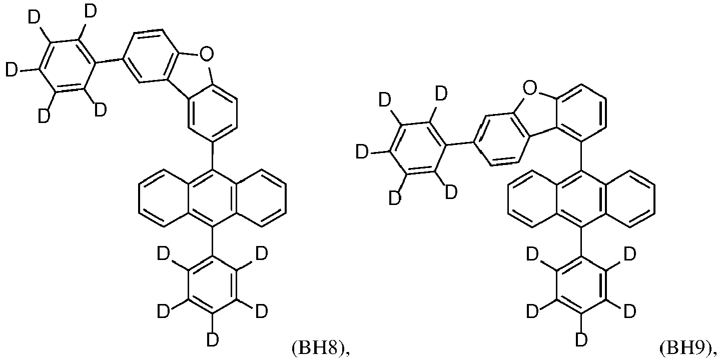

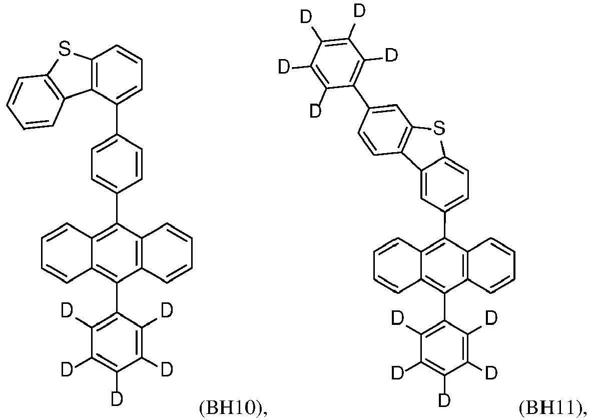

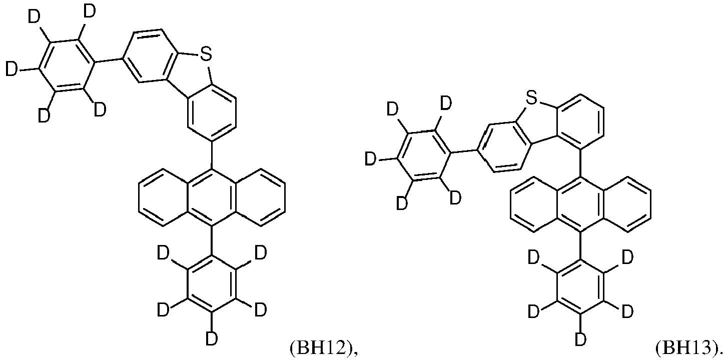

### Organic hole transport compound

At least the first hole transport layer comprises an organic hole transport compound.

The organic hole transport compound, also referred to as "matrix compound" or "hole transport compound", of the hole transport layer may comprises at least ≥ 1 to ≤ 3 amine moieties, and at least ≥ 8 to ≤ 12 aromatic rings or heteroaromatic rings, and wherein the molecular weight Mw of the organic hole transport compound is in the range of ≥ 400 g/mol and ≤ 2000 g/mol.

According to an embodiment at least one heteroaryl group or at least one aryl group are bonded to the amine unit of the at least ≥ 1 to ≤ 3 amine moieties, preferably heteroaryl or aryl groups bonded to the amine unit.

According to another embodiment, the organic hole transport compound, also referred to as "matrix compound" may comprises at least one arylamine compound, diarylamine compound, triarylamine compound, a compound of formula (IV), wherein the compound of formula of (IV) is selected from a compound of formula (IVa) or a compound of formula (IVb): 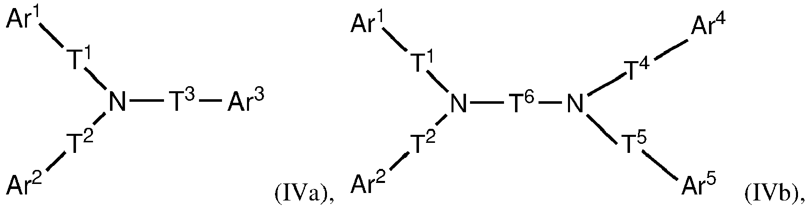 wherein:
- T¹, T², T³, T⁴ and T⁵: are independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: are independently selected from substituted or unsubstituted C₆ to C20 aryl, or substituted or unsubstituted C3 to C20 heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C6 to C₁₈ aryl or C3 to C₁₈ heteroaryl.

According to an embodiment of the organic electroluminescent device, wherein the organic hole transport compound of the hole transport layer, preferably the first hole transport layer, comprises a compound of formula (IV), wherein the compound of formula of (IV) is selected from a compound of formula (IVa) or a compound of formula (IVb): 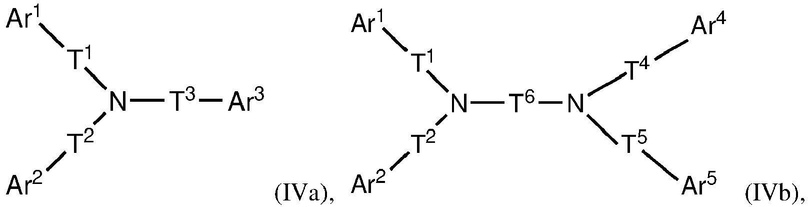 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from substituted or unsubstituted C₆ to C20 aryl, or substituted or unsubstituted C3 to C20 heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar¹, Ar², Ar³, Ar⁴ and Ar⁵ are selected the same or different from the group comprising H, straight-chain alkyl having 1 to 20 carbon atoms, branched alkyl having 1 to 20 carbon atoms, cyclic alkyl having 3 to 20 carbon atoms, alkenyl or alkynyl groups having 2 to 20 carbon atoms, alkoxy groups having 1 to 20 carbon atoms, C6 to C₁₈ aryl, C3 to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

Preferably, the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, alkoxy groups having 1 to 6 carbon atoms, C6 to C₁₈ aryl, C3 to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.
Thereby, the compound of formula (IVa) or (IVb) may have a rate onset temperature suitable for mass production.

According to an embodiment of the organic electroluminescent device, wherein the organic hole transport compound of the hole transport layer, preferably the first hole transport layer, comprises a compound of formula (IV), wherein the compound of formula of (IV) is selected from a compound of formula (IVa) or a compound of formula (IVb): 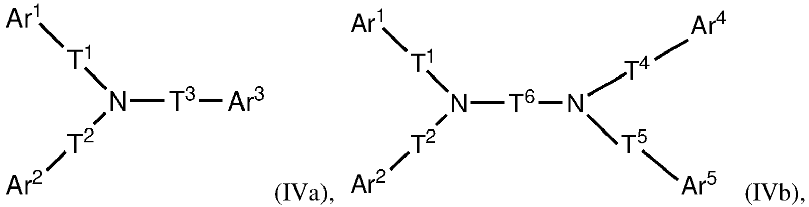 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C6 to C20 aryl, or unsubstituted C3 to C20 heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment of the organic electroluminescent device, wherein the organic hole transport compound of the hole transport layer, preferably the first hole transport layer, comprises a compound of formula (IV), wherein the compound of formula of (IV) is selected from a compound of formula (IVa) or a compound of formula (IVb): 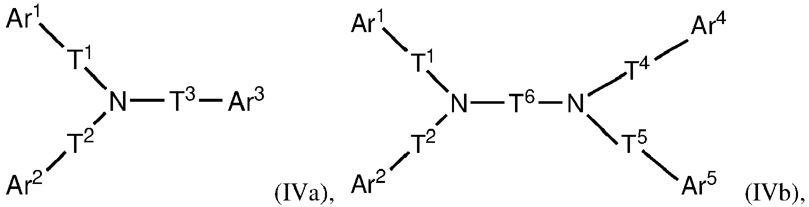 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C6 to C20 aryl, or unsubstituted C3 to C20 heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (IVa) or (IVb) may have a rate onset temperature suitable for mass production.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from K1 to K16: 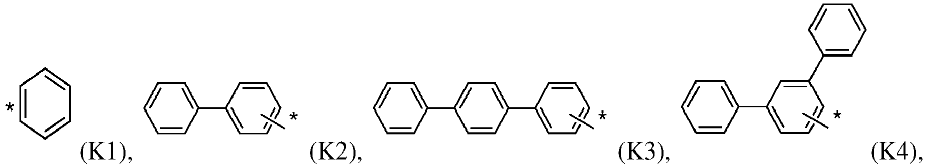 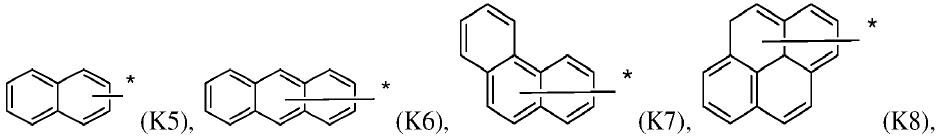 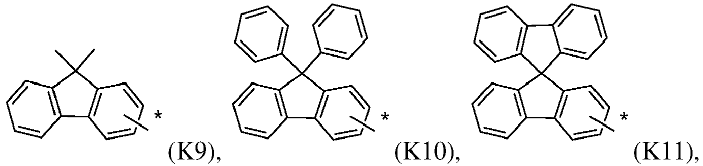 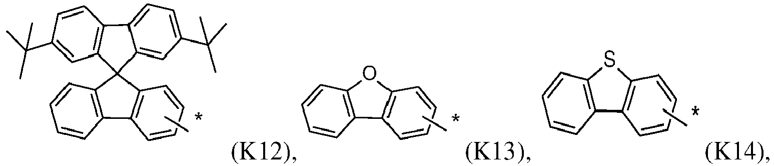 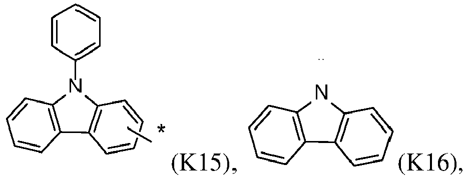 wherein the asterix "^{∗}" denotes the binding position.

According to an embodiment, wherein Ar¹, Ar², Ar³, Ar⁴ and Ar⁵ may be independently selected from K1 to K15; alternatively selected from K1 to K10 and K13 to K15.

According to an embodiment, wherein Ar¹, Ar², Ar³, Ar⁴ and Ar⁵ may be independently selected from the group consisting of K1, K2, K5, K7, K9, K10, K13 to K16.

The rate onset temperature may be in a range particularly suited to mass production, when Ar¹, Ar², Ar³, Ar⁴ and Ar⁵ are selected in this range.

The "organic hole transport compound of formula (IVa) or formula (IVb) " may be also referred to as "matrix compound".

According to one embodiment the organic hole transport compound of formula (IVa) or formula (IVb) may comprises at least ≥ 1 to ≤ 6 substituted or unsubstituted aromatic fused ring systems comprising heteroaromatic rings.

According to one embodiment the organic hole transport compound of formula (IVa) or formula (IVb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the organic hole transport compound of formula (IVa) or formula (IVb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the organic hole transport compound of formula (IVa) or formula (IVb) may comprises at least ≥ 1 to ≤ 3 or 2 substituted or unsubstituted unsaturated 5- to 7-member ring of a heterocycle.

According to one embodiment the organic hole transport compound of formula (IVa) or formula (IVb) may comprises at least ≥ 1 to ≤ 3 or 2 substituted or unsubstituted unsaturated 7-member ring of a heterocycle.

According to one embodiment substituted or unsubstituted aromatic fused ring systems of the organic hole transport compound of formula (IVa) or formula (IVb) may comprises at least ≥ 1 to ≤ 3 or 2 substituted or unsubstituted unsaturated 5- to 7-member ring of a heterocycle.

According to one embodiment the substituted or unsubstituted aromatic fused ring systems of the organic hole transport compound of formula (IVa) or formula (IVb) may comprises at least ≥ 1 to ≤ 3 or 2 substituted or unsubstituted unsaturated 7-member ring of a heterocycle.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the organic hole transport compound of formula (IVa) or formula (IVb) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the organic hole transport compound of formula (IVa) or formula (IVb) may comprises:
- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5- to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the organic hole transport compound of formula (IVa) or formula (IVb) may comprises at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the organic hole transport compound of formula (IVa) or formula (IVb) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment the organic hole transport compound of formula (IVa) or formula (IVb) may comprises :
- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and
      the hole transport compound or the hole transport compound according to formula I comprises at least ≥ 1 to ≤ 4, preferably 2 or 3 aromatic 5-member-rings, preferably hetero aromatic 5-member-rings, and/or
      the hole transport compound or the hole transport compound according to formula (I) comprises at least 1 or 2 unsaturated 5- to 7-member-ring of a heterocycle, preferably at least 1 or 2 unsaturated 7-member-ring of a heterocycle.

According to one embodiment the organic hole transport compound of formula (IVa) or formula (IVb) may comprises a hetero-atom, which may be selected from the group comprising O, S, N, B or P, preferably the hetero-atom may be selected from the group comprising O, S or N.

According to one embodiment the organic hole transport compound of formula (IVa) or formula (IVb) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
   wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment the organic hole transport compound of formula (IVa) or formula (IVb) may be free of hetero-atoms which are not part of an aromatic ring and/or part of an unsaturated 7-member-ring, preferably the hole transport compound or the hole transport compound according to formula (I) may be free on N-atoms except N-atoms which are part of an aromatic ring or are part of an unsaturated 7-member-ring.

According to one embodiment, the organic hole transport compound comprises at least one naphthyl group, carbazole group, dibenzofurane group, dibenzothiophene group and/or substituted fluorenyl group, wherein the substituents are independently selected from methyl, phenyl or fluorenyl.

According to one embodiment, the HOMO of the organic hole transport compound is further away from vacuum level than the HOMO level of N2,N2,N2',N2',N7,N7,N7',N7'-octakis(4-methoxyphenyl)-9,9'-spirobi[fluorene]-2,2',7,7'-tetraamine when determined under the same conditions.

In one embodiment, the HOMO level of the organic hole transport compound , when calculated using TURBOMOLE V6.5 (TURBOMOLE GmbH, Litzenhardtstrasse 19, 76135 Karlsruhe, Germany) by applying the hybrid functional B3LYP with a 6-31G^{∗} basis set in the gas phase, may be more negative than -4.27 eV, preferably more negative than -4.3 eV, alternatively more negative than -4.5 eV, alternatively more negative than -4.6 eV, alternatively more negative than -4.65 eV.

In one embodiment, the HOMO level of the organic hole transport compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) and more positive than the HOMO level of N-([1,1'-biphenyl]-4-yl)-N-(2-(9,9-diphenyl-9H-fluoren-4-yl)phenyl)-9,9-dimethyl-9H-fluoren-2-amine when determined under the same conditions.

In one embodiment of the present invention, the organic hole transport compound may be free of alkoxy groups.

According to one embodiment of the organic electronic device, the following equation is fulfilled:
-0.8 eV ≥ [ HOMO of organic emitter host compound - HOMO of organic hole transport compound ] ≤ 0 eV; and
the HOMO of the organic hole transport compound is further away from vacuum level than the HOMO level of N2,N2,N2',N2',N7,N7,N7',N7'-octakis(4-methoxyphenyl)-9,9'-spirobi[fluorene]-2,2',7,7'-tetraamine.

Thereby, particularly efficient hole transport into the first emission layer may be achieved.

According to an embodiment of the electronic device, wherein the organic hole transport compound of formula (IVa) or formula (IVb) are selected from F1 to F20:

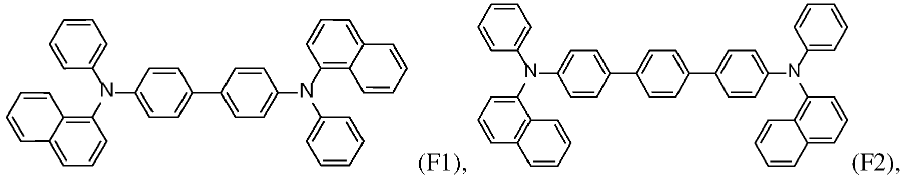

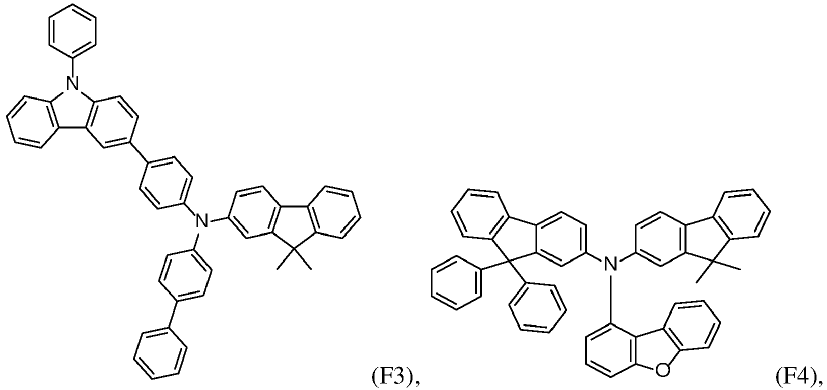

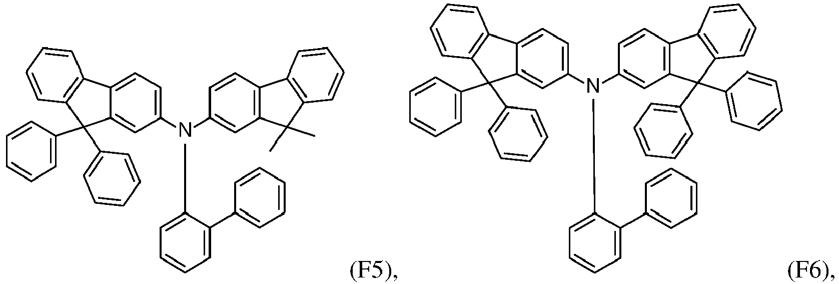

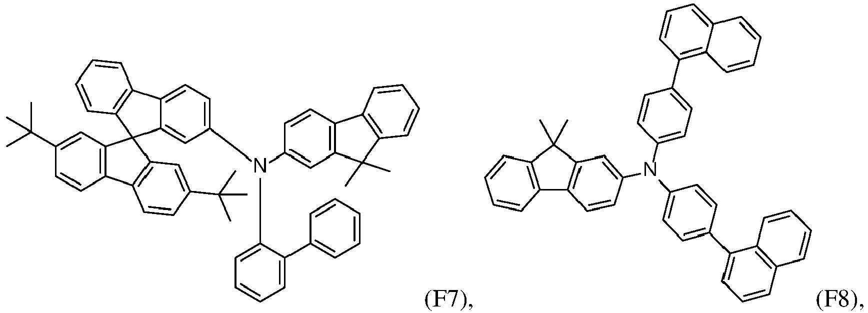

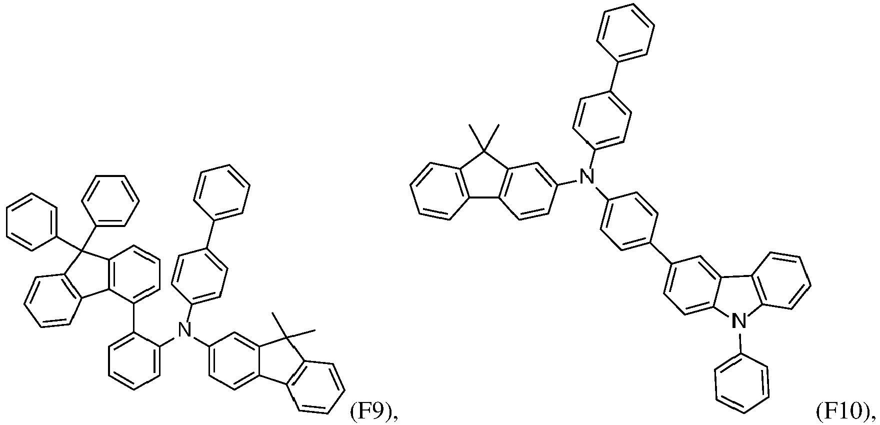

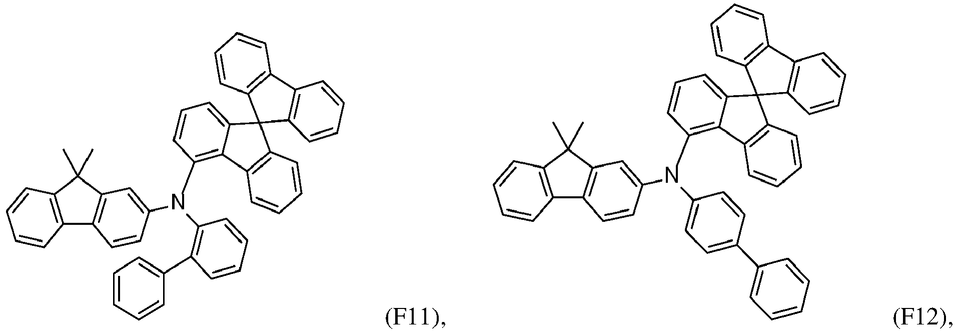

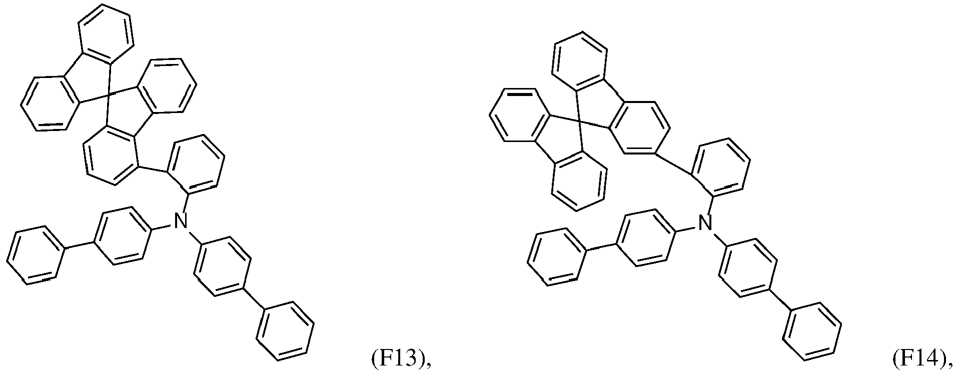

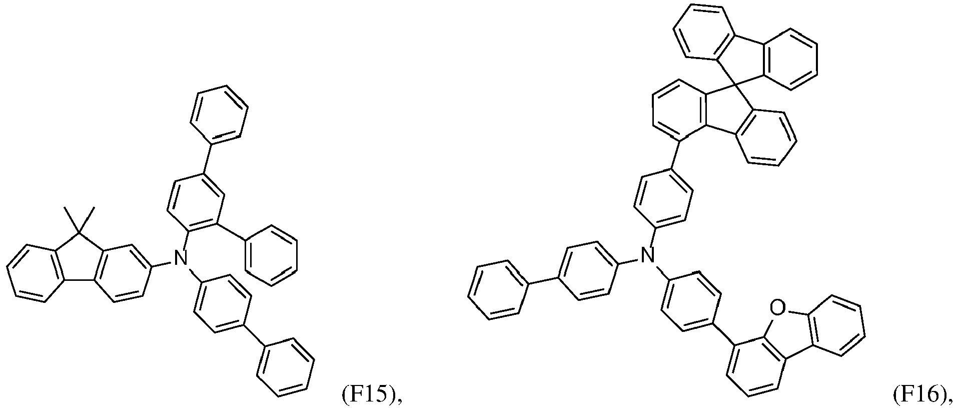

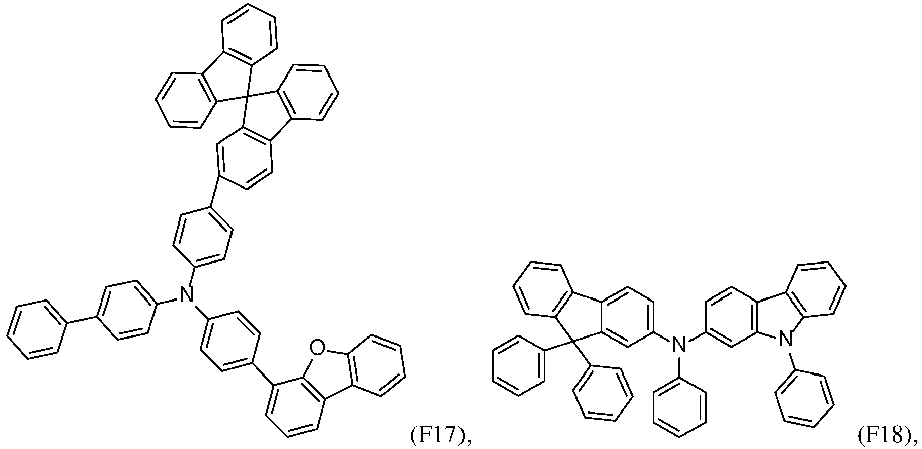

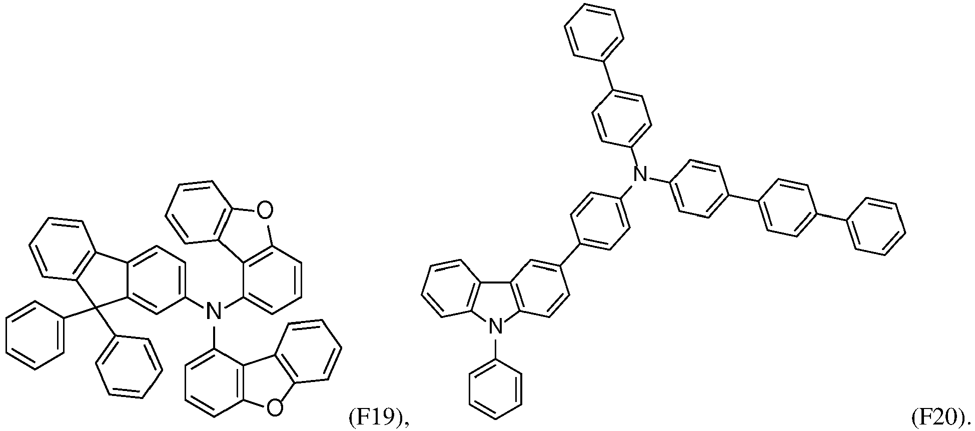

According to an embodiment of the electronic device, wherein the organic hole transport compound of formula (IVa) or formula (IVb) are selected preferably from compounds F3, F4, or F18.

The hole transport compound of the hole transport layer, preferably the first hole transport layer, may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

### Hole injection layer

The hole injection layer (HIL) may be formed on the anode layer, for example by vacuum deposition, spin coating, printing, casting, slot-die coating, Langmuir-Blodgett (LB) deposition, or the like. When the HIL is formed using vacuum deposition, the deposition conditions may vary according to the hole transport compound that is used to form the HIL, and the desired structure and thermal properties of the HIL. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the hole transport compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of a compound of formula (I), which is preferably a metal complex of formula (I).

The thickness of the HIL may be in the range from about 1 nm to about 15 nm, and for example, from about 2 nm to about 15 nm, alternatively about 2 nm to about 12 nm.

When the thickness of the HIL is within this range, the HIL may have excellent hole injecting characteristics, without a substantial penalty in driving voltage.

According to one embodiment of the present invention, the hole injection layer may comprise:
- at least about ≥ 0.5 wt.-% to about ≤ 30 wt.-%, preferably about ≥ 0.5 wt.-% to about ≤ 20 wt.-%, and more preferred about ≥ 1 wt.-% to about ≤ 20 wt.-% of a compound of formula (I), and
- at least about ≥ 70 wt.-% to about ≤ 99.5 wt.-%, preferably about ≥ 80 wt.-% to about ≤ 99.5 wt.-%, and more preferred about ≥ 80 wt.-% to about ≤ 99 wt.-% of a matrix compound.

According to one embodiment, the wt.-% of the compound of formula (I) may be lower than the wt.-% of the matrix compound; wherein the weight-% of the components are based on the total weight of the hole injection layer.

Preferably, the hole injection layer is free of ionic liquids, metal phthalocyanine, CuPc, HAT-CN, Pyrazino[2,3-f][1,10]phenanthroline-2,3-dicarbonitrile, F₄TCNQ, metal fluoride and/or metal oxides, wherein the metal in the metal oxide is selected from Re, W and/or Mo. Thereby, the hole injection layer can be deposited under conditions suitable for mass production.

According to an embodiment of the organic electroluminescent device, wherein the hole injection layer is non-emissive.

It is to be understood that the hole injection layer is not part of the anode layer.

### Hole transport layer (HTL)

The first hole transport layer is arranged between the hole injection layer and the first emission layer.

The first hole transport layer comprises an organic hole transport compound also called herein "matrix compound". The organic hole transport compound also called herein "matrix compound" is preferably a covalent matrix compound. According to one embodiment the covalent matrix compound of the hole transport layer may be selected from at least one organic compound.

The first organic hole transport compound is selected from at least one arylamine compound, diarylamine compound, triarylamine compound, a compound of formula (IVa) or a compound of formula (IVb), preferably of a compound of formula (IVa) or a compound of formula (IVb).

According to one embodiment the organic electroluminescent device comprises in addition to the first hole transport layer additional hole transport layers, maybe a second or a second and a third hole transport layer.

The additional hole transport layer may comprises an organic hole transport compound also called herein "matrix compound". The organic hole transport compound also called herein "matrix compound" is preferably a covalent matrix compound. According to one embodiment the covalent matrix compound of the additional hole transport layer may be selected from at least one organic compound.

The organic hole transport compound for the additional hole transport layer is selected from at least one arylamine compound, diarylamine compound, triarylamine compound, a compound of formula (IVa) or a compound of formula (IVb), preferably of a compound of formula (IVa) or a compound of formula (IVb).

According to one embodiment the organic hole transport compound in the hole injection layer and the first hole transport layer may be selected the same.

According to one embodiment the organic hole transport compound in all hole injection layers and the first hole transport layer and all additional hole transport layers are selected the same.

According to one embodiment of the organic electroluminescent device, the first hole transport layer or the first hole transport layer and at least one additional hole transport layer comprises a matrix compound, wherein the matrix compound of the first hole transport layer or the first hole transport layer and at least one additional hole transport layer may be selected from organic compounds consisting substantially from covalently bound C, H, O, N, S, which optionally comprise in addition covalently bound B, P, As and/or Se.

According to one embodiment, the organic hole transport compound of the first hole transport layer or the first hole transport layer and at least one additional hole transport layer may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the organic hole transport compound of the hole injection layer and the organic hole transport compound of the first hole transport layer, or the first hole transport layer and at least one additional hole transport layer are selected the same.

According to one embodiment of the organic electroluminescent device, wherein the first hole transport layer or the first hole transport layer and at least one additional hole transport layer of the organic electroluminescent device comprises an organic hole transport compound according to formula (IV), preferably the organic hole transport compound in the hole injection layer and first hole transport layer or the first hole transport layer and at least one additional hole transport layer are selected the same.

The first hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the hole transport compound that is used to form the HTL.

The thickness of the first HTL and/or additional HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 200 nm, further about 100 nm to about 180 nm, further about 110 nm to about 140 nm.

When the thickness of the first HTL and/or additional HTL is within this range, the HTL may have excellent hole transporting characteristics, without a substantial penalty in driving voltage.

### Emission layer (EML)

The at least one first emission layer (EML), also referred to as first emission layer, may be formed on the HTL or EBL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to the present invention it is preferred that the organic electroluminescent device comprises one emission layer that is named "first emission layer". However the organic electroluminescent device optionally comprises two emission layers, wherein the first layer is named first emission layer and second layer is named second emission layer.

It may be provided that the at least one emission layer also referred to as first emission layer is free of the matrix compound of the hole injection layer.

It may be provided that the at least one emission layer does not comprise the compound of Formula (IV).

The amount of the compound of formula (III) may be in the range from about 1 to about 50 parts by weight, based on 100 parts by weight of the organic emitter host compound.

The EML may have a thickness of about 10 nm to about 100 nm, for example, from about 20 nm to about 60 nm. When the thickness of the EML is within this range, the EML may have excellent light emission, without a substantial penalty in driving voltage.

### Further layers

In accordance with the invention, the organic electroluminescent device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a transistor backplane. Preferably, the substrate is a silicon substrate or transistor backplane.

### Anode layer

The anode layer, also named anode electrode, may be formed by depositing or sputtering a material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sublayer comprising or consisting of a transparent conductive oxide having a thickness of 3 to 20 nm.

It is to be understood that the third anode layer is not part of the substrate.
According to one embodiment of the present invention, the hole injection layer comprising or consisting of compound of formula (I) is in direct contact with the anode layer.

### Electron blocking layer (EBL)

According to one embodiment of the organic electroluminescent device, wherein the organic electroluminescent device may comprises an electron blocking layer (EBL). The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer may be selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

The thickness of the electron blocking layer may be selected between 2 and 20 nm.

### Hole blocking layer (HBL)

According to one embodiment of the organic electroluminescent device, wherein the organic electroluminescent device may comprises a hole blocking layer (HBL). A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent emitter dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

According to one embodiment of the organic electroluminescent device, wherein the organic electroluminescent device may further comprises an electron transport layer (ETL).

According to another embodiment of the present invention, the electron transport layer may further comprise an azine compound, preferably a triazine compound.

According to one embodiment, the electron transport layer may comprise a composition comprising at least one azine compound and at least one compound comprising a polar group, wherein the polar group may be selected from nitrile or phospine oxide, preferably dialkyl phosphine oxide.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electroluminescent device may further comprise a hole blocking layer and an electron transport layer, wherein the hole blocking layer and the electron transport layer comprise an azine compound. Preferably, the azine compound is a triazine compound.

### Electron injection layer (EIL)

According to one embodiment of the organic electroluminescent device, wherein the organic electroluminescent device may comprises an electron injection layer (EIL). An optional EIL, which may facilitates injection of electrons from the cathode layer, may be formed on the ETL, preferably directly on the electron transport layer. Preferably, the electron injection layer is in direct contact with the cathode layer.

Examples of compounds for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the compound that is used to form the EIL.

According to one embodiment of the organic electroluminescent device, the electron injection layer may comprise a first electron injection sub-layer (EIL1) and a second electron injection sub-layer (EIL2), wherein the EIL1 is arranged closer to the first emission layer and the EIL2 is arranged closer to the cathode layer.

According to one embodiment of the organic electroluminescent device, the EIL1 may comprise LiQ or LiF and the EIL2 may comprise Ca, Ba, Yb, Mg, preferably Yb.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

It is to be understood that the electron injection layer is not part of the cathode layer.

### Cathode layer

The cathode layer is may be arranged on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

According to one embodiment of the organic electroluminescent device, the cathode layer comprises ≥ 50 vol.-% and ≤ 100 vol.-% Ag, preferably ≥ 80 vol.-% Ag and ≤ 100 vol.-% Ag, more preferred ≥ 85 vol.-% Ag and ≤ 100 vol.-% Ag.

According to one embodiment of the organic electroluminescent device, the cathode layer comprises ≥ 50 vol.-% Ag and ≤ 50 vol.-% Mg, more preferred ≥ 80 vol.-% Ag and ≤ 20 vol.-% Mg, even more preferred ≥ 85 vol.-% Ag and ≤ 25 vol.-% Mg.

When the cathode layer is selected in this range, the cathode layer may be transparent to the visible light emission spectrum.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

According to one embodiment of the organic electroluminescent device, wherein light is emitted through the cathode layer.

### Organic electroluminescent device

According to one aspect of the present invention, there is provided an organic electroluminescent device comprising: a substrate; an anode layer formed on the substrate; a hole injection layer, a first hole transport layer, a first emission layer, an electron transport layer and a cathode layer.

According to another aspect of the present invention, there is provided an organic electroluminescent device comprising: a substrate; an anode layer formed on the substrate; a hole injection layer, a first hole transport layer, an electron blocking layer, a first emission layer, a hole blocking layer, an electron transport layer and a cathode layer.

According to another aspect of the present invention, there is provided an organic electroluminescent device comprising: a substrate; an anode layer formed on the substrate; a hole injection layer, a first hole transport layer, an electron blocking layer, a first emission layer, a hole blocking layer, an electron transport layer, an electron injection layer, and a cathode layer.

According to various embodiments of the present invention, there may be provided further layers arranged between the above mentioned layers, on the substrate or on the top electrode.

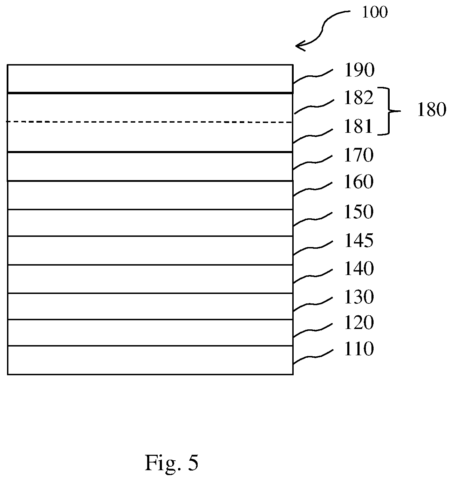

For example, the organic electroluminescent device (100) according to Fig. 5 may be formed by a process, wherein on a substrate (110), an anode layer 120, a hole injection layer (HIL) 130, a first hole transport layer (HTL) 140, an electron blocking layer (EBL) 145, a first emission layer (EML) 150, a hole blocking layer (HBL) 160, an electron transport layer (ETL) 170, an electron injection layer (EIL) 180, wherein the EIL comprises a first EIL sub-layer (EIL1) 181 and a second EIL sub-layer (EIL2) 182, and a cathode layer 190 are subsequently formed in that order.

According to one embodiment of the present invention, wherein the organic electroluminescent device may comprise the hole injection layer comprising the compound of formula (I) and the first hole transport compound and/or a compound of formulae (IVa) or (IVb), wherein in formula (I) M is a metal ion, wherein the metal is selected from Na, Ag, Zn, Cu, Fe, Bi, Ce, wherein if M is Cu, n is 2, and if M is Ce, n is 4.

According to one embodiment of the present invention, wherein the organic electroluminescent device may comprise the hole injection layer consisting of the compound of formula (I), wherein in formula (I) M is a metal ion, wherein the metal is selected from Na, Ag, Zn, Cu, Fe, Bi, Ce, wherein if M is Cu, n is 2, and if M is Ce, n is 4.

### Electronic device / display device

According to another embodiment, wherein the organic electroluminescent device can be a light emitting device or a display device.

According to another embodiment, wherein an electronic device comprises the organic electroluminescent device according to the invention.

According to another embodiment, wherein a display device comprises the organic electroluminescent device according to the invention.

According to another embodiment, wherein a display device comprises an electronic device that comprises the organic electroluminescent device according to the invention.

### Method of manufacturing

According to another aspect of the present invention, there is provided a method of manufacturing an organic electroluminescent device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing may be selected from spin-coating, printing, casting; and/or
- slot-die coating.

According to various embodiments of the present invention, there is provided a method using:
- a first deposition source to release the organic hole transport compound;
- a second deposition source to release the compound of formula (I);
- a third deposition source to release the compound of formula (III);
- a fourth deposition source to release the organic emitter host and/or compound of formula (V).
The method comprising the steps of forming the hole injection layer; whereby for an organic electroluminescent device:
- the hole injection layer is formed by releasing the organic hole transport compound from the first deposition source and the compound of formula (I) from the second deposition source.

According to various embodiments of the present invention, the method may further include forming the layers in the following order on the hole injection layer, at least one layer selected from the group consisting of forming a hole transport layer, forming a hole blocking layer, forming a first emission layer, forming a hole blocking layer, forming an electron transporting layer and/or forming an electron injection layer and/ or forming a cathode layer.

According to various embodiments of the present invention, the method may further include the steps for forming an organic electroluminescent device, wherein
- on a substrate an anode layer is formed,
- on the anode layer a injection layer is formed, which comprises an organic hole transport compound and a compound of formula (I),
- on the hole injection layer a first hole transport layer is formed,
- on the first hole transport layer a first emission layer is formed,
- on the first emission layer an electron transport layer is formed, optionally a hole blocking layer and/or an electron transport layer are formed on the first emission layer,
- and finally a cathode layer is formed,
- optional an electron blocking layer is formed in that order between the hole transport layer and the emission layer,
- optional an electron injection layer is formed between the electron transport layer and the cathode layer.

According to one embodiment, the organic electroluminescent device of the present invention is formed by deposition of the hole injection layer, the first hole transport layer and the first emission layer in vacuum.

According to another aspect, it is provided an electronic device comprising at least one organic light emitting device according to any embodiment described throughout this application, preferably, the electronic device comprises the organic light emitting diode in one of embodiments described throughout this application. More preferably, the organic electroluminescent device is a display device.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

### Figures 1 to 6

- FIG. 1: is a schematic sectional view of an organic electroluminescent device, according to an exemplary embodiment of the present invention;
- FIG. 2: is a schematic sectional view of an organic electroluminescent device, according to an exemplary embodiment of the present invention;
- FIG. 3: is a schematic sectional view of an organic electroluminescent device, according to an exemplary embodiment of the present invention;
- FIG. 4: is a schematic sectional view of an organic electroluminescent device, according to an exemplary embodiment of the present invention;
- FIG. 5: is a schematic sectional view of an organic electroluminescent device, according to an exemplary embodiment of the present invention;
- FIG. 6: is a schematic sectional view of an organic electroluminescent device, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

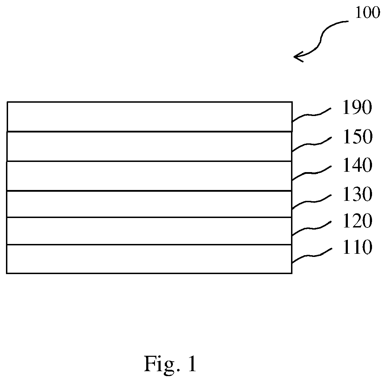

FIG. 1 is a schematic sectional view of an organic electroluminescent device 100, according to an exemplary embodiment of the present invention. The organic electroluminescent device 100 includes a substrate 110, an anode layer 120, a hole injection layer (HIL) 130, a first hole transport layer (HTL) 140, a first emission layer (EML) 150, and a cathode layer 190. The HIL 130 is disposed on the anode layer. Onto the HIL 130, the HTL 140, the EML 150, the cathode layer 190 are disposed.

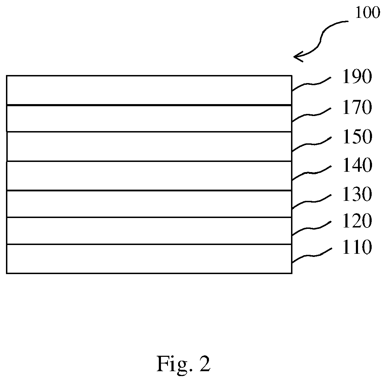

FIG. 2 is a schematic sectional view of an organic electroluminescent device 100, according to an exemplary embodiment of the present invention. The organic electroluminescent device 100 includes a substrate 110, an anode layer 120, a hole injection layer (HIL) 130, a first hole transport layer (HTL) 140, a first emission layer (EML) 150, an electron transport layer (ETL) 170, and a cathode layer 190. The HIL 130 is disposed on the anode layer. Onto the HIL 130, the HTL 140, the EML 150, the ETL 170 and the cathode layer 190 are disposed.

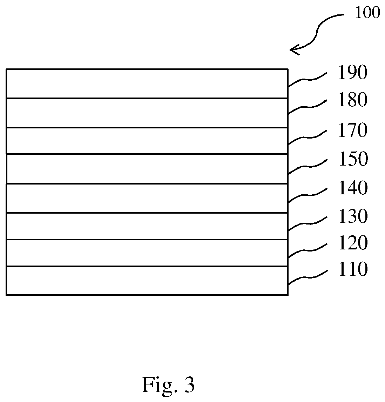

FIG. 3 is a schematic sectional view of an organic electroluminescent device 100, according to an exemplary embodiment of the present invention. The organic electroluminescent device 100 includes a substrate 110, an anode layer 120, a hole injection layer (HIL) 130, a first hole transport layer (HTL) 140, a first emission layer (EML) 150, an electron transport layer (ETL) 170, an electron injection layer (EIL) 180 and a cathode layer 190. The HIL 130 is disposed on the anode layer. Onto the HIL 130, the HTL 140, the EML 150, the ETL 170, the EIL 180 and the cathode layer 190 are disposed.

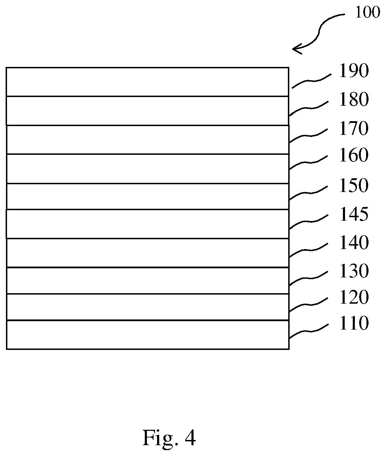

FIG. 4 is a schematic sectional view of an organic electroluminescent device 100, according to an exemplary embodiment of the present invention. The organic electroluminescent device 100 includes a substrate 110, an anode layer 120, a hole injection layer (HIL) 130, a first hole transport layer (HTL) 140, an electron blocking layer (EBL) 145, a first emission layer (EML) 150, a hole blocking layer (HBL) 160, an electron transport layer (ETL) 170, an electron injection layer (EIL) 180 and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

FIG. 5 is a schematic sectional view of an organic electroluminescent device 100, according to an exemplary embodiment of the present invention. The organic electroluminescent device 100 includes a substrate 110, an anode layer 120, a hole injection layer (HIL) 130, a first hole transport layer (HTL) 140, an electron blocking layer (EBL) 145, a first emission layer (EML) 150, a hole blocking layer (HBL) 160, an electron transport layer (ETL) 170, an electron injection layer (EIL) 180, wherein the EIL comprises a first EIL sub-layer (EIL1) 181 and a second EIL sub-layer (EIL2) 182, and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

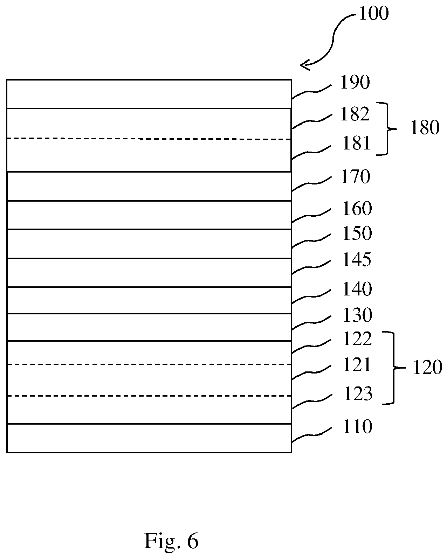

FIG. 6 is a schematic sectional view of an organic electroluminescent device 100, according to an exemplary embodiment of the present invention. The organic electroluminescent device 100 includes a substrate 110, an anode layer 120, wherein the anode layer 120 comprises a first anode sub-layer 121, a second anode sub-layer 122 and a third anode sub-layer 123, a hole injection layer (HIL) 130, a first hole transport layer (HTL) 140, an electron blocking layer (EBL) 145, a first emission layer (EML) 150, a hole blocking layer (HBL) 160, an electron transport layer (ETL) 170, an electron injection layer (EIL) 180, wherein the EIL comprises a first EIL sub-layer (EIL1) 181 and a second EIL sub-layer (EIL2) 182, and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

While not shown in Fig. 1 to Fig. 6, a capping and/or sealing layer may further be formed on the cathode layer 190, in order to seal the organic electroluminescent device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### Detailed description

The invention is furthermore illustrated by the following examples which are illustrative only and non-binding.

### Experimental data

Compounds of formula (I), (II), (IIa) to (IId), (AL-I), (III), (IV), (IVa), (IVb) and (V) may be prepared by methods known in the art.

### HOMO of compounds of formula (III) and (IV)

The HOMO of compounds of formula (III) and (IV) are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G^{∗} basis set in the gas phase. If more than one conformation is viable, the conformation with the lowest total energy is selected.

Under these conditions, the HOMO of N2,N2,N2',N2',N7,N7,N7',N7'-octakis(4-methoxyphenyl)-9,9'-spirobi[fluorene]-2,2',7,7'-tetraamine is -4.27 eV.

### HOMO and LUMO of the organic emitter host of formula (V)

The HOMO and LUMO of the organic emitter host of formula (V) are calculated with the program package ORCA Version 5.0.3-f.1 (Department of theory and spectroscopy, Max Planck Institute für Kohlenforschung Kaiser Wilhelm Platz 1, 45470 Muelheim/Ruhr, Germany). The optimized geometries and the HOMO energy levels of the molecular structures are determined by applying the hybrid functional B3LYP with a 6-31G^{∗} basis set in the gas phase, specifying the deuterium atoms by defining their mass equal to 2.00141amu. If more than one conformation is viable, the conformation with the lowest total energy is selected.

### General procedure for fabrication of OLEDs

For all inventive and comparative examples (see Tables 5 and 6), a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, a hole injection layer was formed on the anode layer in vacuum. In examples 1-1 to 1-12 and comparative examples 1-1 to 1-8, see Table 5, compound of formula (I) is deposited on the anode layer. The thickness of the hole injection layer can be seen in Table 5. In examples 2-1 to 2-6 and comparative examples 2-1 to 2-5, see Table 6, compound of formula (I) and compound of formula (V) are co-deposited on the anode layer to form a hole injection layer having a thickness of 10 nm. The composition of the hole injection layer can be seen in Table 6.

Then, compound of formula (V) was vacuum deposited on the HIL, to form a first hole transport layer (HTL). The composition and thickness of the HTL can be seen in Tables 5 and 6.

Then N,N-di([1,1'-biphenyl]-4-yl)-3'-(9H-carbazol-9-yl)-[1,1'-biphenyl]-4-amine (CAS 1464822-27-2) was vacuum deposited on the HTL, to form an electron blocking layer (EBL) having a thickness of 5 nm.

Then 99 vol.-% 9-(4-(naphthalen-1-yl)phenyl)-10-(phenyl-d5)anthracene (CAS 1185865-32-0) as EML host and 1 vol.-% 2,12-di-tert-butyl-5,9-bis(4-(tert-butyl)phenyl)-7-methyl-5,9-dihydro-5,9-diaza-13b-boranaphtho[3,2,1-de]anthracene (CAS 1805802-42-9) as blue EML dopant were deposited on the EBL, to form a first emission layer with a thickness of 20 nm.

Then a hole blocking layer was formed with a thickness of 5 nm by depositing 2,4-diphenyl-6-(4',5',6'-triphenyl-[1,1':2',1":3",1‴:3‴,1ʺʺ-quinquephenyl]-3ʺʺ-yl)-1,3,5-triazine (CAS 2032364-64-8) on the first emission layer.

Then, the electron transport layer having a thickness of 31 nm is formed on the hole blocking layer. The electron transport layer may comprise a composition Comp-1 comprising 30 wt.-% (3-(4-(4-(4,6-diphenyl-1,3,5-triazin-2-yl)phenyl)naphthalen-1-yl)phenyl)dimethylphosphine oxide (ETM1) and 70 wt.-% 2-([1,1'-biphenyl]-3-yl)-4-phenyl-6-(3-(10-phenylanthracen-9-yl)phenyl)-1,3,5-triazine (ETM2).

Then the electron injection layer EIL is deposited on the electron transport layer. The EIL comprises a first EIL sub-layer formed of 1 nm LiQ, and a second EIL sub-layer formed of 2 nm Yb.

Then the cathode layer having a thickness of 13 nm is formed on the electron injection layer by depositing Ag:Mg (90:10 vol.-%) at a rate of 0.01 to 1 Å/s at 10⁻⁷ mbar.

Then, N-([1,1'-biphenyl]-4-yl)-9,9-dimethyl-N-(4-(9-phenyl-9H-carbazol-3-yl)phenyl)-9H-fluoren-2-amine was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

In bottom emission devices, the emission is predominately Lambertian and quantified in percent external quantum efficiency (EQE). The light is emitted through the anode layer. To determine the efficiency EQE in % the light output of the device is measured using a calibrated photodiode at 10 mA/cm².

In top emission devices, the emission is forward directed through the cathode layer, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm².

The color space is described by coordinates CIE-x and CIE-y (International Commission on Illumination 1931).

Lifetime LT of the device is measured at ambient conditions (20°C) and 30 mA/cm², using a Keithley 2400 source meter, and recorded in hours.

The brightness of the device is measured using a calibrated photo diode. The lifetime LT is defined as the time till the brightness of the device is reduced to 97 % of its initial value.

To determine the voltage stability over time U(100h)-(1h), a current density of at 30 mA/cm² was applied to the device. The operating voltage was measured after 1 hour and after 100 hours, followed by calculation of the voltage stability for the time period of 1 hour to 100 hours. A low value for U(100h)-(1h) denotes a low increase in operating voltage over time and thereby improved voltage stability.

### Technical Effect of the invention

In Table 1 are shown the chemical formulas of a range of compounds of formula (I).

**Table 1: Compound of formula (I) and comparative compounds**

| Referred to as: | Chemical formula |
|---|---|
| Comparative compound 1 CC-1 | 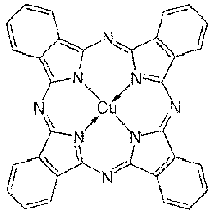 |
| Comparative compound 2 CC-2 | 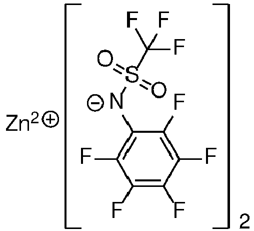 |
| Comparative compound 3 CC-3 | 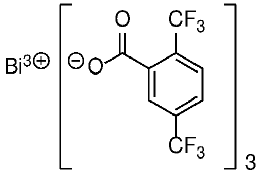 |
| Comparative compound 4 CC-4 | 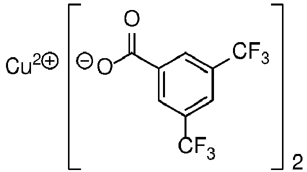 |
| Metal complex 1 MC-1 | 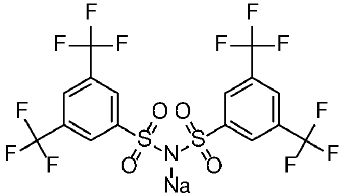 |
| Metal complex 2 MC-2 | 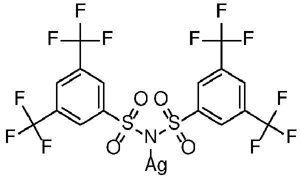 |
| Metal complex 3 MC-3 | 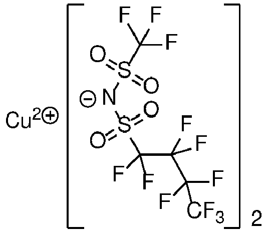 |
| Metal complex 4 MC-4 | 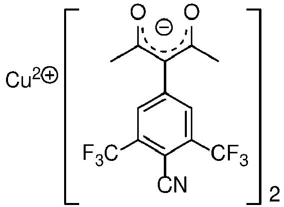 |
| Metal complex 5 MC-5 | 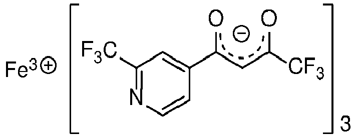 |
| Metal complex 6 MC-6 | 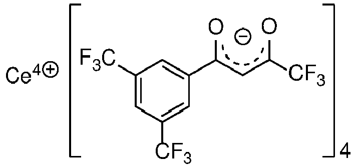 |

In Table 2 are shown the chemical formulas and HOMO values of a range of compounds of formula (IV).

**Table 2: Compounds of formula (IV)**

| Referred to as: | Chemical formula | HOMO (eV) |
|---|---|---|
| F3 | 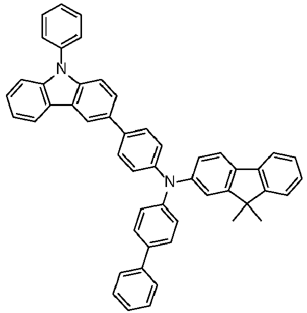 | -4.69 |
| F18 | 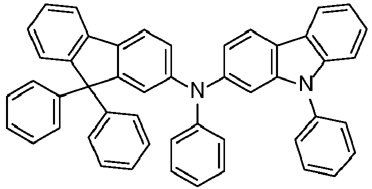 | -4.73 |
| F4 | 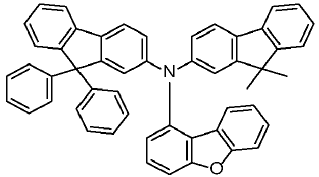 | -4.85 |
| F2 | 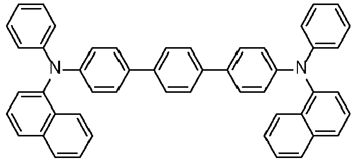 | -4.81 |

In Table 3 are shown the chemical formulas and HOMO values of a range of compounds of formula (V).

**Table 3: Organic emitter host compound of formula (V)**

| Referred to as: | Chemical formula | HOMO (eV) |
|---|---|---|
| BH1 | 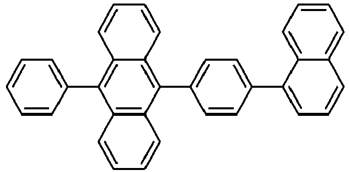 | -5.11 |
| BH2 | 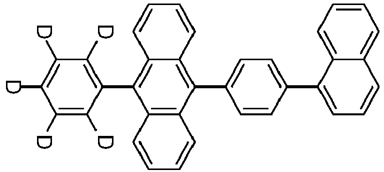 | -5.11 |
| BH4 | 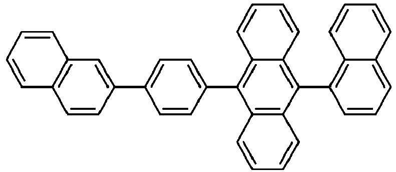 | -5.13 |
| BH6 | 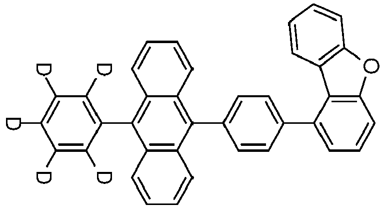 | -5.14 |
| BH8 | 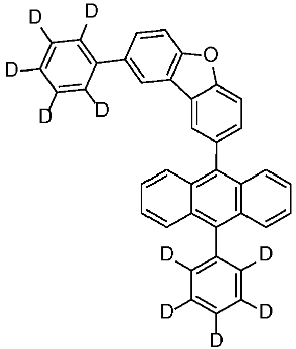 | -5.12 |
| BH10 | 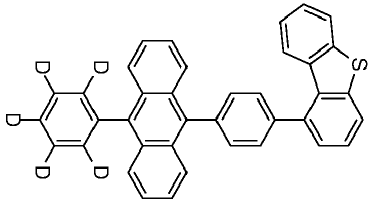 | -5.15 |
| BH13 | 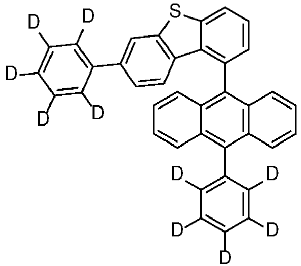 | -5.18 |

When the HOMO of BH1 and BH4 are calculated with the same method as for compounds of formula (IV), namely by applying hybrid functional B3LYP with a 6-31G^{∗} basis set in the gas phase using program package TURBOMOLE V6.5, as described above, essentially the same values are obtained as shown in Table 3 above.

In Table 4 are shown values for [HOMO (compound of formula (V)) - HOMO (compound of formula (IV)] for a range of compounds of formula (II) and compounds of formula (IV).

**Table 4: HOMO (compound of formula (V)) - HOMO (compound of formula (IV))**

| | F3 | F18 | F4 | F2 |
|---|---|---|---|---|
| BH1 | -0.42 | -0.38 | -0.26 | -0.3 |
| BH2 | -0.42 | -0.38 | -0.26 | -0.3 |
| BH4 | -0.44 | -0.4 | -0.28 | -0.32 |
| BH6 | -0.45 | -0.41 | -0.29 | -0.33 |
| BH8 | -0.43 | -0.39 | -0.27 | -0.31 |
| BH10 | -0.46 | -0.42 | -0.3 | -0.34 |
| BH13 | -0.49 | -0.45 | -0.33 | -0.37 |

In Table 5 are shown performance data of organic electroluminescent devices wherein in the hole injection layer consists of compound of formula (IV).

In comparative example 1-1, the hole injection layer consists of CuPc. CuPc is free of formula (II), see Table 1. The HOMO (compound of formula (V)) - HOMO (compound of formula (IV)) is -0.41 eV. The operating voltage is 8.42 V, the EQE efficiency is 10.6 %, the Ceff is 5 cd/A, the lifetime is 1 hour and the voltage stability over time U(100h)-(1h) is 2.259 V.

In comparative example 1-2, the thickness of the hole injection layer is increased to 2 nm. The operating voltage is > 10 V. Therefore, the other performance characteristics were not determined.

In comparative example 1-3, the hole injection layer consists of CC-2. CC-2 is free of formula (II). The operating voltage is improved to 4.15 V. The efficiency is improved to 17.99 % EQE and 8.8 cd/A. The lifetime is improved to 18 hours. The voltage stability over time U(100h)-(1h) is improved to 0.239 V.

In comparative example 1-4, the thickness of the hole injection layer is increased to 2 nm. The operating voltage is unchanged, the efficiency is increased to 18.10 % EQE and 8.9 cd/A. The lifetime is 9 hours and the voltage stability is 0.313 V.

In comparative example 1-5, the hole injection layer consists of CC-3. CC-3 is free of formula (II). The operating voltage is improved to 4.05 V. The efficiency is improved to 18.37 % EQE and 8.6 cd/A. The lifetime is improved to 13 hours. The voltage stability over time U(100h)-(1h) is improved to 0.251 V. In comparative example 1-6, the thickness of the hole injection layer is increased to 2 nm. The performance is essentially the same.

In examples 1-1 to 1-10, the hole injection layer comprises a range of compounds of formula (I). As can be seen in Table, 3, operating voltage, EQE, Ceff, lifetime and/or voltage stability over time U(100h)-(1h) are improved over comparative examples 1-1 to 1-6.

In comparative example 1-7, the hole injection layer consists of CC-2. CC-2 is free of formula (II). The HOMO (compound of formula (V)) - HOMO (compound of formula (IV)) is -0.25 eV. The operating voltage is 4.12 V, the EQE efficiency is 18.47 %, the Ceff is 8.9 cd/A, the lifetime is 2 hours and the voltage stability over time U(100h)-(1h) is 1.276 V. In comparative example 1-8, the thickness of the hole injection layer is increased to 2 nm. The operating voltage and efficiency are essential unchanged. The lifetime is reduced to 1 hour. The voltage stability over time is improved to 0.722 V.

In examples 1-11 and 1-12, the hole injection layer comprises MC-1. As can be seen in Table 5, the operating voltage is improved to 3.86 V. The EQE is 17.87 and 18.09 %, respectively. The cd/A efficiency is improved to 9.1 and 9.2 cd/A, respectively. The lifetime is improved to 5 and 7 hours, respectively. The voltage stability over time U(100h)-(1h) is improved to 0.133 and 0.135 V, respectively.

In Table 6 are shown performance data for an organic electroluminescent device, wherein the hole injection layer comprises a compound of formula (I) and a compound of formula (IV). The hole injection layer and the first hole transport layer comprise the same compound of formula (IV).

In comparative example 2-1, the hole injection layer comprises CC-2. CC-2 is free of formula (II). The HOMO (compound of formula (V)) - HOMO (compound of formula (IV)) is -0.41 eV. The operating voltage is 4.07 V, the EQE is 18.16 %, the Ceff is 8.9 cd/A, the lifetime is 39 hours and the voltage stability over time U(100h)-(1h) is 0.251 V.

In comparative example 2-2, the hole injection layer comprises CC-4. CC-4 is free of formula (II). The operating voltage is 4.27 V, the EQE is 17.37 %, the Ceff is 8.2 cd/A, the lifetime is 13 hours and the voltage stability over time U(100h)-(1h) is 1.441 V.

In comparative example 2-3, the hole injection layer comprises CC-3. CC-3 is free of formula (II). The operating voltage is 4.22 V, the EQE is 17.93 %, the Ceff is 8.4 cd/A, the lifetime is 17 hours and the voltage stability over time U(100h)-(1h) is 1.077 V.

In example 2-1, the hole injection layer comprises MC-2. The operating voltage is improved to 4.02 V. The efficiency is improved to 18.57 % EQE and 8.6 cd/A. The lifetime is high at 38 hours and the voltage stability over time U(100h)-(1h) is improved to 0.116 V.

In examples 2-2 to 2.4, the hole injection layer comprises a range of compounds of formula (I). As can be seen in Table 5, operating voltage, EQE, Ceff, lifetime and/or voltage stability over time U(100h)-(1h) are improved over comparative examples 2-1 to 2-3.

In comparative example 2-4, the hole injection layer comprises CC-2 and compound of formula (IV) F4. CC-2 is free of formula (II). As the HOMO of the compound of formula (IV) is further away from vacuum level, the concentration of CC-2 in the hole injection layer has been increased to 3 mol.-%. The HOMO (compound of formula (V)) - HOMO (compound of formula (IV)) is -0.25 eV. The operating voltage is 4.01 V, the efficiency is 18.51 % EQE and 8.9 cd/A. The lifetime is 13 hours and the voltage stability over time U(100h)-(1h) is 0.764 V.

In example 2-5, the hole injection layer comprises MC-3. The operating voltage is improved to 3.86 V, the efficiency is 17.94 % EQE and 9 cd/A. The lifetime is 27 hours and the voltage stability over time U(100h)-(1h) is improved to 0.133 V.

In comparative example 2-5, the hole injection layer comprises CC-2 and compound of formula (IV) F2. CC-2 is free of formula (II). The HOMO (compound of formula (V)) - HOMO (compound of formula (IV)) is -0.29 eV. The operating voltage is 3.90 V, the efficiency is 15.71 % EQE and 8.0 cd/A. The lifetime is 55 hours and the voltage stability over time U(100h)-(1h) is 0.212 V.

In example 2-6, the hole injection layer comprises MC-3. The operating voltage is improved to 3.79 V, the efficiency is 15.68 % EQE and 7.9 cd/A. The lifetime is 55 hours and the voltage stability over time U(100h)-(1h) is improved to 0.170 V.

In summary, an improvement in operating voltage, EQE, cd/A efficiency, lifetime and/or voltage stability over time U(100h)-(1h) has been obtained.

An improvement in operating voltage, EQE and cd/A efficiency may result in lower power consumption of organic electroluminescent devices, in particular mobile devices.

An improvement in lifetime and/or voltage stability over time may lead to improved stability over time of organic electroluminescent devices.

**Table 5: Performance of an organic electroluminescent device wherein the hole injection layer consists of a compound of formula (I)**

| | Compound of formula (I) or comparative compound in the HIL | Thickness HIL [nm] | Compound of formula (IV) in the first HTL | HOMO (compound of formula (V)) - HOMO (compound of formula (IV)) [eV] | Thickness first HTL [nm] | Voltage [V] | EQE [%] | CEff [cd/A] | LT at 30 mA/cm² [h] | U(100h)-(lh) at 30mA/cm² [V] |
|---|---|---|---|---|---|---|---|---|---|---|
| Comparative example 1-1 | CuPc | 1 | F3 | -0.41 | 131 | 8.42 | 10.60 | 5.0 | 1 | 2.259 |
| Comparative example 1-2 | CuPc | 2 | F3 | -0.41 | 131 | >10 | n.d.¹ | n.d. | n.d. | n.d. |
| Comparative example 1-3 | CC-2 | 1 | F3 | -0.41 | 131 | 4.15 | 17.99 | 8.8 | 18 | 0.239 |
| Comparative example 1-4 | CC-2 | 2 | F3 | -0.41 | 131 | 4.15 | 18.10 | 8.9 | 9 | 0.313 |
| Comparative example 1-5 | CC-3 | 1 | F3 | -0.41 | 131 | 4.05 | 18.37 | 8.6 | 13 | 0.251 |
| Comparative example 1-6 | CC-3 | 2 | F3 | -0.41 | 131 | 4.02 | 18.49 | 8.8 | 10 | 0.215 |
| Example 1-1 | MC-1 | 1 | F3 | -0.41 | 131 | 4.06 | 18.40 | 8.8 | 9 | 0.096 |
| Example 1-2 | MC-1 | 2 | F3 | -0.41 | 131 | 4.02 | 18.66 | 8.8 | 12 | 0.100 |
| Example 1-3 | MC-2 | 1 | F3 | -0.41 | 131 | 4.03 | 18.67 | 8.7 | 19 | 0.089 |
| Example 1-4 | MC-2 | 2 | F3 | -0.41 | 131 | 4.00 | 18.86 | 8.6 | 23 | 0.105 |
| Example 1-5 | MC-5 | 1 | F3 | -0.41 | 131 | 4.02 | 18.62 | 8.7 | 37 | 0.072 |
| Example 1-6 | MC-5 | 2 | F3 | -0.41 | 131 | 3.99 | 18.80 | 8.6 | 34 | 0.057 |
| Example 1-7 | MC-4 | 1 | F3 | -0.41 | 131 | 4.10 | 18.44 | 8.7 | 42 | 0.079 |
| Example 1-8 | MC-4 | 2 | F3 | -0.41 | 131 | 4.02 | 18.63 | 8.8 | 41 | 0.064 |
| Example 1-9 | MC-6 | 1 | F3 | -0.41 | 131 | 4.03 | 18.25 | 8.7 | 38 | 0.054 |
| Example 1-10 | MC-6 | 2 | F3 | -0.41 | 131 | 3.97 | 18.30 | 8.7 | 38 | 0.059 |
| Comparative example 1-7 | CC-2 | 1 | F4 | -0.25 | 137 | 4.12 | 18.47 | 8.9 | 2 | 1.276 |
| Comparative example 1-8 | CC-2 | 2 | F4 | -0.25 | 137 | 4.13 | 18.43 | 8.9 | 1 | 0.722 |
| Example 1-11 | MC-1 | 1 | F4 | -0.25 | 137 | 3.86 | 17.87 | 9.1 | 5 | 0.133 |
| Example 1-12 | MC-1 | 2 | F4 | -0.25 | 137 | 3.86 | 18.09 | 9.2 | 7 | 0.135 |

| | | | | | | | | | | |
|---|---|---|---|---|---|---|---|---|---|---|
| ¹ : n.d. = not determined | | | | | | | | | | |

**Table 6: Performance of an organic electroluminescent device wherein the hole injection layer comprises a compound of formula (I) and a compound of formula (IV)**

| | Compound of formula (I) or comparative compound in the HIL | Compound of formula (IV) in the HIL | Concentration of compound of formula (I) or comparative compound in the HIL [mol.-%] | Compound of formula (IV) in the first HTL | Thickness first HTL [nm] | HOMO (compound of formula (V)) - HOMO (compound of formula (IV)) [eV] | Voltage [V] | EQE [%] | CEff [cd/A] | LT at 30 mA/cm² [h] | U(100h)-(1h) at 30mA/cm² [V] |
|---|---|---|---|---|---|---|---|---|---|---|---|
| Comparative example 2-1 | CC-2 | F3 | 1 | F3 | 123 | -0.41 | 4.07 | 18.16 | 8.9 | 39 | 0.251 |
| Comparative example 2-2 | CC-4 | F3 | 1 | F3 | 123 | -0.41 | 4.27 | 17.37 | 8.2 | 13 | 1.441 |
| Comparative example 2-3 | CC-3 | F3 | 1 | F3 | 123 | -0.41 | 4.22 | 17.93 | 8.4 | 17 | 1.077 |
| Example 2-1 | MC-2 | F3 | 1 | F3 | 123 | -0.41 | 4.02 | 18.57 | 8.6 | 38 | 0.116 |
| Example 2-2 | MC-1 | F3 | 1 | F3 | 123 | -0.41 | 4.06 | 18.17 | 8.6 | 35 | 0.157 |
| Example 2-3 | MC-3 | F3 | 1 | F3 | 123 | -0.41 | 3.96 | 18.43 | 8.7 | 36 | 0.117 |
| Example 2-4 | MC-6 | F3 | 1 | F3 | 123 | -0.41 | 3.94 | 18.42 | 8.8 | 42 | 0.061 |
| Comparative example 2-4 | CC-2 | F4 | 3 | F4 | 129 | -0.25 | 4.01 | 18.51 | 8.9 | 13 | 0.764 |
| Example 2-5 | MC-3 | F4 | 3 | F4 | 129 | -0.25 | 3.86 | 17.94 | 9.0 | 27 | 0.133 |
| Comparative example 2-5 | CC-2 | F2 | 3 | F2 | 124 | -0.29 | 3.90 | 15.71 | 8.0 | 55 | 0.212 |
| Example 2-6 | MC-3 | F2 | 3 | F2 | 124 | -0.29 | 3.79 | 15.68 | 7.9 | 55 | 0.170 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electroluminescent device comprising an anode layer, a cathode layer, a first emission layer (EML), a hole injection layer (HIL) and a first hole transport layer (HTL), wherein
- the hole injection layer comprises a compound of formula (I):
M^{n⊕}(L^{⊝})ₙ(AL)ₘ (I),
wherein
M is a metal ion,
n is an integer selected from 1 to 4, which corresponds to the oxidation number of M;
AL is an ancillary ligand;
m is an integer selected from 0, 1 or 2;
L is a ligand of formula (II):
[A¹-Y¹-X-Y²-A²]^{⊝} (II),
- X is N or C-A³;
- Y¹ and Y² are independently selected from CO or SO₂;
- A¹ and A² are independently selected from substituted or unsubstituted C₁ to C₁₂ alkyl, substituted or unsubstituted C6 to C₁₉ aryl, substituted or unsubstituted C₃ to C₁₂ heteroaryl,
wherein the substituents on A¹ and A² are independently selected from D, C6 aryl, C3 to C₉ heteroaryl, C₁ to C6 alkyl, C₁ to C6 alkoxy, C3 to C6 branched alkyl, C3 to C6 cyclic alkyl, C3 to C6 branched alkoxy, C3 to C₆ cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C6 alkoxy, COR¹, COOR¹, halogen, F or CN;
- A³ is selected from H, D, C₁ to C₄ alkyl, partially or perfluorinated C₁ to C₄ alkyl, CN, F, or A¹ and A³ are bridged to form a cyclic ring;
wherein
at least two of the substituents in L of formula (II) are independently selected from C3 to C₉ heteroaryl, C₁ to C6 alkoxy, C3 to C6 branched alkoxy, C3 to C6 cyclic alkoxy, partially or perfluorinated C₁ to C₁₆ alkyl, partially or perfluorinated C₁ to C₁₆ alkoxy, partially or perdeuterated C₁ to C6 alkoxy, COR¹, COOR¹, halogen, F or CN;
wherein
R¹ is selected from C₆ aryl, C₃ to C₉ heteroaryl, C₁ to C₆ alkyl, C₁ to C₆ alkoxy, C₃ to C6 branched alkyl, C3 to C6 cyclic alkyl, C3 to C6 branched alkoxy, C3 to C6 cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C6 alkoxy;
- the first emission layer comprises a compound of formula (III) and an organic emitter host compound: 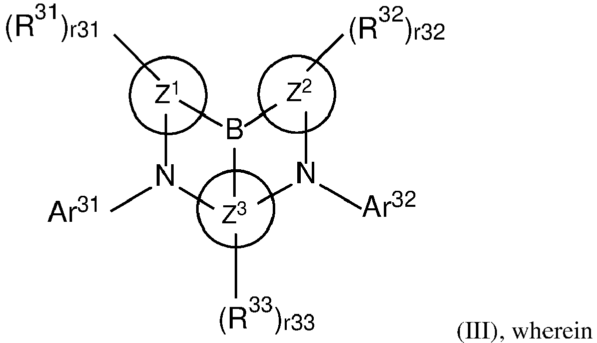
Z¹, Z² and Z³ are the same as or selected different from each other, and are each independently selected from the group comprising a monocyclic to polycyclic aromatic hydrocarbon ring or monocyclic to polycyclic aromatic hetero ring;
Ar³¹ and Ar³² are the same as or selected different from each other, and are each independently and are each independently selected from the group comprising a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
R³¹, R³² and R³³ are the same as or selected different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group
having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
r31, r32 and r33 are each an integer from 0, 1, 2, 3 or 4, and when r31 to r33 are 2 or higher, substituents in the parenthesis are the same as or selected different from each other;
wherein the organic emitter host compound comprises:
- at least one condensed aromatic ring system consisting of at least ≥ 3 to ≤ 5 condensed aromatic rings, and
- at least ≥ 3 to ≤ 7 aromatic rings and/or at least ≥ 3 to ≤ 7 heteroaromatic rings, wherein at least ≥ 2 to ≤ 7 of the aromatic rings and/or at least ≥ 3 to ≤ 7 of the heteroaromatic rings are condensed to form a fused aromatic ring system and/or fused heteroaromatic ring systems, and
wherein the molecular weight Mw of the organic emitter host compound is in the range of ≥ 400 g/mol and ≤ 2000 g/mol;
- the first hole transport layer comprises an organic hole transport compound, wherein the organic hole transport compound comprises:
- at least ≥ 1 to ≤ 3 amine moieties, and
- at least ≥ 8 to ≤ 12 aromatic rings or heteroaromatic rings, and
wherein the molecular weight Mw of the organic hole transport compound is in the range of ≥ 400 g/mol and ≤ 2000 g/mol; wherein
the hole injection layer is arranged between the anode layer and the first hole transport layer; the first emission layer is arranged between the first hole transport layer and the cathode layer; and the first hole transport layer is arranged between the hole injection layer and the first emission layer.

2. The organic electroluminescent device according to claim 1, wherein the following equation is fulfilled:
-0.8 eV ≥ [ HOMO of organic emitter host compound - HOMO of organic hole transport compound ] ≤ 0 eV.

3. The organic electroluminescent device according to any one of claim 1 or 2, wherein the ligand L of formula (II) comprises at least 3 fluorine atoms, more preferred at least 4 fluorine atoms, also preferred at least 6 fluorine atoms and more preferred ≥ 3 to ≤ 60 fluorine atoms.

4. The organic electroluminescent device according to any one of claims 1 to 3, wherein the ligand L of formula (II) is selected from the group of anionic ligands L of formula (IIb), (IIc) or (IId): 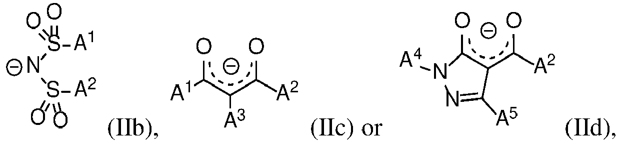 wherein
A¹ and A² are independently selected from substituted or unsubstituted C₁ to C12 alkyl, substituted or unsubstituted C6 to C12 aryl, substituted or unsubstituted C3 to C12 heteroaryl;
wherein the substituents of A¹ and A² are independently selected from D, C6 aryl, C3 to C₉ heteroaryl, C₁ to C6 alkyl, C₁ to C6 alkoxy, C3 to C6 branched alkyl, C3 to C6 cyclic alkyl, C3 to C6 branched alkoxy, C3 to C6 cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C6 alkoxy, COR¹, COOR¹, halogen, F or CN,
wherein R¹ is selected from C₆ aryl, C₃ to C₉ heteroaryl, C₁ to C₆ alkyl, C₁ to C6 alkoxy, C3 to C6 branched alkyl, C3 to C6 cyclic alkyl, C3 to C6 branched alkoxy, C3 to C6 cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C6 alkoxy;
A³ is selected from H, D, CN, C₁ to C₄ alkyl, partially or perfluorinated C₁ to C₄ alkyl, F, or A¹ and A³ are bridged to form a cyclic ring, whereby preferably A³ is selected as to form a cyclic structure with either A¹ or A², whereby 5- or 6- membered aliphatic or aromatic rings are preferred and whereby the ring may comprise one or more heteroatoms, preferably selected from N, O and S;
A⁴ is selected from substituted or unsubstituted C₁ to C12 alkyl, substituted or unsubstituted C6 to C₁₉ aryl, substituted or unsubstituted C2 to C₂₀ heteroaryl, or substituted or unsubstituted 6-membered heteroaryl;
A⁵ is selected from C₁ to C6 alkyl, substituted or unsubstituted C6 to C12 aryl, substituted or unsubstituted C₃ to C₉ heteroaryl or CN, preferably CH₃ or CN,
wherein
the substituents on A⁴ and A⁵ are independently selected from D, CN, C₁ to C4 alkyl, partially or perfluorinated C₁ to C4 alkyl, halogen or F;
wherein
at least two of the substituents in L are independently selected from C3 to C9 heteroaryl, C₁ to C6 alkoxy, C3 to C6 branched alkoxy, C3 to C6 cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN;
wherein R¹ is selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

5. The organic electroluminescent device according to any one of claims 1 to 4, wherein the ligand L of formula (IIb), (IIc) or (IId) are selected from G1 to G113:

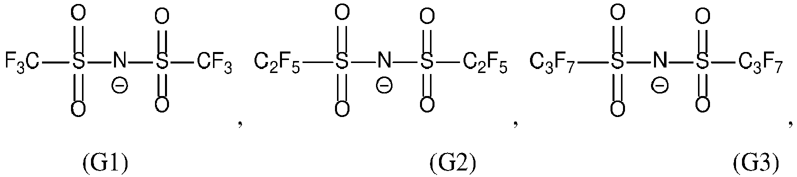

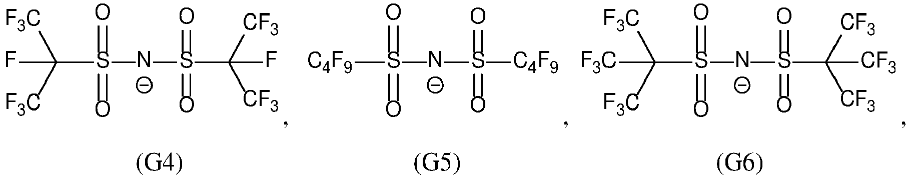

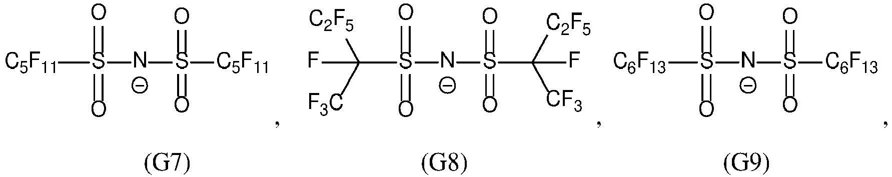

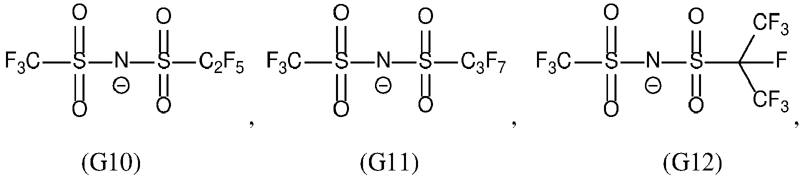

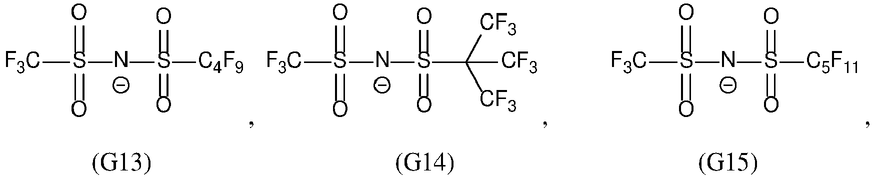

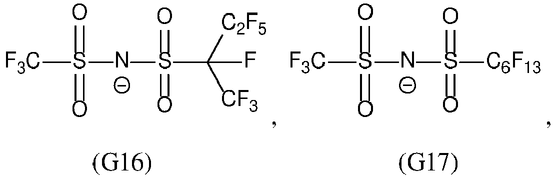

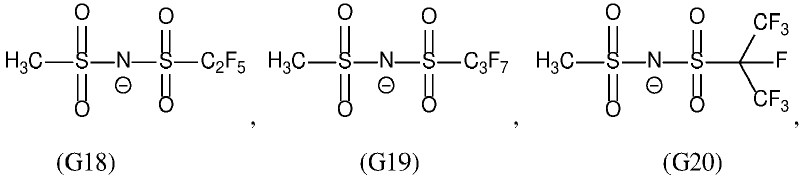

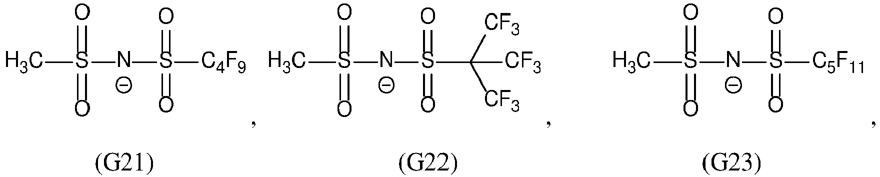

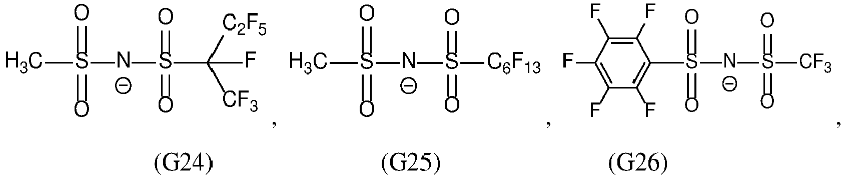

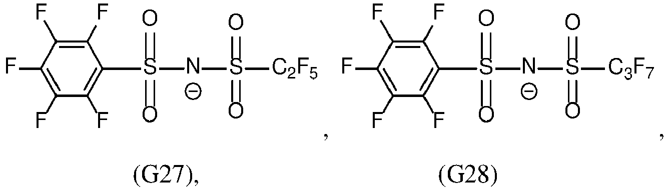

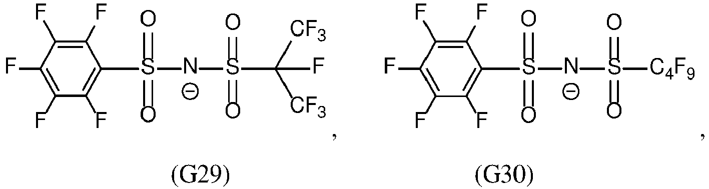

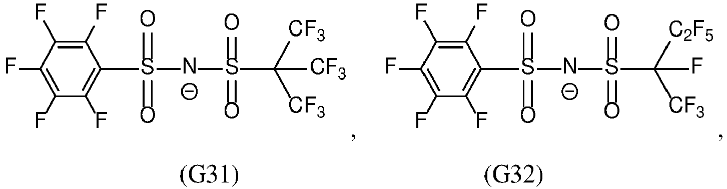

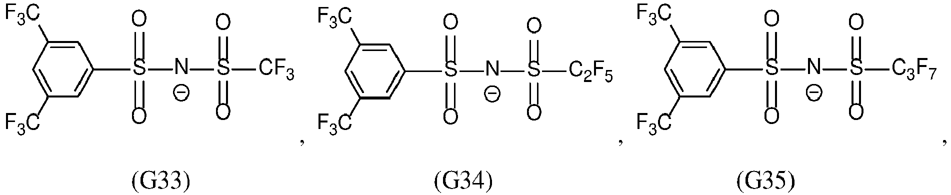

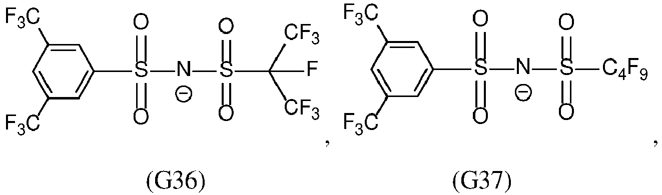

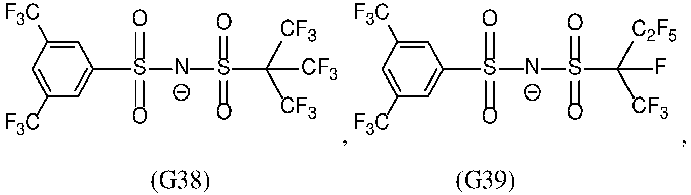

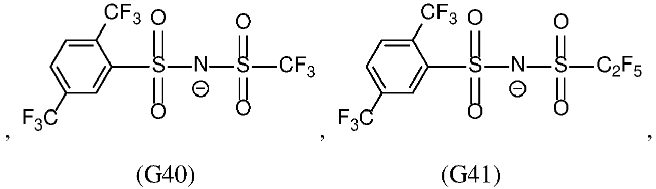

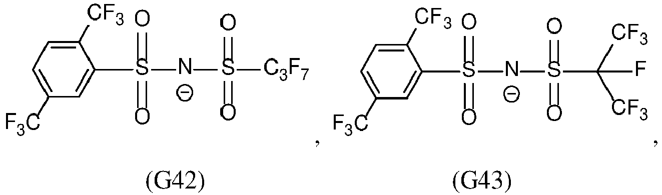

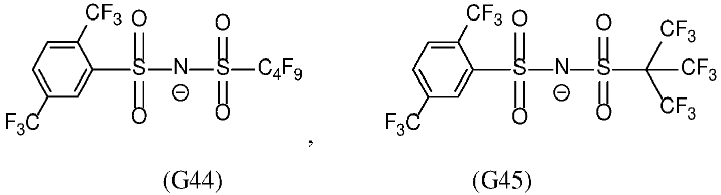

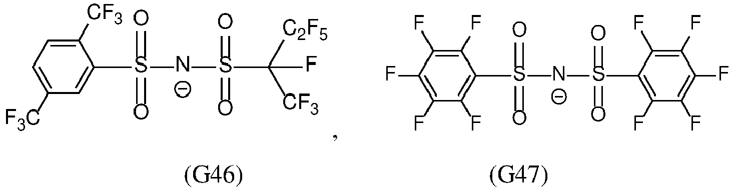

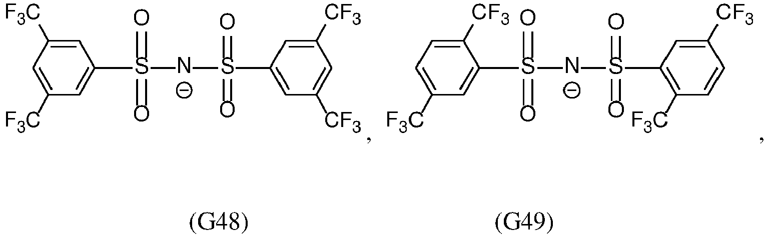

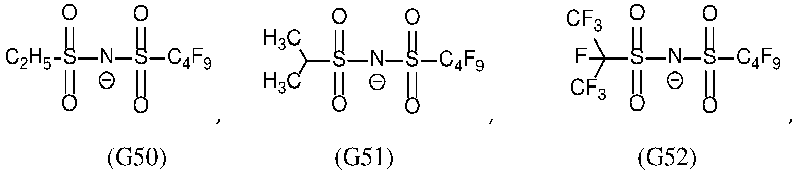

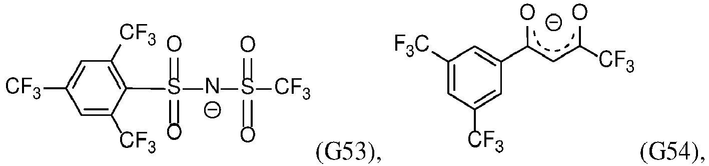

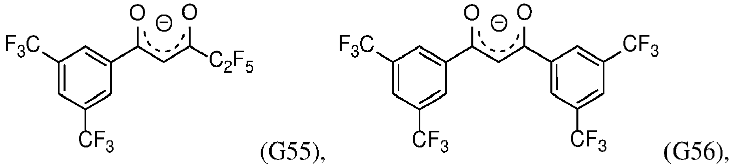

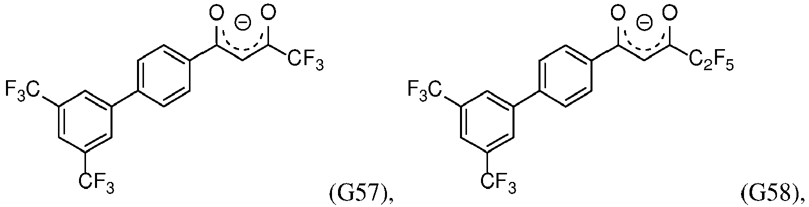

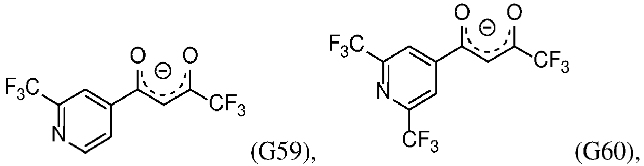

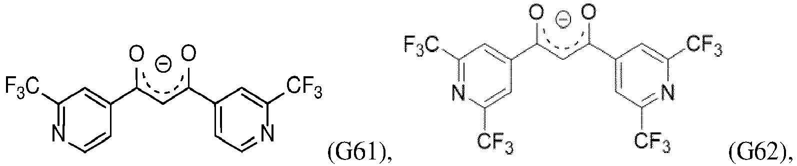

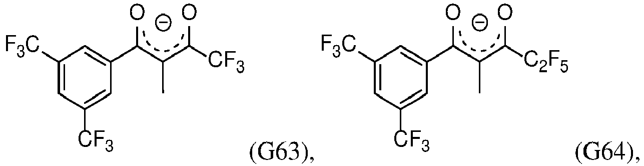

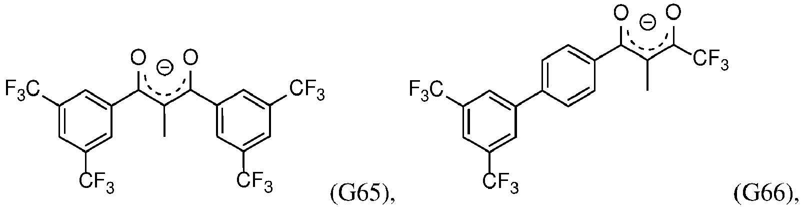

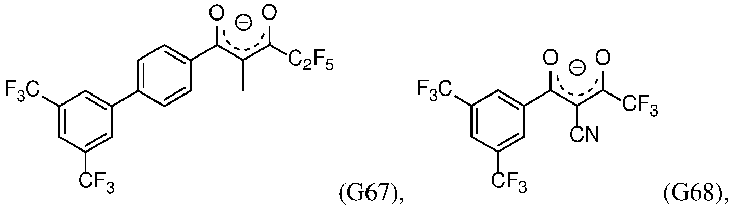

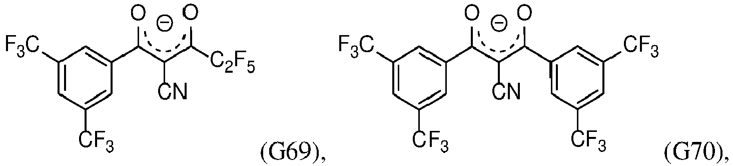

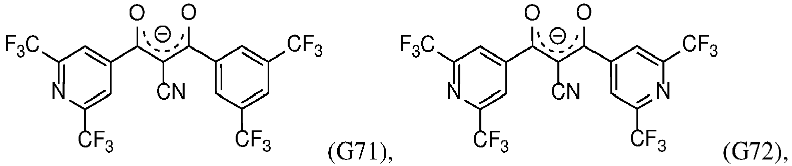

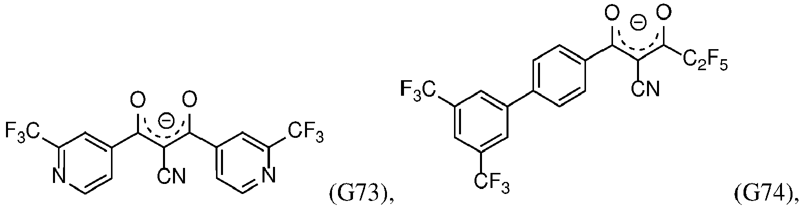

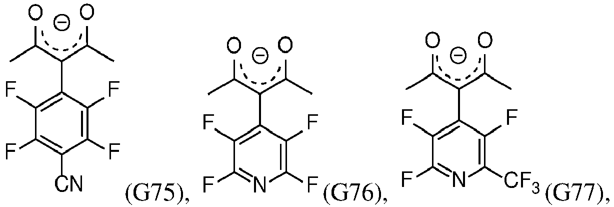

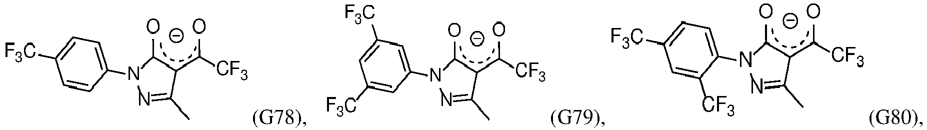

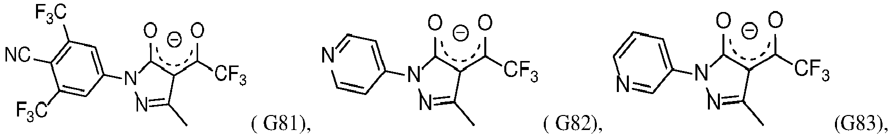

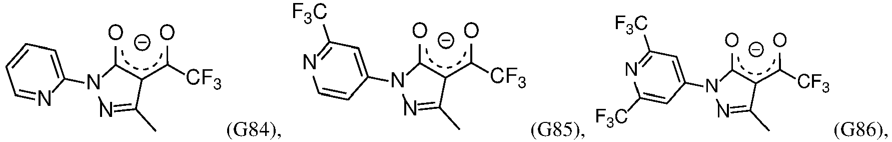

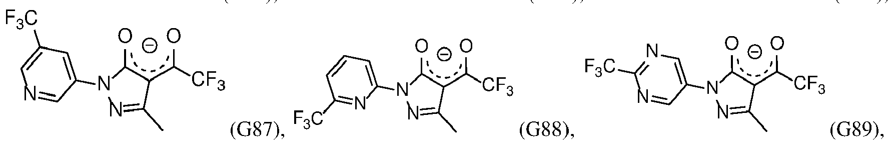

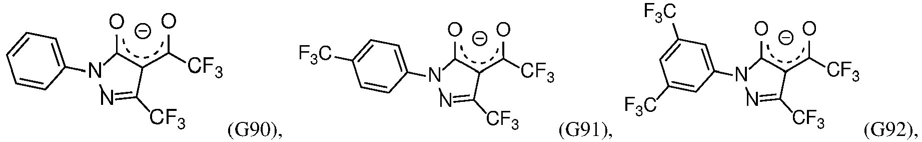

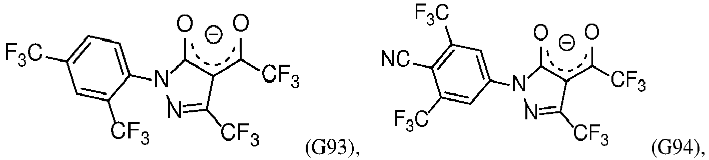

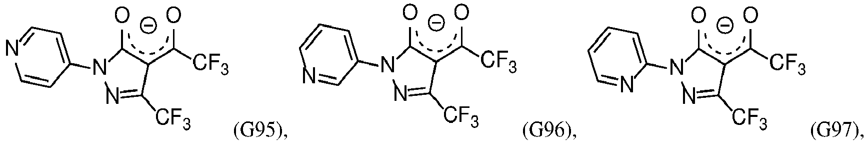

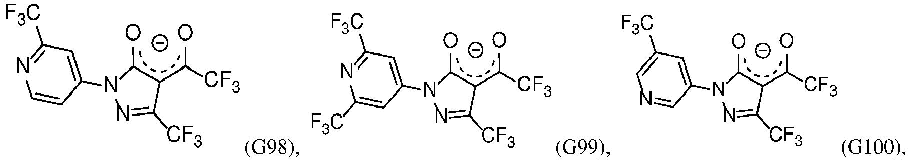

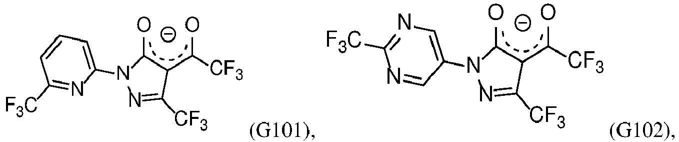

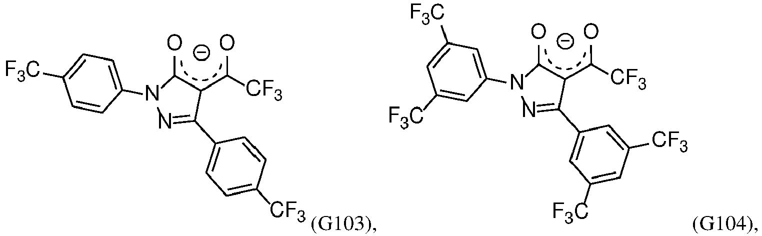

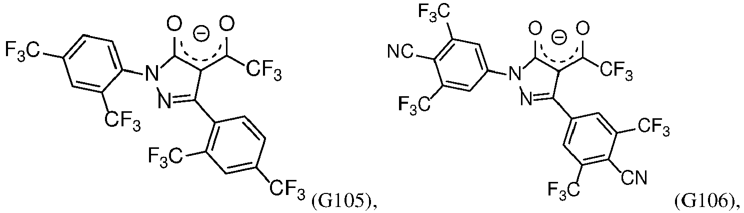

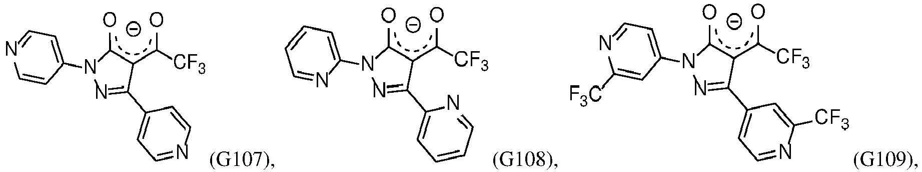

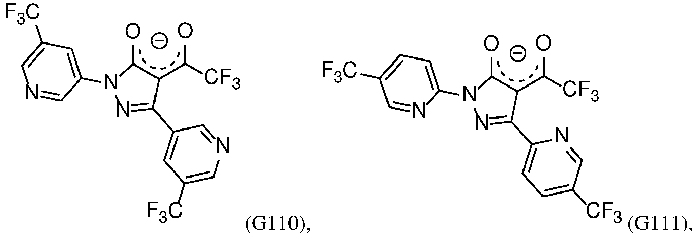

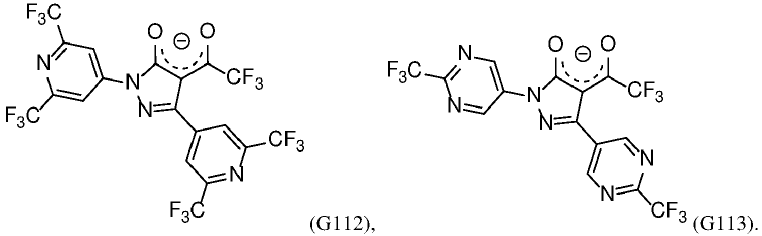

6. The organic electroluminescent device according to any one of claims 1 to 5, wherein the compound of formula (I) is selected from:
Li TFSI, K TFSI, Cs TFSI, Ag TFSI, Mg(TFSI)₂, Mn(TFSI)₂, Sc(TFSI)₃, Na[N(SO₂C₄F₉)₂], K[N(SO₂C₄F₉)₂], Mg[N(SO₂ⁱC₃F₇)₂]₂, Zn[N(SO₂ⁱC₃F₇)₂]₂, Ag[N(SO₂ⁱC₃F₇)₂], Ag[N(SO₂C₃F₇)₂], Ag[N(SO₂C₄F₉)₂], Ag[N(SO₂CF₃)(SO₂C₄F₉)], Cs[N(SO₂C₄F₉)₂], Mg[N(SO₂C₄F₉)₂]₂, Ca[N(SO₂C₄F₉)₂]₂, Ag[N(SO₂C₄F₉)₂], Cu[N(SO₂ⁱC₃F₇)₂]₂, Cu[N(SO₂C₃F₇)₂]₂, Cu[N(SO₂CF₃) (SO₂C₄F₉)]₂, Cu [N(SO₂C₂H₅) (SO₂C₄F₉)]₂, Cu [N(SO₂ ⁱC₃H₇) (SO₂C₄F₉)]₂, Cu [N(SO₂ ⁱC₃F₇) (SO₂C₄F₉)]₂, Cu[N(SO₂CH₃) (SO₂C₄F₉)]₂, Mg[N(SO₂CF₃) (SO₂C₄F₉)]₂, Mn[N(SO₂CF₃) (SO₂C₄F₉)]₂, Ag[N(SO₂CH₃) (SO₂C₄F₉)], 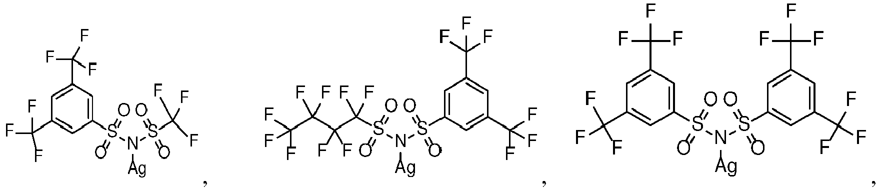 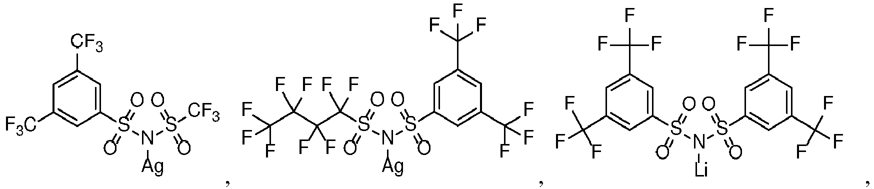 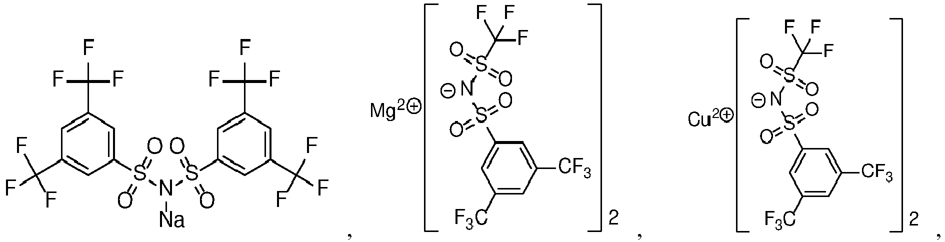 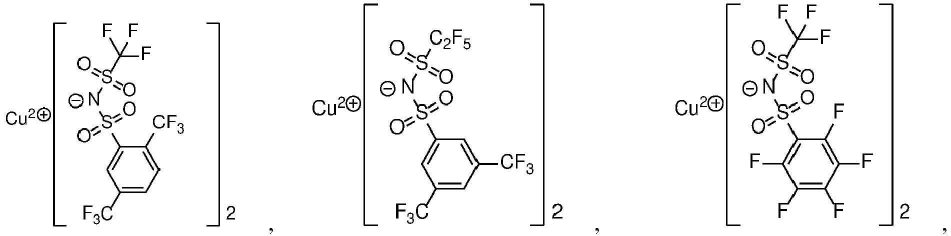 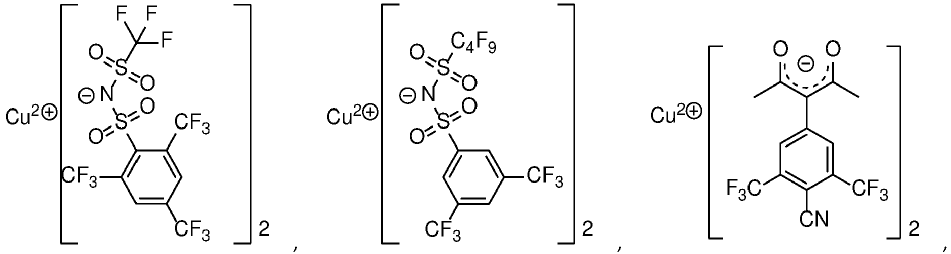 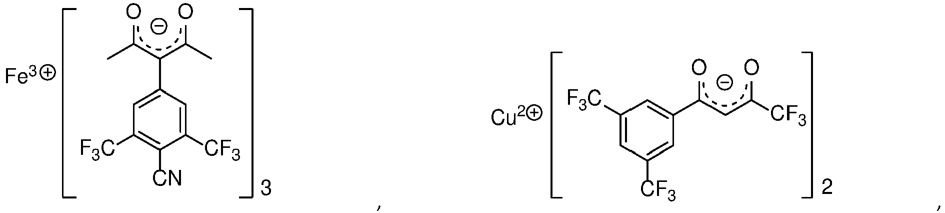 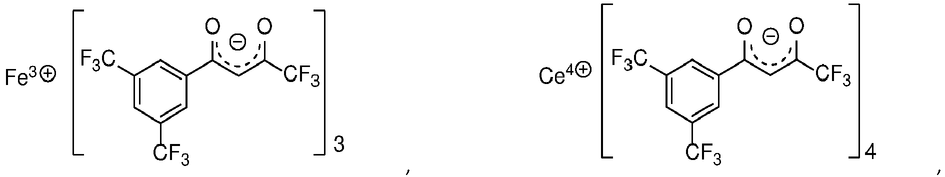 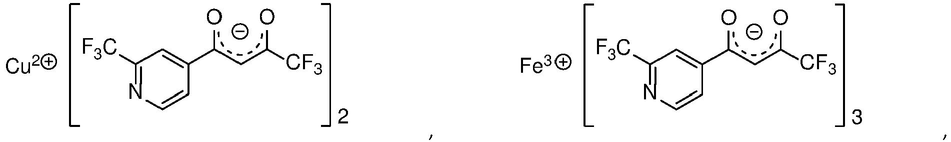 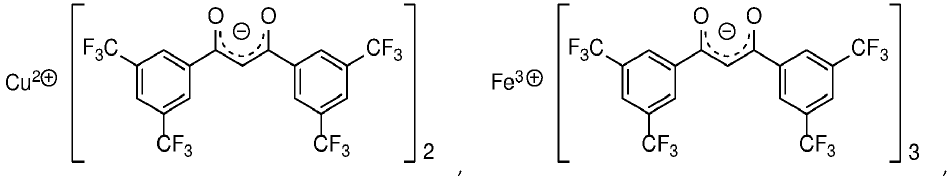 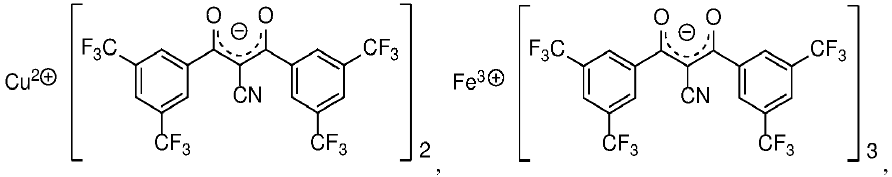 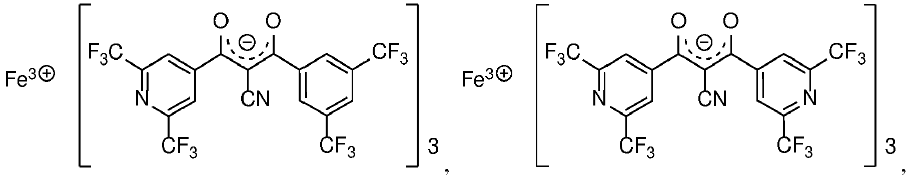 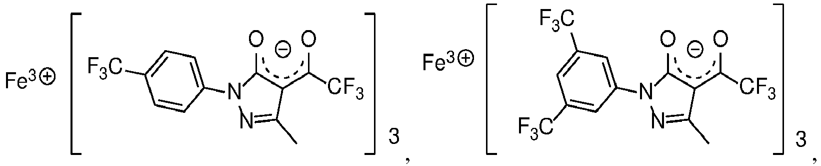 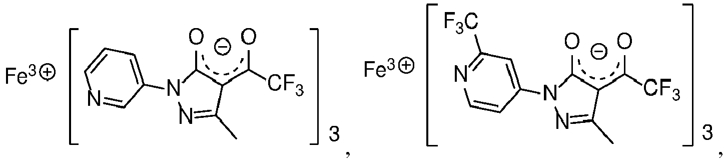 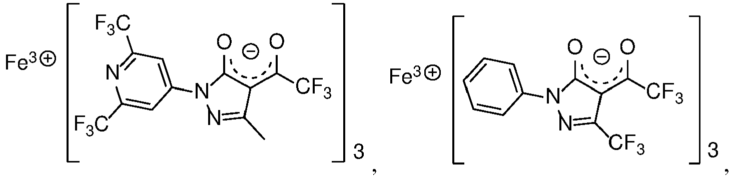 wherein "i" denotes "iso".

7. The organic electroluminescent device according to any one of claims 1 to 6, wherein the organic hole transport compound is selected from a compound of formula (IVa) or of formula (IVb): 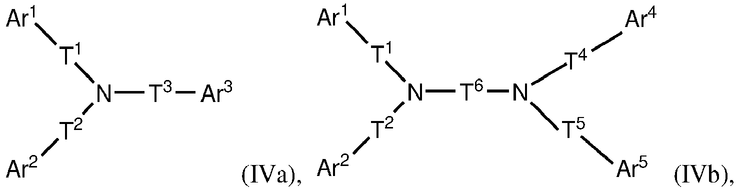 wherein:
T¹ to T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹ to Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar¹ to Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

8. The organic electroluminescent device according to any one of claims 1 to 7, wherein the organic hole transport compound of formula (IV) is selected from a compound from F1 to F20:

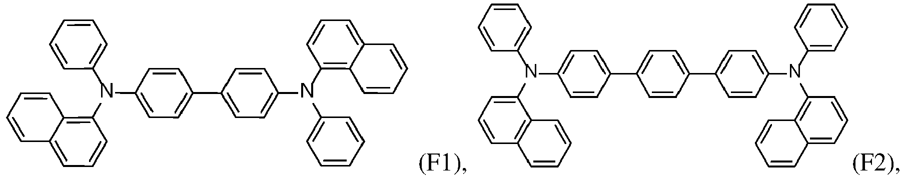

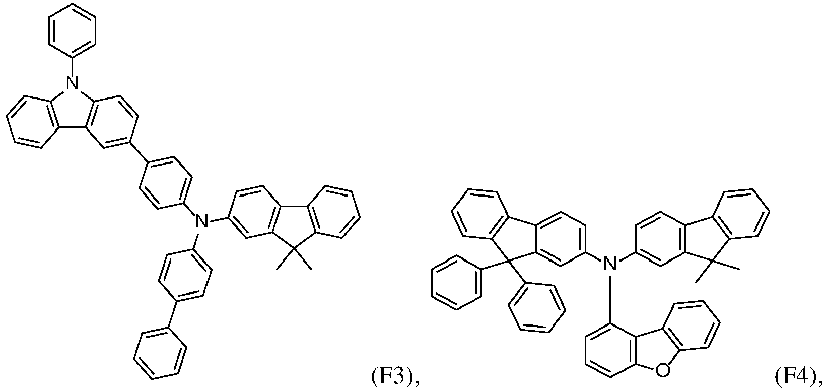

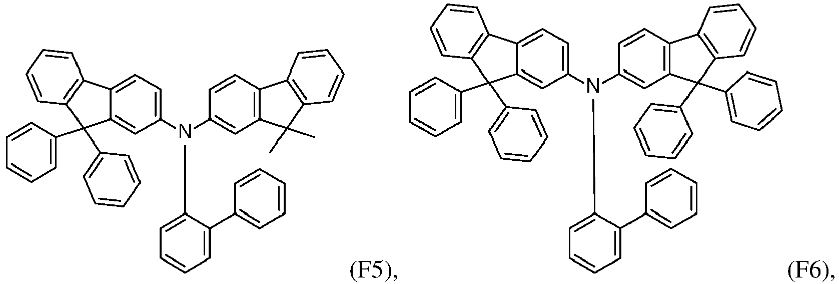

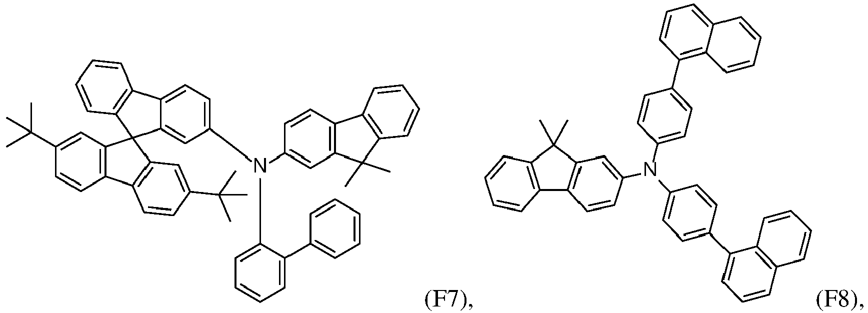

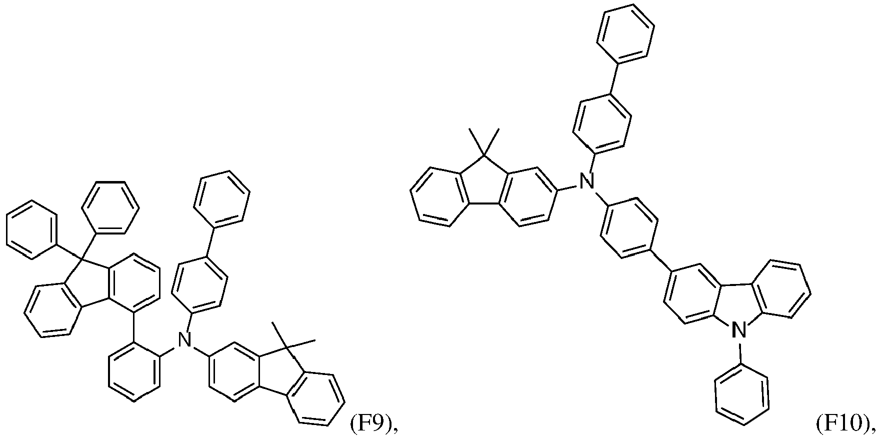

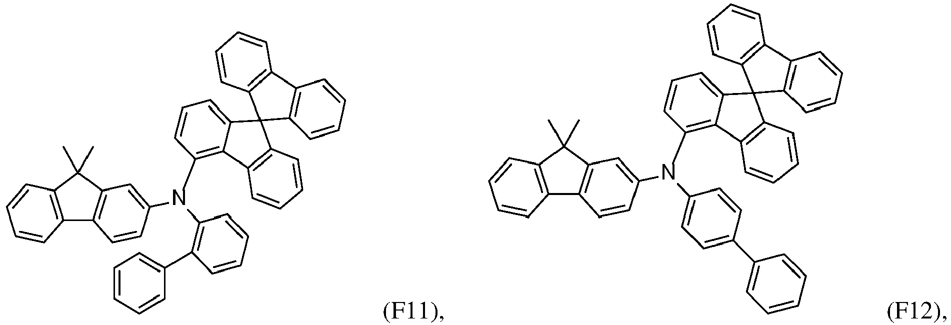

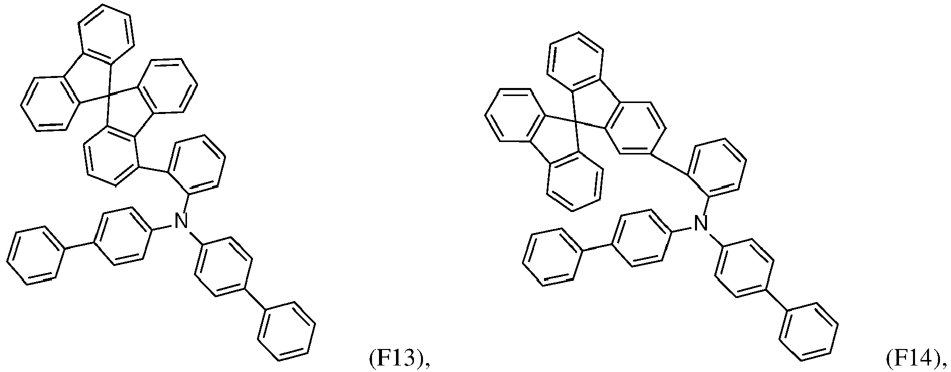

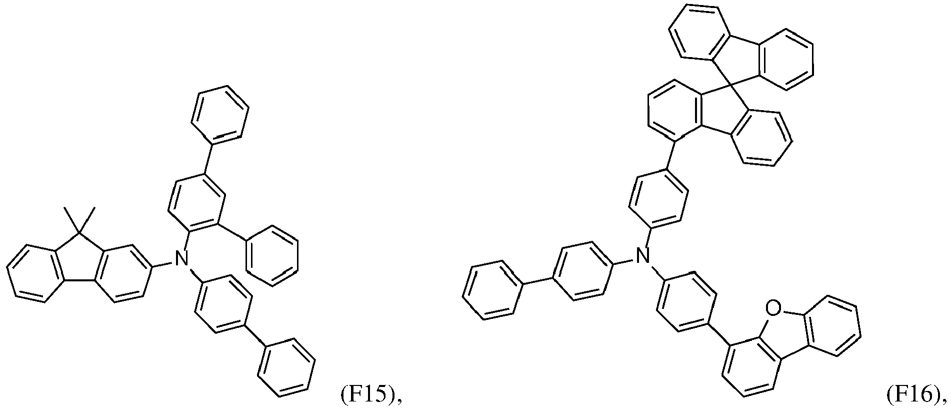

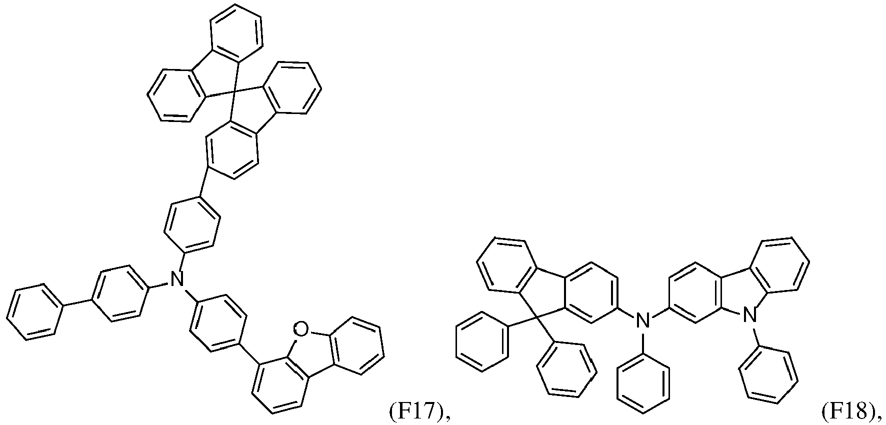

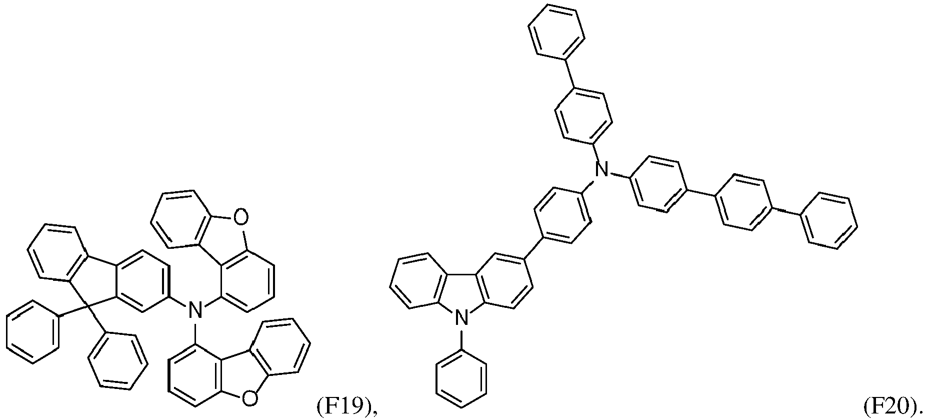

9. The organic electroluminescent device according to any one of claims 1 to 8, wherein the compound of formula (III) is selected from the group of BD1 to BD9:

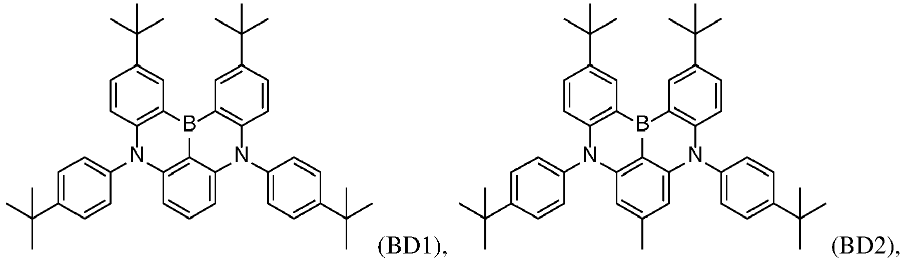

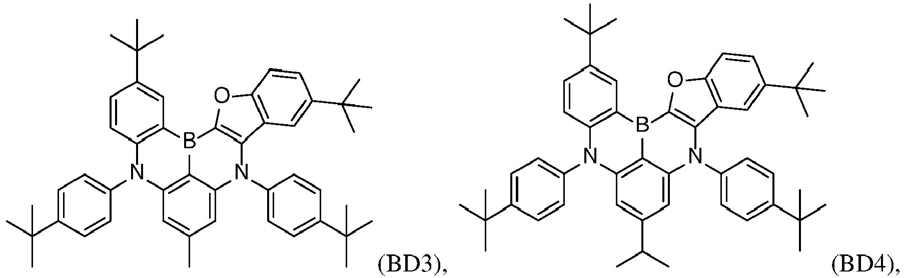

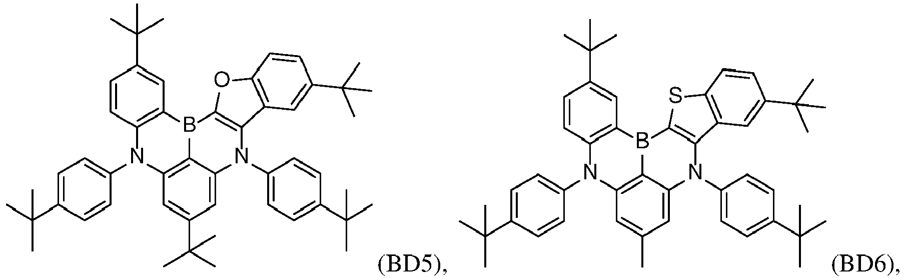

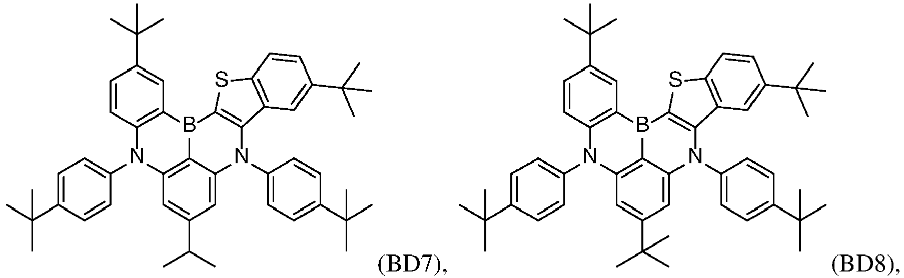

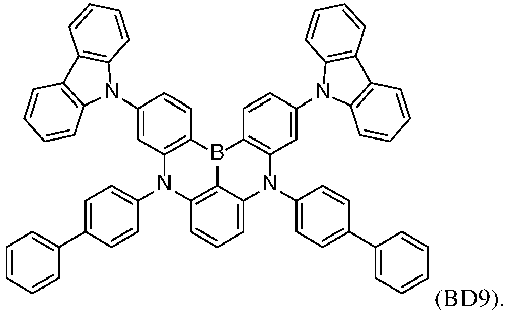

10. The organic electroluminescent device according to any one of claims 1 to 9, wherein the organic emitter host compound is selected from a compound of formula (V): 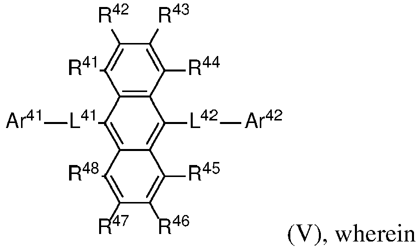
Ar⁴¹ and Ar⁴² are independently selected from substituted or unsubstituted C₆ to C₂₄ aryl, substituted or unsubstituted C₃ to C₂₄ heteroaryl;
L⁴¹ and L⁴² are independently selected from a direct bond or substituted or unsubstituted C₆ to C₂₄ arylene, substituted or unsubstituted C₃ to C₂₄ heteroarylene;
R⁴¹ to R⁴⁸ are independently selected from H, D, substituted or unsubstituted C₁ to C₁₂ alkyl, substituted or unsubstituted C₆ to C₁₉ aryl, substituted or unsubstituted C₃ to C₁₂ heteroaryl;
wherein
the substituents on Ar⁴¹, Ar⁴², L⁴¹, L⁴², R⁴¹ to R⁴⁸ are independently selected from D, C₆ to C₁₀ aryl, C₃ to C₉ heteroaryl, C₁ to C₆ alkyl, C₁ to C₆ alkoxy, C₃ to C₆ branched alkyl, C₃ to C6 cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C6 alkyl, partially or perdeuterated C₁ to C₆ alkoxy, halogen, F or CN.

11. The organic electroluminescent device according to any of claims 1 to 10, wherein the organic emitter host compound of formula (V) is selected from a compound of BH1 to BH13:

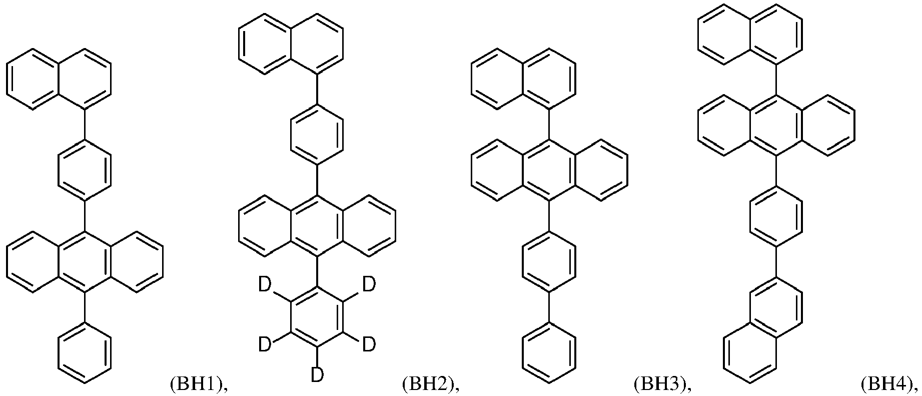

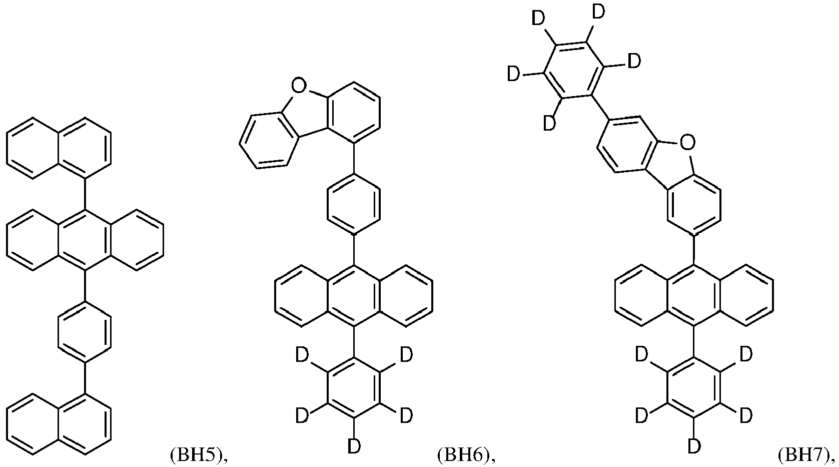

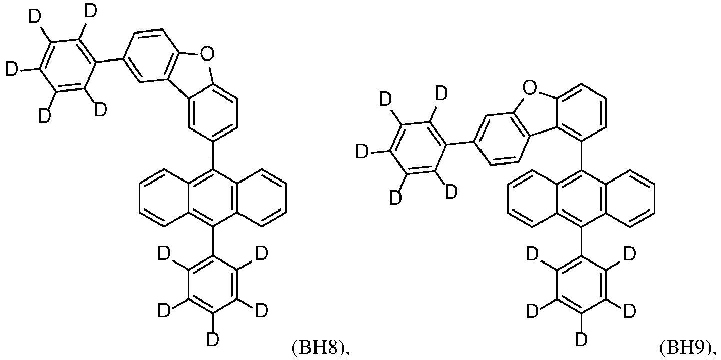

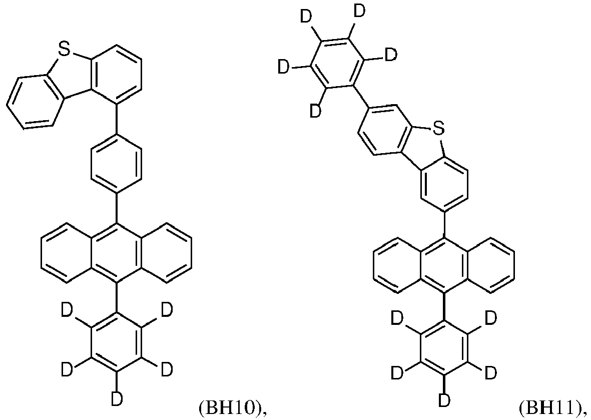

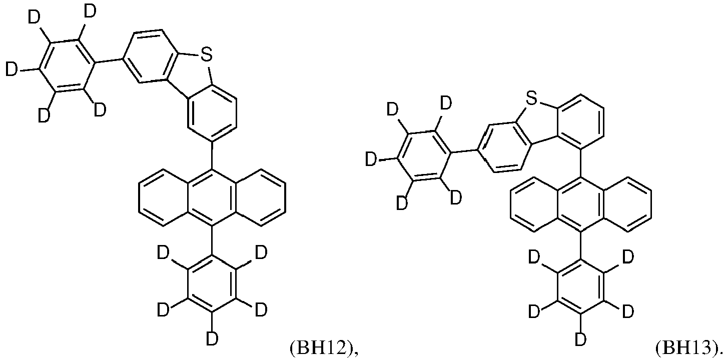

12. The organic electroluminescent device according to any of the claims 1 to 11, wherein light is emitted through the cathode layer.

13. An electronic device comprising the organic electroluminescent device according to any one of claims 1 to 12.

14. A display device comprising an organic electroluminescent device according to any of the claims 1 to 13.
